(19) Europäisches Patentamt / European Patent Office / Office européen des brevets

(11) **EP 2 936 577 B1**

(12) **EUROPÄISCHE PATENTSCHRIFT**

(45) Veröffentlichungstag und Bekanntmachung des Hinweises auf die Patenterteilung:
**28.12.2016 Patentblatt 2016/52**

(21) Anmeldenummer: **13798937.2**

(22) Anmeldetag: **27.11.2013**

(51) Int Cl.:
***H01L 51/54*** *(2006.01)* ***C09K 11/02*** *(2006.01)*

(86) Internationale Anmeldenummer:
**PCT/EP2013/003584**

(87) Internationale Veröffentlichungsnummer:
**WO 2014/094964 (26.06.2014 Gazette 2014/26)**

(54) **ORGANISCHE ELEKTROLUMINESZENZVORRICHTUNG**

ORGANIC ELECTROLUMINESCENT DEVICE

DISPOSITIF ORGANIC ELECTROLUMINESCENT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.12.2012 EP 12008419**

(43) Veröffentlichungstag der Anmeldung:
**28.10.2015 Patentblatt 2015/44**

(73) Patentinhaber: **Merck Patent GmbH**
**64293 Darmstadt (DE)**

(72) Erfinder:
- **PARHAM, Amir, Hossain**
  **60486 Frankfurt am Main (DE)**
- **PFLUMM, Christof**
  **64291 Darmstadt (DE)**
- **JATSCH, Anja**
  **DE/60489 Frankfurt am Main (DE)**
- **EBERLE, Thomas**
  **76829 Landau (DE)**
- **STOESSEL, Philipp**
  **60487 Frankfurt am Main (DE)**
- **KROEBER, Jonas, Valentin**
  **60311 Frankfurt am Main (DE)**
- **KAISER, Joachim**
  **64289 Darmstadt (DE)**

(56) Entgegenhaltungen:
**WO-A1-2011/116865 WO-A1-2011/137951**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 936 577 B1

**Beschreibung**

Die vorliegende Erfindung betrifft organische Elektrolumineszenzvorrichtungen, welche Mischungen aus mindestens zwei elektronenleitenden Materialien, insbesondere als Matrix für phosphoreszierende Emitter, enthalten.

Der Aufbau organischer Elektrolumineszenzvorrichtungen (OLEDs), in denen organische Halbleiter als funktionelle Materialien eingesetzt werden, ist beispielsweise in US 4539507, US 5151629, EP 0676461 und WO 98/27136 beschrieben. Als emittierende Materialien werden hierbei zunehmend metallorganische Komplexe eingesetzt, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen als Phosphoreszenzemitter eine bis zu vierfache Energie- und Leistungseffizienz möglich. Generell gibt es bei OLEDs, insbesondere auch bei OLEDs, die Triplettemission (Phosphoreszenz) zeigen, jedoch immer noch Verbesserungsbedarf, beispielsweise im Hinblick auf Effizienz, Betriebsspannung und Lebensdauer. Dies gilt insbesondere für OLEDs, welche im kürzerwelligen Bereich, beispielsweise grün, emittieren.

Die Eigenschaften von phosphoreszierenden OLEDs werden nicht nur von den eingesetzten Triplettemittern bestimmt. Hier sind auch die anderen verwendeten Materialien, insbesondere auch die Matrixmaterialien von besonderer Bedeutung. Verbesserungen dieser Materialien können somit auch zu deutlichen Verbesserungen der OLED-Eigenschaften führen.

Gemäß dem Stand der Technik werden nicht nur Einzelmaterialien, sondern auch Mischungen aus zwei oder mehr Materialien als Matrix für phosphoreszierende Emitter verwendet. Dabei enthalten die Mischungen in der Regel entweder ein lochtransportierendes und ein elektronentransportierendes Matrixmaterial, wie zum Beispiel in WO 2002/047457 beschrieben, oder sie enthalten ein ladungstransportierendes Matrix-material und ein weiteres Matrixmaterial, welches durch eine große Bandlücke nicht oder nicht in wesentlichem Umfang am Ladungstransport teilnimmt, wie zum Beispiel in WO 2010/108579 beschrieben.

Neben weiteren Materialklassen, die als Matrixmaterialien für phosphoreszierende Emitter eingesetzt werden können, sind auch Lactame als Matrixmaterialien bekannt, zum Beispiel gemäß WO 2011/116865 oder WO 2011/137951.

Jedoch sind auch mit den oben genannten Materialien und Deviceaufbauten noch Verbesserungen wünschenswert, inbesondere in Bezug auf die Lebensdauer und die Betriebsspannung.

Aufgabe der vorliegenden Erfindung ist somit die Bereitstellung von organischen Elektrolumineszenzvorrichtungen, die eine verbesserte Lebensdauer und/oder eine verbesserte Betriebsspannung aufweisen.

Überraschend wurde gefunden, dass organische Elektrolumineszenzvorrichtungen, die in einer Schicht eine Mischung aus einem bestimmten Lactamderivat und einem weiteren elektronentransportierenden Material enthalten, insbesondere als Matrixmaterialien für den phosphoreszierende Emitter, diese Aufgabe lösen und zu deutlichen Verbesserungen der organischen Elektrolumineszenzvorrichtung führen, insbesondere hinsichtlich der Lebensdauer und der Betriebsspannung. Dies gilt insbesondere für grün bis rot phosphoreszierende Elektrolumineszenzvorrichtungen. Derartige organische Elektrolumineszenzvorrichtungen sind daher der Gegenstand der vorliegenden Erfindung.

Gegenstand der vorliegenden Erfindung ist eine organische Elektrolumineszenzvorrichtung, enthaltend Kathode, Anode und mindestens eine Schicht, die die folgenden Verbindungen enthält:

(A) mindestens eine elektronentransportierende Verbindung, die ein LUMO $\leq$ -2.4 eV aufweist; und

(B) mindestens eine Verbindung gemäß der folgenden Formel (1) oder (1a),

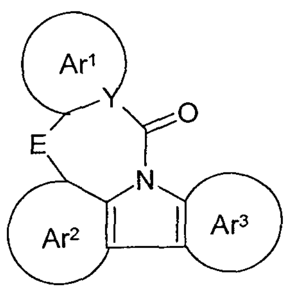

Formel (1)

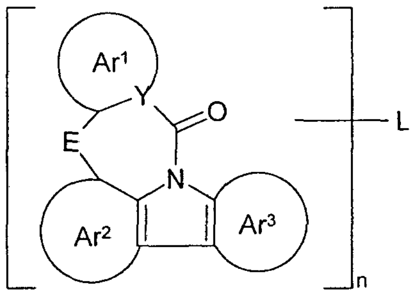

Formel (1a)

wobei für die verwendeten Symbole und Indizes gilt:

E ist eine Einfachbindung oder $NAr^4$;

Y ist C, wenn $Ar^1$ eine 6-Ring-Aryl- oder 6-Ring-Heteroarylgruppe darstellt, bzw. ist C oder N, wenn $Ar^1$

eine 5-Ring-Heteroarylgruppe darstellt;

$Ar^1$ ist zusammen mit der Gruppe Y und dem explizit dargestellten Kohlenstoffatom ein aromatisches oder heteroaromatisches Ring-system mit 5 bis 30 aromatischen Ringatomen, welches durch einen oder mehrere Reste R substituiert sein kann;

$Ar^2$, $Ar^3$ ist gleich oder verschieden bei jedem Auftreten zusammen mit den explizit dargestellten Kohlenstoffatomen ein aromatisches oder heteroaromatisches Ringsystem mit 5 bis 30 aromatischen Ring-atomen, welches durch einen oder mehrere Reste R substituiert sein kann;

$Ar^4$ ist ein aromatisches oder heteroaromatisches Ringsystem mit 5 bis 30 aromatischen Ringatomen, welches durch einen oder mehrere Reste R substituiert sein kann; dabei kann $Ar^4$ auch mit $Ar^2$ oder $Ar^1$ durch eine Einfachbindung verknüpft sein;

L ist für n = 2 eine Einfachbindung oder eine bivalente Gruppe, bzw. für n = 3 eine trivalente Gruppe bzw. für n = 4 eine tetravalente Gruppe, welche jeweils an eine beliebige Position an $Ar^1$, $Ar^2$, $Ar^3$ oder $Ar^4$ gebunden ist;

R ist bei jedem Auftreten gleich oder verschieden ausgewählt aus der Gruppe bestehend aus H, D, F, Cl, Br, I, CN, $NO_2$, $N(Ar^5)_2$, $N(R^1)_2$, $C(=O)Ar^5$, $C(=O)R^1$, $P(=O)(Ar^5)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^1$ substituiert sein kann, wobei eine oder mehrere nicht-benachbarte $CH_2$-Gruppen durch $R^1C=CR^1$, C=C, $Si(R^1)_2$, $Ge(R^1)_2$, $Sn(R^1)_2$, C=O, C=S, C=Se, $C=NR^1$, $P(=O)(R^1)$, SO, $SO_2$, $NR^1$, O, S oder $CONR^1$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 80, bevorzugt 5 bis 60, aromatischen Ringatomen, das jeweils mit einem oder mehreren Resten $R^1$ substituiert sein kann, einer Aryloxy- oder Heteroaryloxygruppe mit 5 bis 60 aromatischen Ringatomen, die mit einem oder mehreren Resten $R^1$ substituiert sein kann, oder einer Kombination dieser Systeme, wobei optional zwei oder mehr benachbarte Substituenten R ein monocyclisches oder polycyclisches, aliphatisches, aromatisches oder heteroaromatisches Ringsystem bilden können, das mit einem oder mehreren Resten $R^1$ substituiert sein kann;

$R^1$ ist bei jedem Auftreten gleich oder verschieden ausgewählt aus der Gruppe bestehend aus H, D, F, Cl, Br, I, CN, $NO_2$, $N(Ar^5)_2$, $N(R^2)_2$, $C(=O)Ar^5$, $C(=O)R^2$, $P(=O)(Ar^5)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^2$ substituiert sein kann, wobei eine oder mehrere nicht-benachbarte $CH_2$-Gruppen durch $R^2C=CR^2$, C=C, $Si(R^2)_2$, $Ge(R^2)_2$, $Sn(R^2)_2$, C=O, C=S, C=Se, $C=NR^2$, $P(=O)(R^2)$, SO, $SO_2$, $NR^2$, O, S oder $CONR^2$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 60 aromatischen Ringatomen, das jeweils mit einem oder mehreren Resten $R^2$ substituiert sein kann, einer Aryloxy- oder Heteroaryloxygruppe mit 5 bis 60 aromatischen Ringatomen, die mit einem oder mehreren Resten $R^2$ substituiert sein kann, oder einer Kombination dieser Systeme, wobei optional zwei oder mehr benachbarte Substituenten R ein monocyclisches oder polycyclisches, aliphatisches, aromatisches oder heteroaromatisches Ringsystem bilden können, das mit einem oder mehreren Resten $R^2$ substituiert sein kann;

$Ar^5$ ist bei jedem Auftreten gleich oder verschieden ein aromatisches oder heteroaromatisches Ringsystem mit 5-30 aromatischen Ringatomen, das mit einem oder mehreren nicht-aromatischen Resten $R^2$ substituiert sein kann; dabei können zwei Reste $Ar^5$, welche an dasselbe N-Atom oder P-Atom binden, auch durch eine Einfachbindung oder eine Brücke, ausgewählt aus $N(R^2)$, $C(R^2)_2$ oder O, miteinander verbrückt sein;

$R^2$ ist ausgewählt aus der Gruppe bestehend aus H, D, F, CN, einem aliphatischem Kohlenwasserstoffrest mit 1 bis 20 C-Atomen, einem aromatischem oder heteroaromatischem Ringsystem mit 5 bis 30 aromatischen Ringatomen, in dem ein oder mehrere H-Atome durch D, F, Cl, Br, I oder CN ersetzt sein können, wobei zwei oder mehr benachbarte Substituenten $R^2$ miteinander ein mono- oder polycyclisches, aliphatisches, aromatisches oder heteroaromatisches Ringsystem bilden können;

n ist 2, 3 oder 4.

Dabei bedeutet 6-Ring-Aryl- bzw. 6-Ring-Heteroarylgruppe bzw. 5-Ring-Heteroarylgruppe in der Definition von Y, dass der Ring, der das explizit dargestellte Kohlenstoffatom und die Gruppe Y enthält, ein solcher Ring ist. An diesen Ring können noch weitere aromatische bzw. heteroaromatische Gruppen ankondensiert sein.

Eine Arylgruppe im Sinne dieser Erfindung enthält 6 bis 60 C-Atome; eine Heteroarylgruppe im Sinne dieser Erfindung enthält 2 bis 60 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte (anellierte) Aryl- oder Heteroarylgruppe, beispielsweise Naphthalin, Anthracen, Phenanthren, Chinolin, Isochinolin, etc., verstanden. Miteinander durch Einfachbindung verknüpfte Aromaten, wie zum Beispiel Biphenyl, werden dagegen nicht als Aryl- oder Heteroarylgruppe, sondern als aromatisches Ringsystem bezeichnet.

Ein aromatisches Ringsystem im Sinne dieser Erfindung enthält 6 bis 80 C-Atome im Ringsystem. Ein heteroaromatisches Ringsystem im Sinne dieser Erfindung enthält 2 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit, wie z. B. ein C-, N- oder O-Atom, verbunden sein können. So sollen beispielsweise auch Systeme wie Fluoren, 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine kurze Alkylgruppe verbunden sind.

Im Rahmen der vorliegenden Erfindung werden unter einem aliphatischen Kohlenwasserstoffrest bzw. einer Alkylgruppe bzw. einer Alkenyl- oder Alkinylgruppe, die 1 bis 40 C-Atome enthalten kann, und in der auch einzelne H-Atome oder $CH_2$-Gruppen durch die oben genannten Gruppen substituiert sein können, bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, neo-Pentyl, Cyclopentyl, n-Hexyl, neo-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl, Heptinyl oder Octinyl verstanden. Unter einer Alkoxygruppe mit 1 bis 40 C-Atomen werden bevorzugt Methoxy, Trifluormethoxy, Ethoxy, n-Propoxy, i-Propoxy, n-Butoxy, i-Butoxy, s-Butoxy, t-Butoxy, n-Pentoxy, s-Pentoxy, 2-Methylbutoxy, n-Hexoxy, Cyclohexyloxy, n-Heptoxy, Cycloheptyloxy, n-Octyloxy, Cyclooctyloxy, 2-Ethylhexyloxy, Pentafluorethoxy und 2,2,2-Trifluorethoxy verstanden. Unter einer Thioalkylgruppe mit 1 bis 40 C-Atomen werden insbesondere Methylthio, Ethylthio, n-Propylthio, i-Propylthio, n-Butylthio, i-Butylthio, s-Butylthio, t-Butylthio, n-Pentylthio, s-Pentylthio, n-Hexylthio, Cyclohexylthio, n-Heptylthio, Cycloheptylthio, n-Octylthio, Cyclooctylthio, 2-Ethylhexylthio, Trifluormethylthio, Pentafluorethylthio, 2,2,2-Trifluorethylthio, Ethenylthio, Propenylthio, Butenylthio, Pentenylthio, Cyclopentenylthio, Hexenylthio, Cyclohexenylthio, Heptenyfthio, Cycloheptenylthio, Octenylthio, Cyclooctenylthio, Ethinylthio, Propinylthio, Butinylthio, Pentinylthio, Hexinylthio, Heptinylthio oder Octinylthio verstanden. Allgemein können Alkyl-, Alkoxy- oder Thioalkylgruppen gemäß der vorliegenden Erfindung geradkettig, verzweigt oder cyclisch sein, wobei eine oder mehrere nicht-benachbarte $CH_2$-Gruppen durch die oben genannten Gruppen ersetzt sein können; weiterhin können auch ein oder mehrere H-Atome durch D, F, Cl, Br, I, CN oder $NO_2$, bevorzugt F, Cl oder CN, weiter bevorzugt F oder CN, besonders bevorzugt CN ersetzt sein.

Unter einem aromatischen oder heteroaromatischen Ringsystem mit 5 - 30 bzw. 5 - 60 aromatischen Ringatomen, welches noch jeweils mit den oben genannten Resten R, $R^1$ oder $R^2$ substituiert sein kann, werden insbesondere Gruppen verstanden, die abgeleitet sind von Benzol, Naphthalin, Anthracen, Benzanthracen, Phenanthren, Pyren, Chrysen, Perylen, Fluoranthen, Naphthacen, Pentacen, Benzpyren, Biphenyl, Biphenylen, Terphenyl, Triphenylen, Fluoren, Spirobifluoren, Dihydrophenanthren, Dihydropyren, Tetrahydropyren, cis- oder trans-Indenofluoren, cis- oder trans-Indenocarbazol, cis- oder trans-Indolocarbazol, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol; Isoxazol, 1,2-Thiazol, 1,3-Thiazol, Benzothiazol, Pyridazin, Hexaazatriphenylen, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol oder Gruppen,

die abgeleitet sind von Kombination dieser Systeme.

Eine elektronentransportierende Verbindung im Sinne der vorliegenden Erfindung, wie sie in der erfindungsgemäßen organischen Elektrolumineszenzvorrichtung vorliegt, ist eine Verbindung, die ein LUMO von kleiner oder gleich -2.4 eV aufweiset. Dabei ist das LUMO das niedrigste unbesetzte Molekülorbital (lowest unoccupied molecular orbital). Der Wert des LUMO der Verbindung wird durch quantenchemische Rechnung bestimmt, wie hinten im Beispielteil allgemein beschrieben.

Dabei handelt es sich bei der Schicht, die die elektronentransportierende Verbindung mit einem LUMO ≤ -2.4 eV und die Verbindung der Formel (1) bzw. (1a) enthält, insbesondere um eine emittierende Schicht, eine Elektronentransport- bzw. Elektroneninjektionsschicht oder eine Lochblockierschicht, bevorzugt um eine emittierende Schicht oder eine Elektronentransport- bzw. Elektroneninjektionsschicht und besonders bevorzugt um eine emittierende Schicht. Wenn es sich um eine emittierende Schicht handelt, dann ist es bevorzugt eine phosphoreszierende Schicht, die dadurch gekennzeichnet ist, dass sie zusätzlich zu der elektronentransportierenden Verbindung mit einem LUMO ≤ -2.4 eV und der Verbindung der Formel (1) bzw. (1a) eine phosphoreszierende Verbindung enthält. In diesem Fall sind die elektronentransportierende Verbindung mit einem LUMO von ≤ -2.4 eV und die Verbindung der Formel (1) bzw. (1a) Matrixmaterialien für die phosphoreszierenden Verbindung, nehmen also selber nicht oder nicht in wesentlichem Umfang an der Lichtemission teil.

Eine phosphoreszierende Verbindung im Sinne der vorliegenden Erfindung ist eine Verbindung, die Lumineszenz aus einem angeregten Zustand mit höherer Spinmultiplizität zeigt, also einem Spinzustand > 1, insbesondere aus einem angeregten Triplettzustand. Im Sinne dieser Anmeldung sollen alle lumineszierenden Komplexe mit Übergangsmetallen oder Lanthaniden, insbesondere alle Iridium-, Platin- und Kupferkomplexe, als phosphoreszierende Verbindungen angesehen werden.

Das bevorzugte Verhältnis der elektronentransportierenden Verbindung mit einem LUMO ≤ -2.4 eV und der Verbindung gemäß Formel (1) bzw. (1a) hängt von der genauen Struktur der Materialien und genauer Anwendung ab. Allgemein bevorzugt ist ein Verhältnis der elektronentransportierenden Verbindung mit einem LUMO ≤ -2.4 eV zu der Verbindung gemäß Formel (1) bzw. (1a) zwischen 10:90 und 90:10, bevorzugt zwischen 20:80 und 80:20, besonders bevorzugt zwischen 30:70 und 70:30 und ganz besonders bevorzugt zwischen 40:60 und 60:40. Dabei ist das Verhältnis üblicherweise bezogen auf das Volumen, wenn die Schicht durch einen Aufdampfprozess hergestellt wird, bzw. ist bezogen auf das Gewicht, wenn die Schicht aus Lösung hergestellt wird. Das jeweils beste Verhältnis kann nicht unabhängig von den Materialien angegeben werden, kann jedoch durch den Fachmann in Routineexperimenten ohne Ausübung von erfinderischer Tätigkeit ermittelt werden. Dies gilt sowohl, wenn die Mischung als Matrixmaterialien für eine phosphoreszierende Verbindung in einer emittierenden Schicht eingesetzt wird, wie auch, wenn die Mischung als Elektronentransportmaterialien in einer Elektronentransportschicht eingesetzt wird.

Wenn die elektronentransportierende Verbindung mit einem LUMO ≤ -2.4 eV und die Verbindung der Formel (1) bzw. (1a) als Matrixmaterialien für eine phosphoreszierende Verbindung eingesetzt werden, ist es bevorzugt, wenn deren Triplettenergie nicht wesentlich kleiner der Triplettenergie des phosphoreszierenden Emitters ist. Dabei gilt bevorzugt für das Triplettniveau $T_1$(Emitter) - $T_1$(Matrix) ≤ 0.2 eV, besonders bevorzugt ≤ 0.15 eV, ganz besonders bevorzugt ≤ 0.1 eV. Dabei ist $T_1$(Matrix) das Triplettniveau des Matrixmaterials in der Emissionsschicht, wobei diese Bedingung für jedes der beiden Matrixmaterialien gilt, und $T_1$(Emitter) ist das Triplettniveau des phosphoreszierenden Emitters. Enthält die Emissionsschicht mehr als zwei Matrixmaterialien, so gilt die oben genannte Beziehung bevorzugt auch für jedes weitere Matrixmaterial.

Die Mischung aus der phosphoreszierenden Verbindung und den Matrixmaterialien, also der elektronentransportierenden Verbindung mit einem LUMO ≤ -2.4 eV und der Verbindung gemäß Formel (1) bzw. (1a), in der emittierenden Schicht enthält insgesamt zwischen 99 und 1 Vol.-%, vorzugsweise zwischen 98 und 10 Vol.-%, besonders bevorzugt zwischen 97 und 60 Vol.-%, insbesondere zwischen 95 und 80 Vol.-% der Matrixmaterialien bezogen auf die Gesamtmischung aus Emitter und Matrixmaterialien. Entsprechend enthält die Mischung zwischen 1 und 99 Vol.-%, vorzugsweise zwischen 2 und 90 Vol.-%, besonders bevorzugt zwischen 3 und 40 Vol.-%, insbesondere zwischen 5 und 20 Vol.-% des Emitters bezogen auf die Gesamtmischung aus Emitter und Matrixmaterialien.

Im Folgenden werden bevorzugte Ausführungsformen der Verbindung der Formel (1) bzw. (1a) beschrieben.

In einer bevorzugten Ausführungsform der Erfindung steht die Gruppe $Ar^1$ für eine Gruppe der folgenden Formel (2), (3), (4), (5) oder (6),

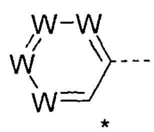
Formel (2)

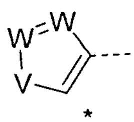
Formel (3)

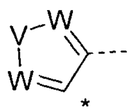
Formel (4)

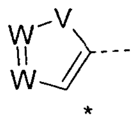
Formel (5)

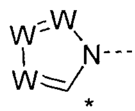
Formel (6)

wobei die gestrichelte Bindung die Verknüpfung mit der Carbonylgruppe andeutet, * die Position der Verknüpfung mit E andeutet und weiterhin gilt:

W ist gleich oder verschieden bei jedem Auftreten CR oder N; oder zwei benachbarte Gruppen W stehen für eine Gruppe der folgenden Formel (7) oder (8),

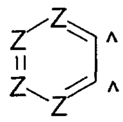

Formel (7)

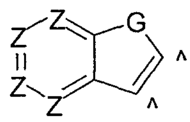

Formel (8)

wobei G für $CR_2$, NR, O oder S steht, Z gleich oder verschieden bei jedem Auftreten für CR oder N steht und ^ die entsprechenden benachbarten Gruppen W in der Formel (2) bis (6) andeuten;

V ist NR, O oder S.

In einer weiteren bevorzugten Ausführungsform der Erfindung steht die Gruppe $Ar^2$ für eine Gruppe gemäß einer der folgenden Formeln (9), (10) oder (11),

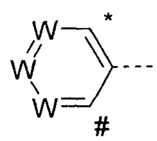

Formel (9)

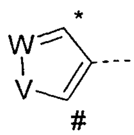

Formel (10)

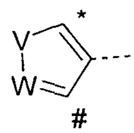

Formel (11)

wobei die gestrichelte Bindung die Verknüpfung mit N andeutet, # die Position der Verknüpfung mit $Ar^3$ andeutet, * die Verknüpfung mit E andeutet und W und V die oben genannten Bedeutungen aufweisen.

In einer weiteren bevorzugten Ausführungsform der Erfindung steht die Gruppe $Ar^3$ für eine Gruppe gemäß einer der folgenden Formeln (12), (13), (14) oder (15),

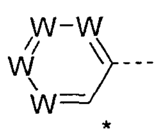

Formel (12)

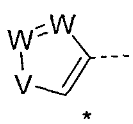

Formel (13)

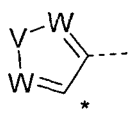

Formel (14)

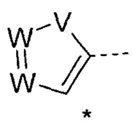

Formel (15)

wobei die gestrichelte Bindung die Verknüpfung mit N andeutet, * die Verknüpfung mit $Ar^2$ andeutet und W und V die oben genannten Bedeutungen aufweisen.

Dabei können die oben genannten bevorzugten Gruppen $Ar^1$, $Ar^2$ und $Ar^3$ beliebig miteinander kombiniert werden.

In einer weiteren bevorzugten Ausführungsform der Erfindung steht E für eine Einfachbindung.

In einer bevorzugten Ausführungsform der Erfindung treten die oben genannten Bevorzugungen gleichzeitig auf. Besonders bevorzugt sind daher Verbindungen gemäß Formel (1) bzw. (1a), für die gilt:

E ist eine Einfachbindung;

$Ar^1$ ist ausgewählt aus den Gruppen der oben genannten Formeln (2), (3), (4), (5) oder (6);

$Ar^2$ ist ausgewählt aus den Gruppen der oben genannten Formeln (9), (10) oder (11);

$Ar^3$ ist ausgewählt aus den Gruppen der oben genannten Formeln (12), (13), (14) oder (15).

Besonders bevorzugt stehen mindestens zwei der Gruppen $Ar^1$, $Ar^2$ und $Ar^3$ für eine 6-Ring-Aryl- oder eine 6-Ring-Heteroarylgruppe. Besonders bevorzugt steht also $Ar^1$ für eine Gruppe der Formel (2) und gleichzeitig steht $Ar^2$ für eine Gruppe der Formel (9), oder $Ar^1$ steht für eine Gruppe der Formel (2) und gleichzeitig steht $Ar^3$ für eine Gruppe

der Formel (12), oder $Ar^2$ steht für eine Gruppe der Formel (9) und gleichzeitig steht $Ar^3$ für eine Gruppe der Formel (12).

Besonders bevorzugte Ausführungsformen der Formel (1) sind daher die Verbindungen der folgenden Formeln (16) bis (26),

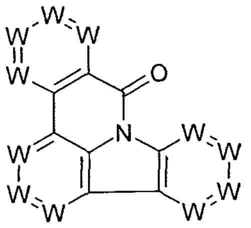

Formel (16)

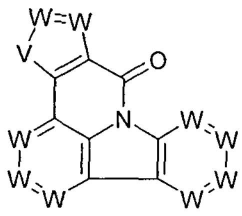

Formel (17)

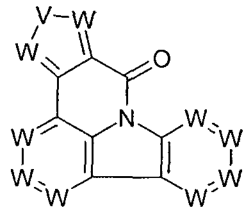

Formel (18)

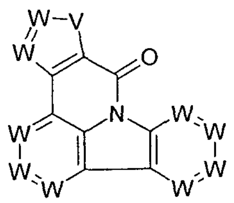

Formel (19)

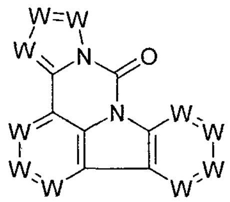

Formel (20)

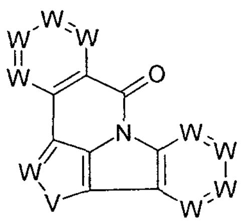

Formel (21)

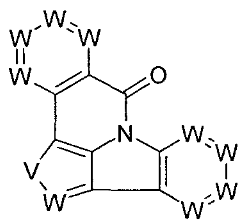

Formel (22)

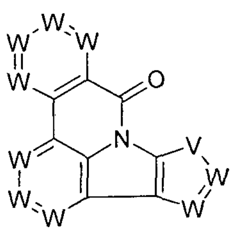

Formel (23)

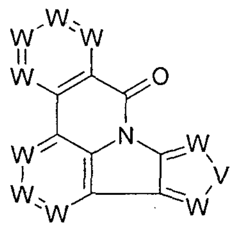

Formel (24)

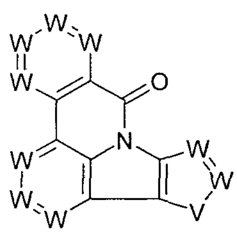

Formel (25)

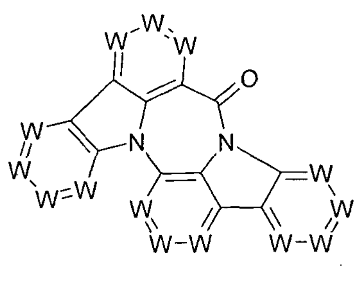

Formel (26)

wobei die verwendeten Symbole die oben genannten Bedeutungen aufweisen.

Es ist weiterhin bevorzugt, wenn W für CR oder N steht und nicht für eine Gruppe der Formel (7) oder (8). In einer bevorzugten Ausführungsform der Verbindungen gemäß Formel (16) bis (26) steht pro Cyclus insgesamt maximal

ein Symbol W für N, und die verbleibenden Symbole W stehen für CR. In einer besonders bevorzugten Ausführungsform der Erfindung stehen alle Symbole W für CR. Besonders bevorzugt sind daher die Verbindungen gemäß den folgenden Formeln (16a) bis (26a),

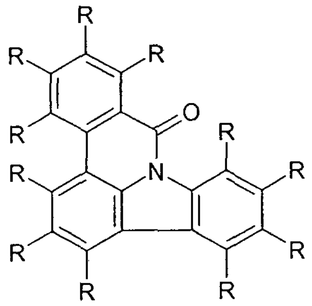
Formel (16a)

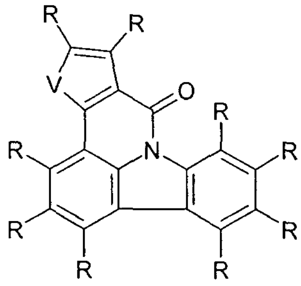
Formel (17a)

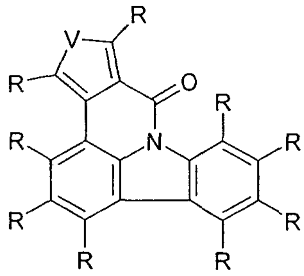
Formel (18a)

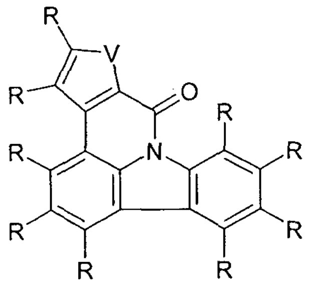
Formel (19a)

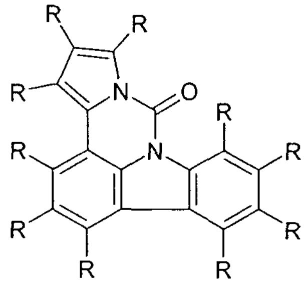
Formel (20a)

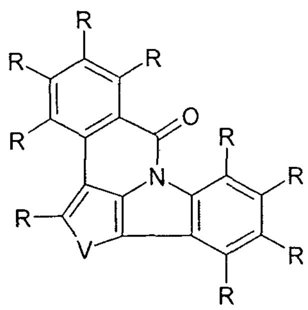
Formel (21a)

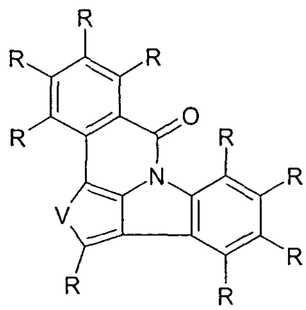
Formel (22a)

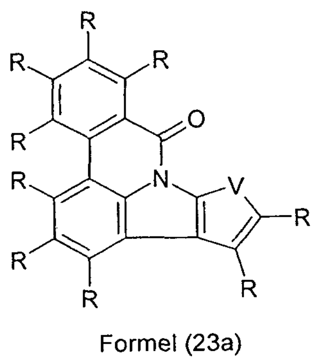
Formel (23a)

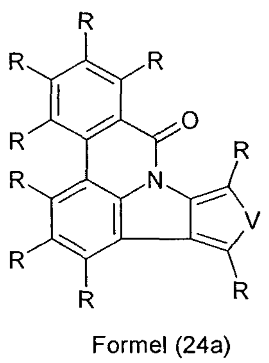
Formel (24a)

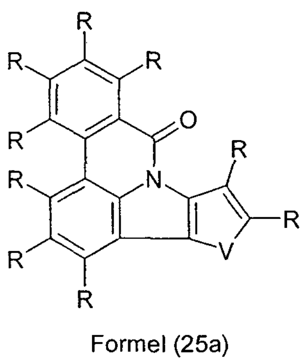
Formel (25a)

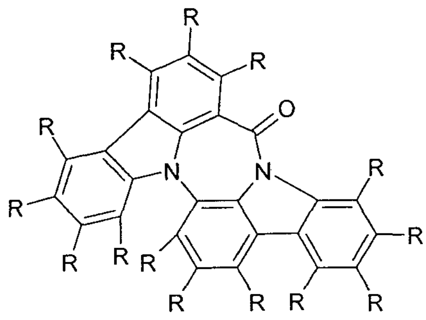

Formel (26a)

wobei die verwendeten Symbole die oben genannten Bedeutungen aufweisen.

Ganz besonders bevorzugt sind die Strukturen der Formeln (16b) bis (26b),

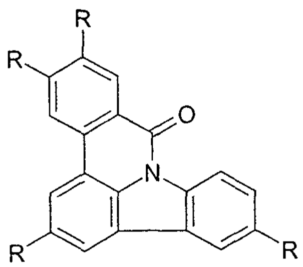

Formel (16b)

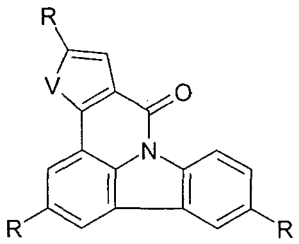

Formel (17b)

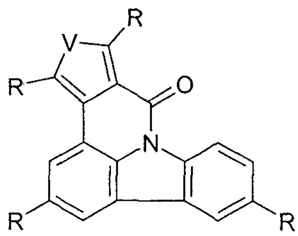

Formel (18b)

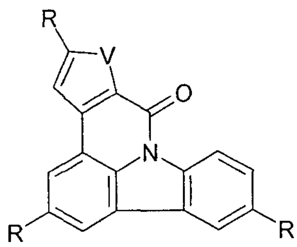

Formel (19b)

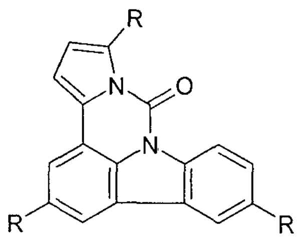

Formel (20b)

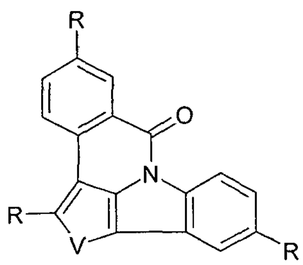

Formel (21b)

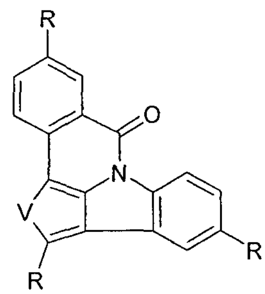

Formel (22b)

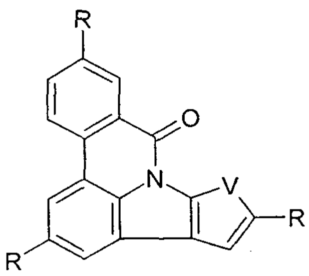

Formel (23b)

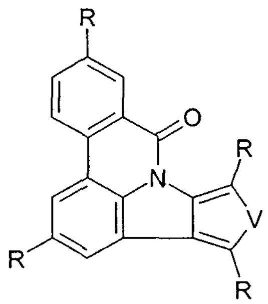

Formel (24b)

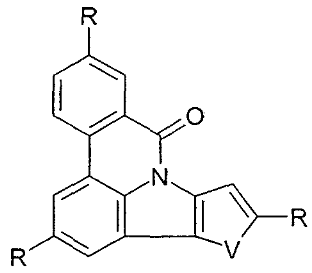

Formel (25b)

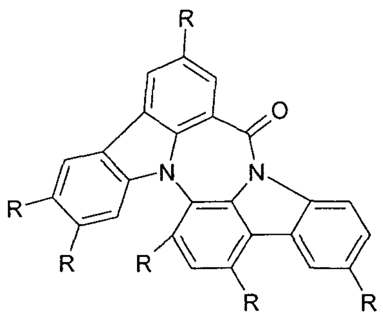

Formel (26b)

wobei die verwendeten Symbole die oben genannten Bedeutungen aufweisen.

Ganz besonders bevorzugt sind die Verbindungen der Formel (16) bzw. (16a) bzw. (16b).

In einer weiteren bevorzugten Ausführungsform der Erfindung steht $Ar^3$ für eine Gruppe der Formel (12) und zwei benachbarte Gruppen W in dieser Gruppe $Ar^3$ stehen für eine Gruppe der Formel (8) und die anderen Gruppen W in dieser Gruppe $Ar^3$ stehen gleich oder verschieden für CR oder N, insbesondere für CR. Dabei kann die Gruppe der Formel (8) in jeder möglichen Position ankondensiert sein. Besonders bevorzugt steht gleichzeitig $Ar^1$ für eine Gruppe der Formel (2), in der W bleich oder verschieden für CR oder N steht, insbesondere für CR, und $Ar^2$ steht für eine Gruppe der Formel (9), in der W gleich oder verschieden für CR oder N steht, insbesondere für CR. Bevorzugte Ausführungsformen der Verbindungen der Formel (1) sind also weiterhin die Verbindungen der folgenden Formeln (27) bis (32),

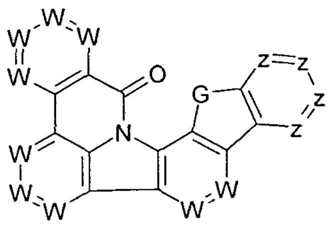

Formel (27)

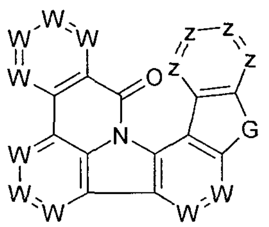

Formel (28)

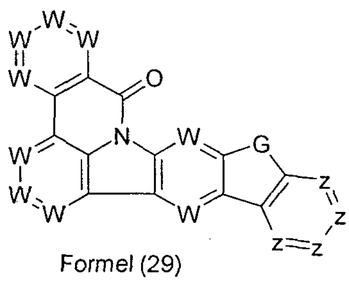

Formel (29)

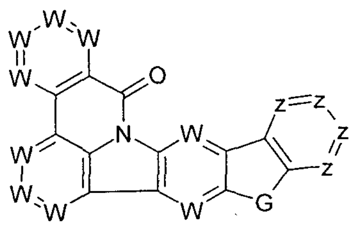

Formel (30)

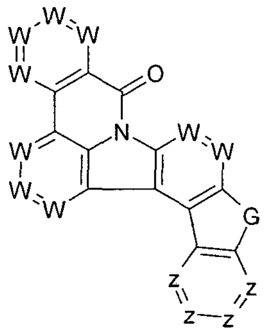

Formel (31)

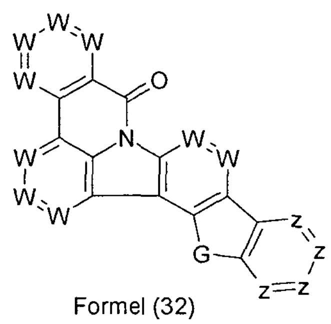

Formel (32)

wobei G und Z die oben genannten Bedeutungen aufweisen und W gleich oder verschieden bei jedem Auftreten für CR oder N stehen.

In einer bevorzugten Ausführungsform der Erfindung steht pro Cyclus in den Verbindungen der Formel (27) bis (32) jeweils maximal eine Gruppe W bzw. Z für N und die anderen Gruppen W bzw. Z stehen für CR. Besonders bevorzugt stehen alle Gruppen W und Z für CR.

In einer weiteren bevorzugten Ausführungsform der Erfindung steht G für $CR_2$, NR oder O, besonders bevorzugt für $CR_2$ oder NR und ganz besonders bevorzugt für $CR_2$.

In einer besonders bevorzugten Ausführungsform der Erfindung stehen alle Gruppen W und Z für CR und G steht gleichzeitig für $CR_2$, NR oder O, besonders bevorzugt für $CR_2$ oder NR und insbesondere für $CR_2$.

Bevorzugte Verbindungen der Formel (27) bis (32) sind somit die Verbindungen der folgenden Formeln (27a) bis (32a),

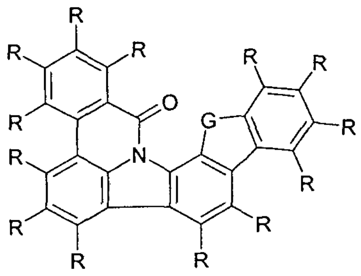

Formel (27a)

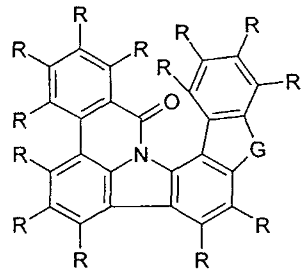

Formel (28a)

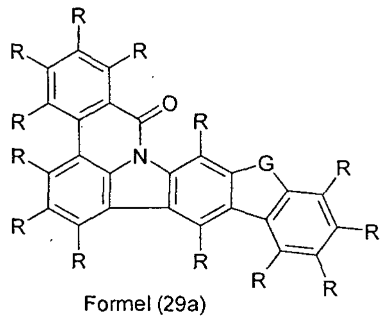

Formel (29a)

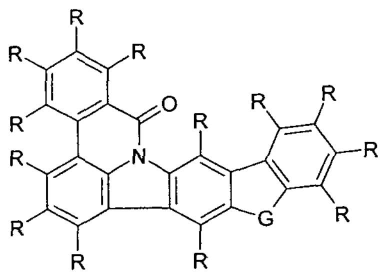

Formel (30a)

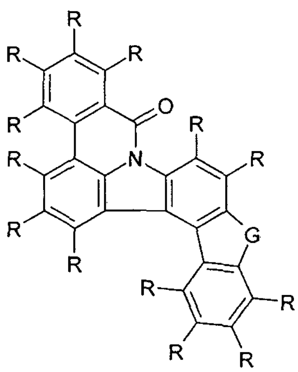

Formel (31a)

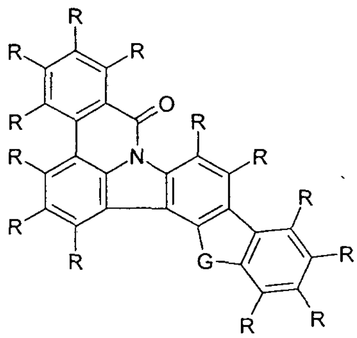

Formel (32a)

wobei die verwendeten Symbole die oben genannten Bedeutungen aufweisen.

Die folgenden Verbindungen der Formeln (27b) bis (32b) sind besonders bevorzugt:

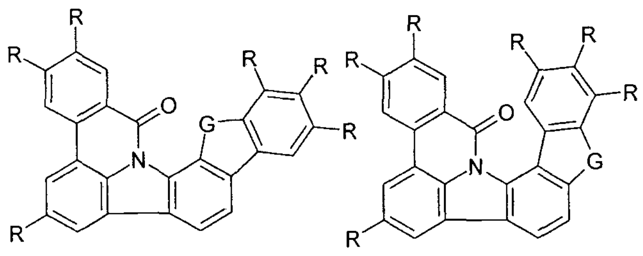

Formel (27b)

Formel (28b)

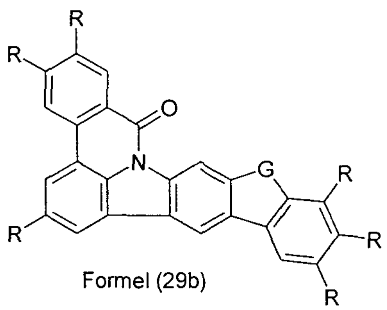

Formel (29b)

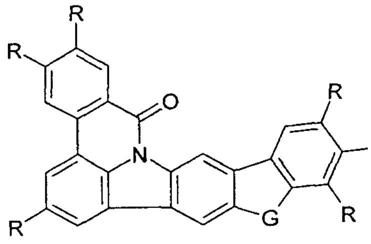

Formel (30b)

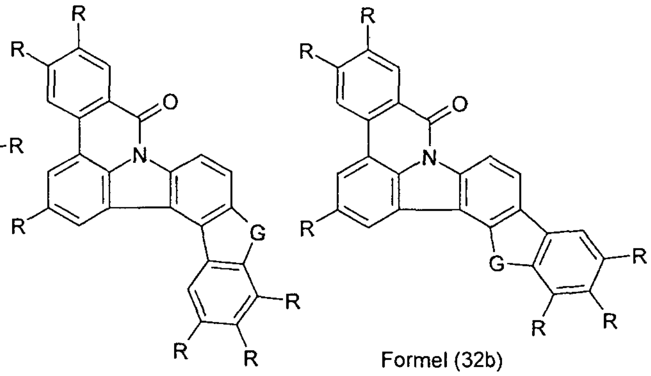

Formel (31b)

Formel (32b)

Dabei weisen R und G die oben genannten Bedeutungen auf und die oben bzw. im Folgenden genannten bevorzugten Bedeutungen.

Die verbrückende Gruppe L in den Verbindungen der Formeln (1a) ist bevorzugt ausgewählt aus einer Einfachbindung oder einem aromatischen oder heteroaromatischen Ringsystem mit 5 bis 30 aromatischen Ringatomen, welches durch einen oder mehrere Reste R substituiert sein kann. Dabei enthalten die aromatischen bzw. heteroaromatischen Ringsysteme bevorzugt keine kondensierten Aryl- bzw. Heteroarylgruppen, in denen mehr als zwei aromatische Sechsringe direkt aneinander ankondensiert sind. Besonders bevorzugt enthalten sie überhaupt keine Aryl- bzw. Heteroarylgruppen, in denen aromatische Sechsringe direkt aneinander ankondensiert sind.

In einer weiteren bevorzugten Ausführungsform der Erfindung ist der Index n in Verbindungen der Formel (1a) = 2 oder 3, insbesondere gleich 2. Ganz besonders bevorzugt werden Verbindungen der Formel (1) eingesetzt.

In einer bevorzugten Ausführungsform der Erfindung ist R in den oben genannten Formeln gleich oder verschieden bei jedem Auftreten ausgewählt aus der Gruppe bestehend aus H, D, F, Cl, Br, CN, $N(Ar^5)_2$, $C(=O)Ar^5$, einer geradkettigen Alkyl- oder Alkoxygruppe mit 1 bis 10 C-Atomen oder einer verzweigten oder cyclischen Alkyl- oder Alkoxygruppe mit 3 bis 10 C-Atomen oder einer Alkenyl- oder Alkinylgruppe mit 2 bis 10 C-Atomen, die jeweils mit einem oder mehreren Resten $R^1$ substituiert sein kann, wobei eine oder mehrere nicht-benachbarte $CH_2$-Gruppen durch O ersetzt sein können und wobei ein oder mehrere H-Atome durch D oder F ersetzt sein können, einem aromatischen oder heteroaromatischen Ringsystem mit 5 bis 30 aromatischen Ringatomen, das jeweils mit einem oder mehreren Resten $R^1$ substituiert sein kann, einer Aryloxy- oder Heteroaryloxygruppe mit 5 bis 30 aromatischen Ringatomen, die mit einem oder mehreren Resten $R^1$ substituiert sein kann, oder einer Kombination dieser Systeme. Besonders bevorzugt ist R in den oben genannten Formeln gleich oder verschieden bei jedem Auftreten ausgewählt aus der Gruppe bestehend aus H, D, F, Cl, Br, CN, einer geradkettigen Alkylgruppe mit 1 bis 10 C-Atomen oder einer verzweigten oder cyclischen Alkylgruppe mit 3 bis 10 C-Atomen, die jeweils mit einem oder mehreren Resten $R^1$ substituiert sein kann, wobei ein oder mehrere H-Atome durch D oder F ersetzt sein können, einem aromatischen oder heteroaromatischen Ringsystem mit 5 bis 18 aromatischen Ringatomen, das jeweils mit einem oder mehreren Resten $R^1$ substituiert sein kann, oder einer Kombination dieser Systeme.

Dabei enthalten die Reste R, wenn diese aromatische oder heteroaromatische Ringsysteme enthalten, bevorzugt keine kondensierten Aryl- bzw. Heteroarylgruppen, in denen mehr als zwei aromatische Sechsringe direkt aneinander ankondensiert sind. Besonders bevorzugt enthalten sie überhaupt keine Aryl- bzw. Heteroarylgruppen, in denen aromatische Sechsringe direkt aneinander ankondensiert sind. Insbesondere bevorzugt sind hier Phenyl, Biphenyl, Terphenyl, Quaterphenyl, Carbazol, Dibenzothiophen, Dibenzofuran, Indenocarbazol, Indolocarbazol, Triazin oder Pyrimidin, welche jeweils auch durch einen oder mehrere Reste $R^1$ substituiert sein können. Dabei ist es auch bevorzugt, wenn in den Resten $R^1$ nicht mehr als zwei aromatische Sechsringe direkt aneinander ankondensiert sind. Besonders bevorzugt enthält $R^1$ überhaupt keine Aryl- bzw. Heteroarylgruppen, in denen aromatische Sechsringe direkt aneinander ankondensiert sind.

Dabei haben für Verbindungen, die durch Vakuumverdampfung verarbeitet werden, die Alkylgruppen bevorzugt nicht mehr als fünf C-Atome, besonders bevorzugt nicht mehr als 4 C-Atome, ganz besonders bevorzugt nicht mehr als 1 C-Atom. Für Verbindungen, die aus Lösung verarbeitet werden, eignen sich auch Verbindungen, die mit Alkylgruppen mit bis zu 10 C-Atomen substituiert sind oder die mit Oligoarylengruppen, beispielsweise ortho-, meta-, para- oder verzweigten Terphenylgruppen, substituiert sind.

Die Synthese der Verbindungen der Formel (1) kann gemäß den in der WO 2011/116865 und WO 2011/137951 beschriebenen Verfahren erfolgen.

Beispiele für bevorzugte Verbindungen gemäß den oben aufgeführten Ausführungsformen sind die in der folgenden Tabelle aufgeführten Verbindungen.

| | | |
|---|---|---|
| 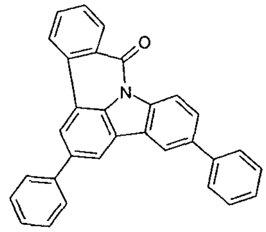 | 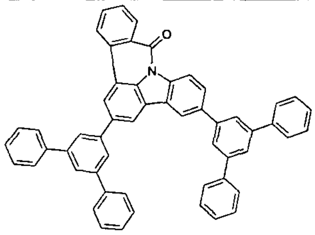 | 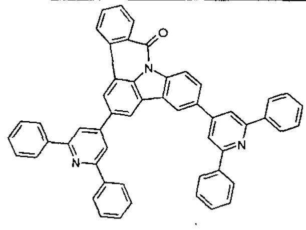 |
| 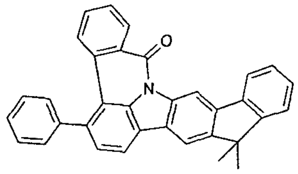 | 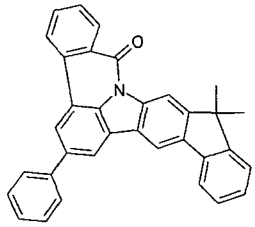 | 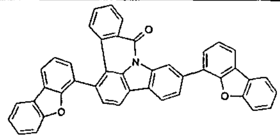 |
| 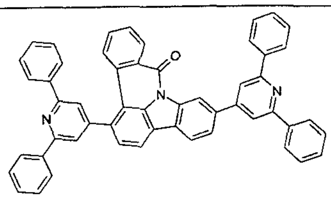 | 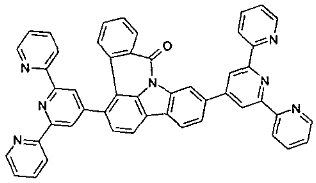 | 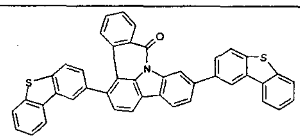 |
| 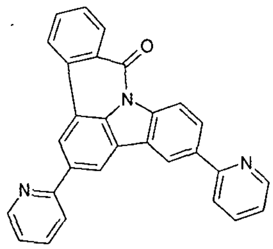 | 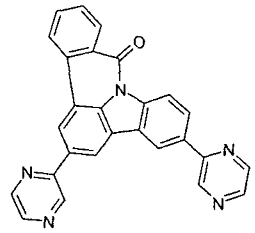 | 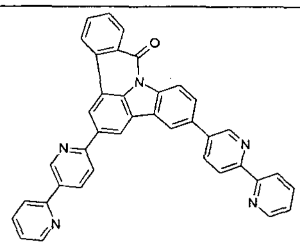 |

| | | |
|---|---|---|
| 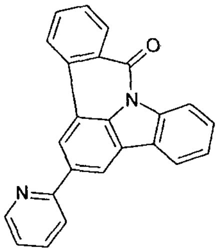 | 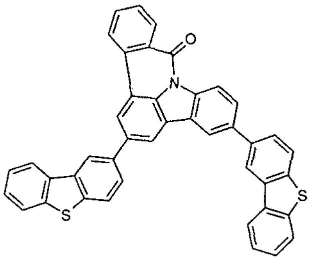 | 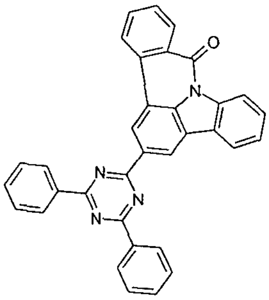 |
| 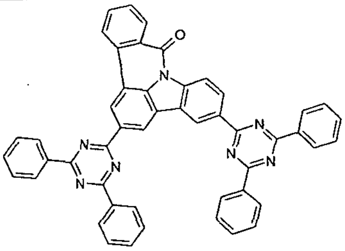 | 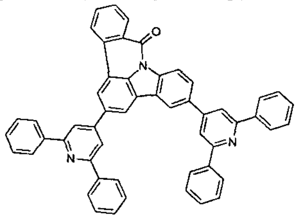 | 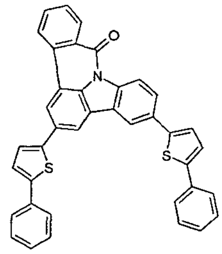 |
| 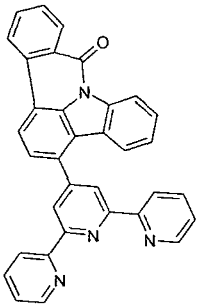 | 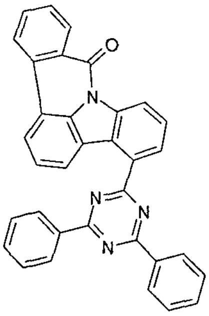 | 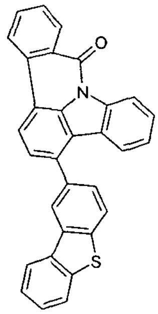 |
| 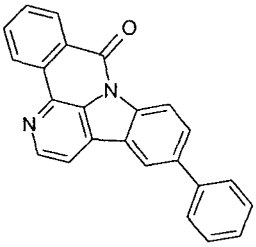 | 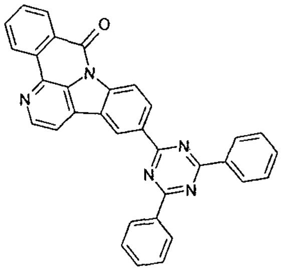 | 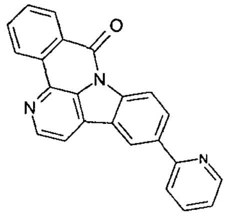 |
| 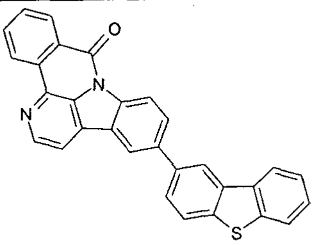 | 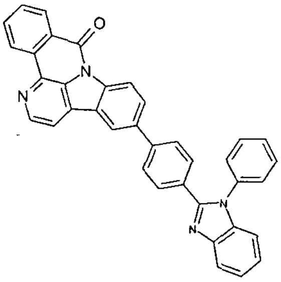 | 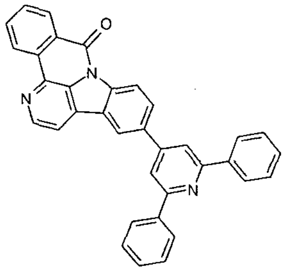 |

| | | |
|---|---|---|
| 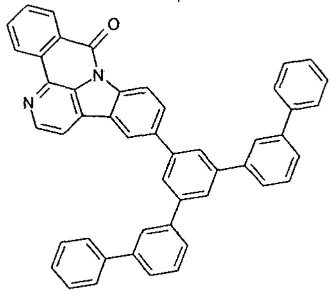 | 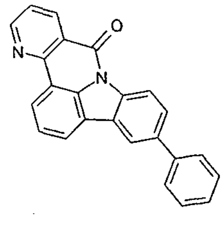 | 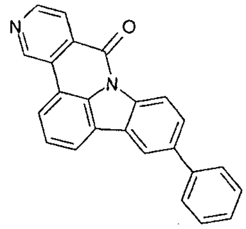 |
| 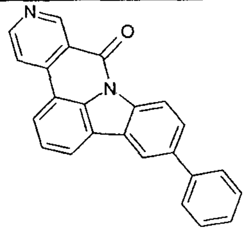 | 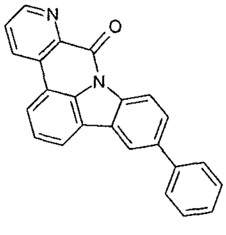 | 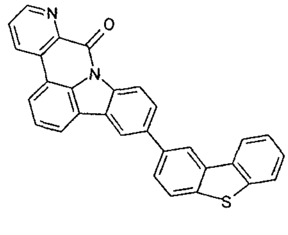 |
| 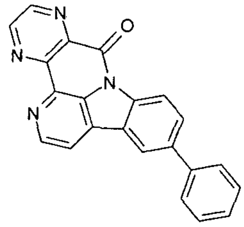 | 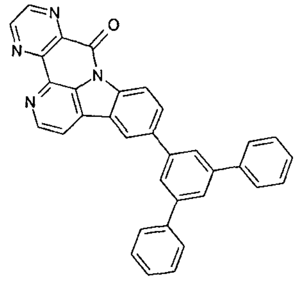 | 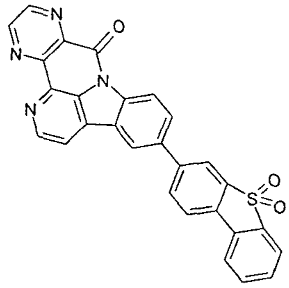 |
| 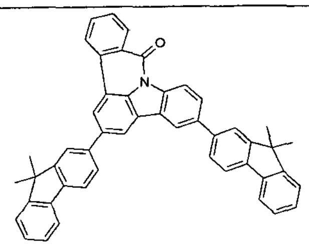 | 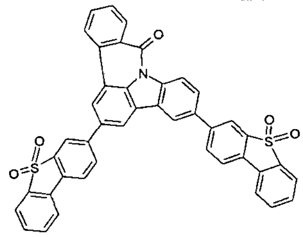 | 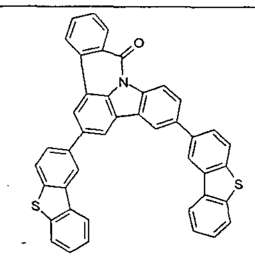 |
| 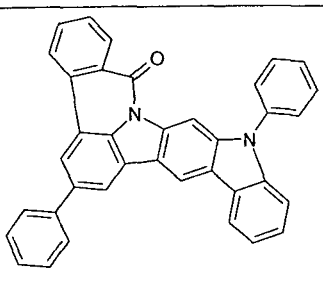 | 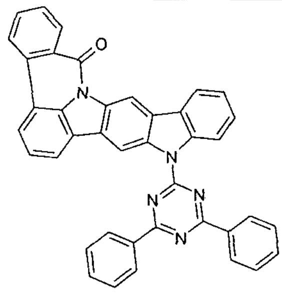 | 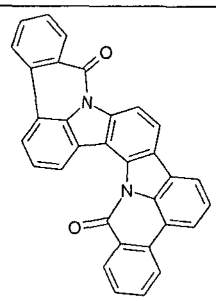 |
| 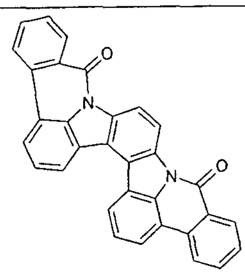 | 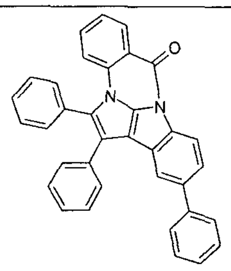 | 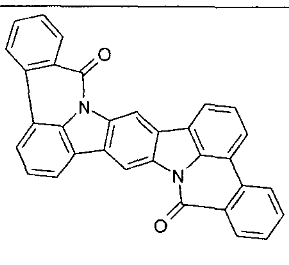 |

| | | |
|---|---|---|
| 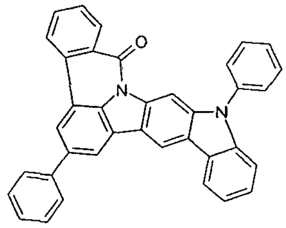 | 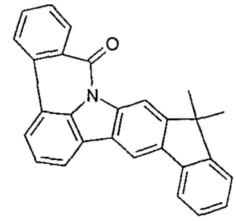 | 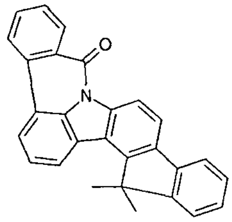 |
| 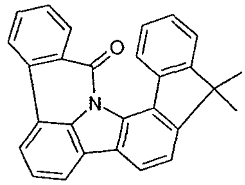 | 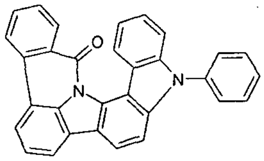 | 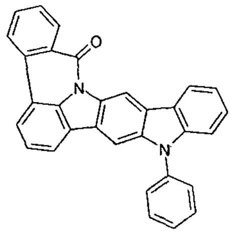 |
| 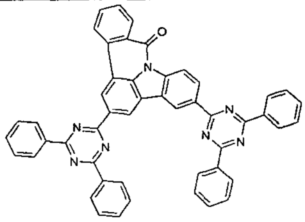 | 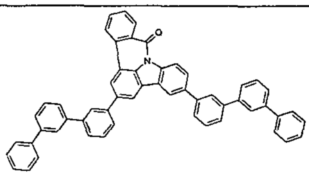 | 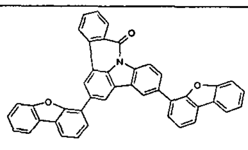 |
| 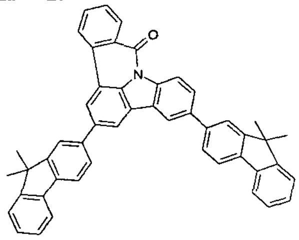 | 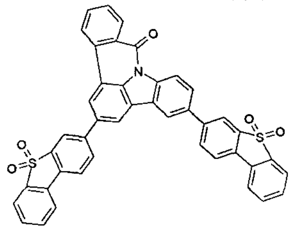 | 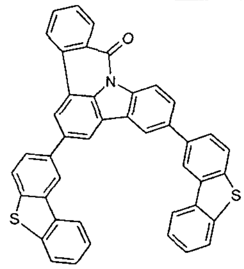 |
| 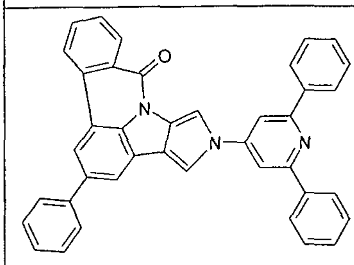 | 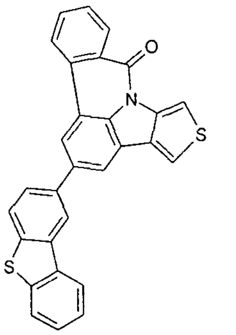 | 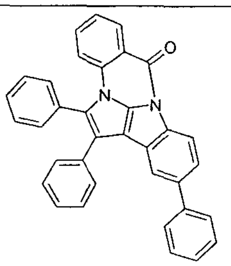 |
| 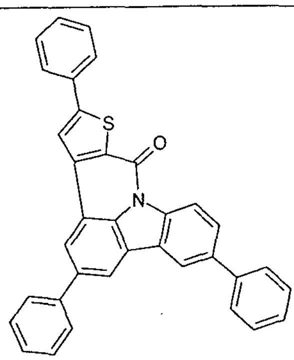 | 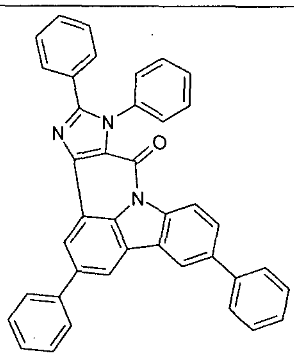 | 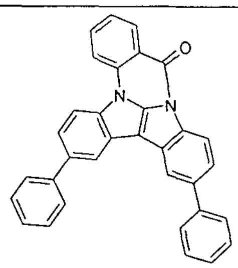 |

| | | |
|---|---|---|
| 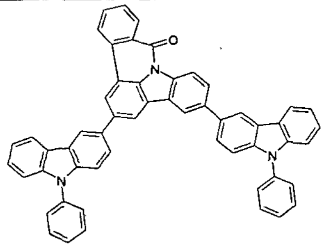 | 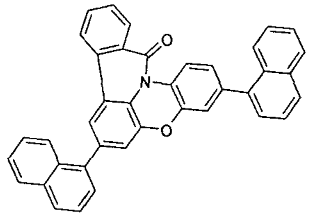 | 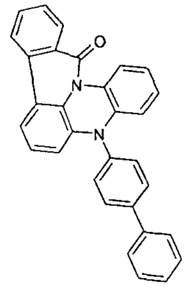 |
| 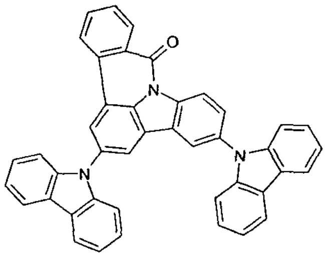 | 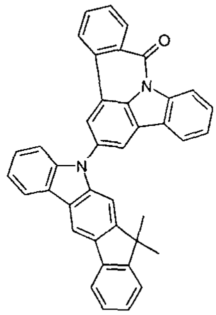 | 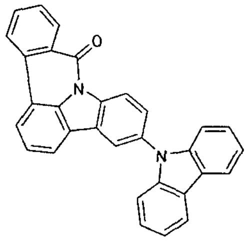 |
| 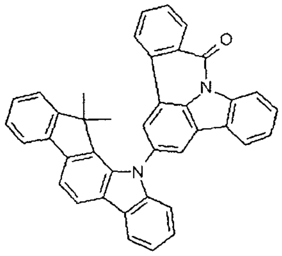 | 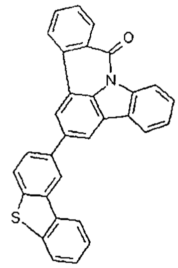 | 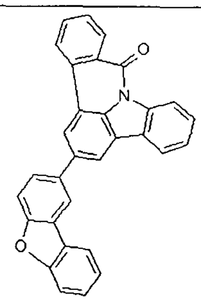 |
| 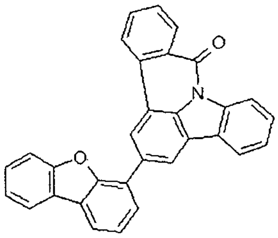 | 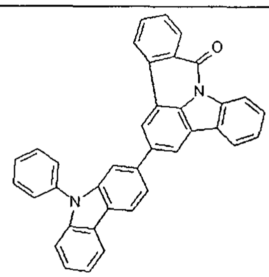 | 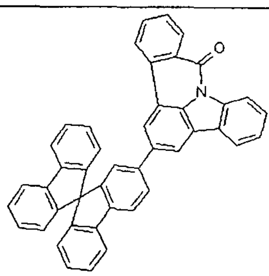 |
| 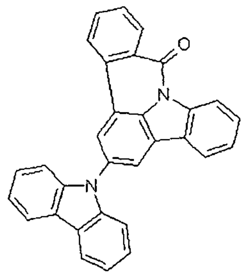 | 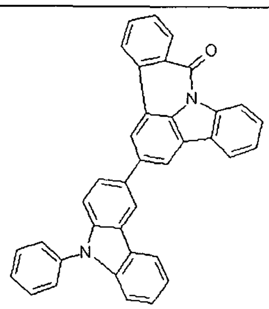 | 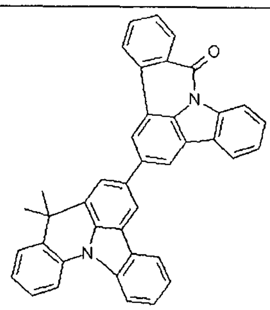 |

| | | |
|---|---|---|
| 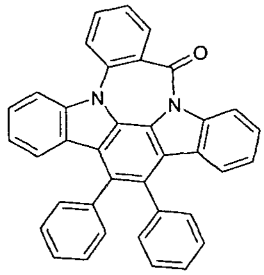 | 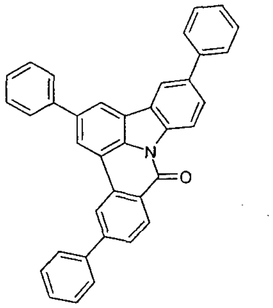 | 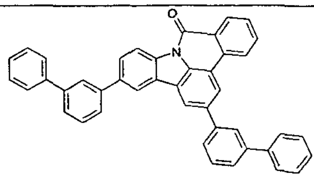 |
| 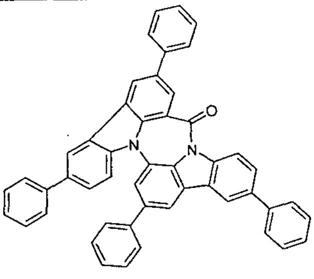 | 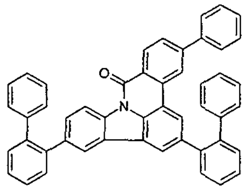 | 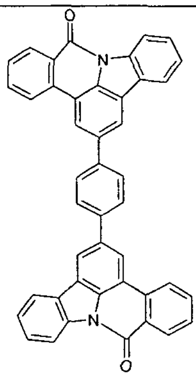 |
| 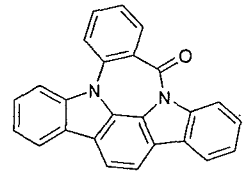 | 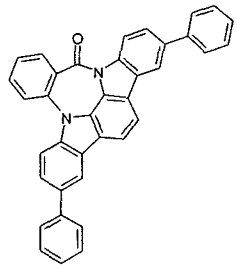 | 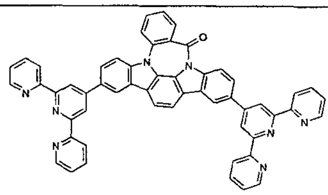 |
| 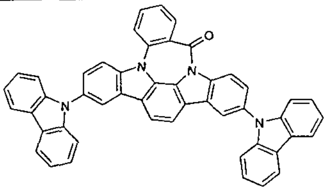 | 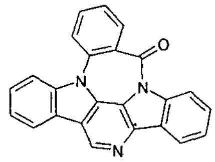 | 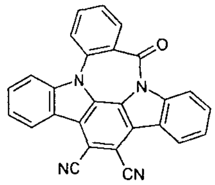 |
| 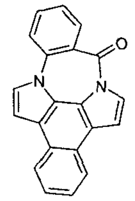 | 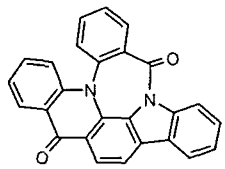 | 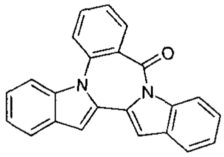 |
| 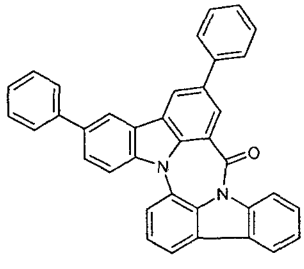 | 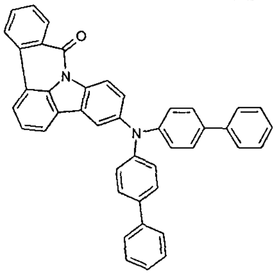 | 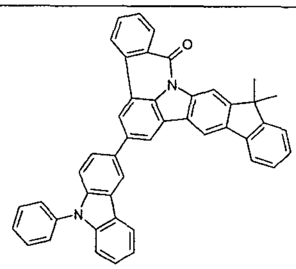 |

| | | |
|---|---|---|
| 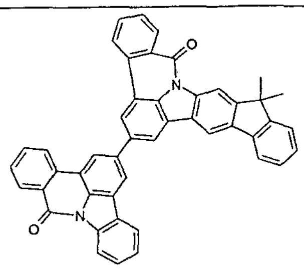 | 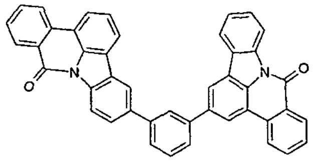 | 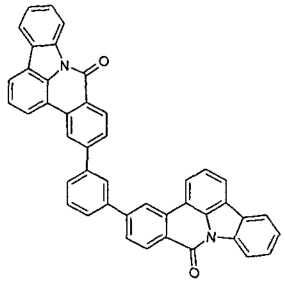 |
| 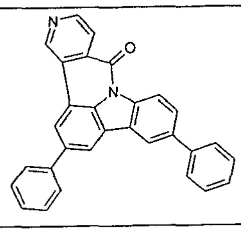 | | |

Im Folgenden werden bevorzugte elektronentransportierende Verbindungen beschrieben, wie sie erfindungsgemäß in Kombination mit Verbindungen der Formel (1) eingesetzt werden.

In einer bevorzugten Ausführungsform der Erfindung weist die elektronentransportierende Verbindung ein LUMO von ≤ -2.5 eV auf, besonders bevorzugt ≤ -2.55 eV.

In einer weiteren bevorzugten Ausführungsform der Erfindung enthält die Verbindung mindestens eine Triazingruppe, mindestens eine Pyrimidingruppe und/oder mindestens eine Lactamgruppe.

Wenn es sich um eine Verbindung mit einer Lactamgruppe handelt, dann ist diese bevorzugt ausgewählt aus den Verbindungen der oben genannten Formel (1) bzw. den oben ausgeführten bevorzugten Ausführungsformen. Dabei sind die elektronentransportierende Verbindung mit einem LUMO ≤ -2.4 eV und die Verbindung der Formel (1) voneinander unterschiedlich, d.h. es handelt sich um eine Mischung aus zwei verschiedenen Verbindungen der Formel (1).

Wenn es sich um eine Verbindung mit einer Triazingruppe oder einer Pyrimidingruppe handelt, dann ist diese Gruppe bevorzugt an drei aromatische oder heteroaromatische Ringsysteme mit jeweils 5 bis 30 aromatischen Ringatomen, bevorzugt 6 bis 24 aromatischen Ringatomen, gebunden, die jeweils durch einen oder mehrere Reste R, die wie oben definiert sind, substituiert sein können.

Wenn es sich um eine Verbindung mit einer Triazingruppe oder einer Pyrimidingruppe handelt, dann ist diese Gruppe bevorzugt direkt oder über eine verbrückende Gruppe an eine Indenocarbazolgruppe, eine Spiroindenocarbazolgruppe, eine Indolocarbazolgruppe, eine Carbazolgruppe oder eine Spriobifluorengruppe gebunden. Dabei können sowohl die Triazin- bzw. Pyrimidingruppe wie auch die Indenocarbazol- bzw. Indolocarbazol- bzw. Carbazolgruppe durch einen oder mehrere Reste R substituiert sein, wobei R wie oben definiert ist und zwei Substituenten R, insbesondere auch den dem Indeno-Kohlenstoffatom des Indenocarbazols, auch miteinander einen Ring bilden können und so ein Spirosystem aufspannen können.

Bevorzugte Ausführungsformen der Triazin- bzw. Pyrimidingruppe sind die Strukturen der folgenden Formeln (T-1) bzw. (P-1), (P-2) oder (P-3),

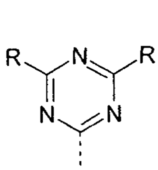

Formel (T-1)

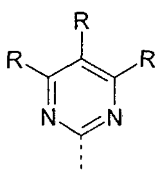

Formel (P-1)

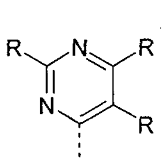

Formel (P-2)

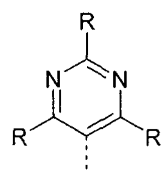

Formel (P-3)

wobei R die oben genannten Bedeutungen aufweist und die gestrichelte Bindung die Bindung an die Indenocarbazolgruppe, die Indolocarbazolgruppe oder die Carbazolgruppe darstellt oder die Bindung an die verbrückende Gruppe, die wiederum an die Indenocarbazolgruppe, die Indolocarbazolgruppe oder die Carbazolgruppe gebunden ist.

Besonders bevorzugte Pyrimidingruppen sind die Strukturen der folgenden Formeln (P-1a), (P-2a) bzw. (P-3a),

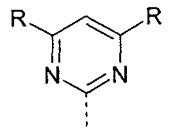
Formel (P-1a)

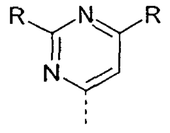
Formel (P-2a)

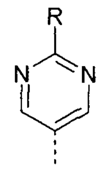
Formel (P-3a)

wobei die verwendeten Symbole die oben genannten Bedeutungen aufweisen.

Dabei stehen die Reste R in Formel (T-1) bzw. (P-1a), (P-2a) oder (P-3a) bevorzugt gleich oder verschieden bei jedem Auftreten für ein aromatisches oder heteroaromatisches Ringsystem mit 5 bis 30, bevorzugt 6 bis 24 aromatischen Ringatomen, das jeweils mit einem oder mehreren Resten $R^1$ substituiert sein kann. Dabei enthalten die aromatischen bzw. heteroaromatischen Ringsysteme bevorzugt keine kondensierten Aryl- bzw. Heteroarylgruppen, in denen mehr als zwei aromatische Sechsringe direkt aneinander ankondensiert sind. Besonders bevorzugt enthalten sie überhaupt keine Aryl- bzw. Heteroarylgruppen, in denen aromatische Sechsringe direkt aneinander ankondensiert sind.

Bevorzugte Ausführungsformen der Indenocarbazolgruppe, der Indolocarbazolgruppe oder der Carbazolgruppe sind die Strukturen der folgenden Formeln (Indeno-1), (Indeno-2), (Indolo-1), (Carb-1) und (Spiro-1),

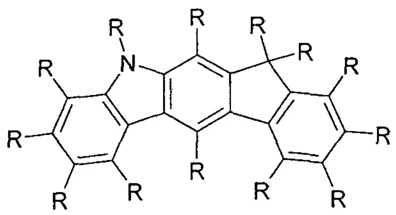
Formel (Indeno-1)

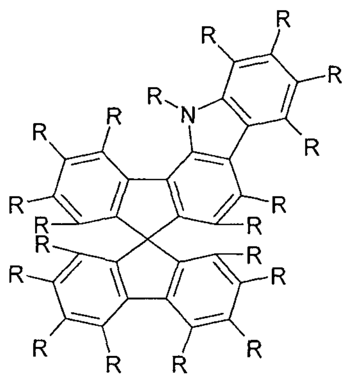
Formel (Indeno-2)

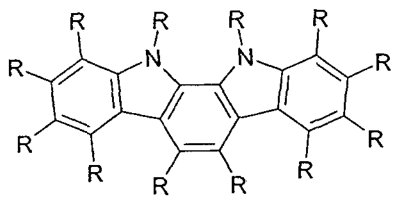
Formel (Indolo-1)

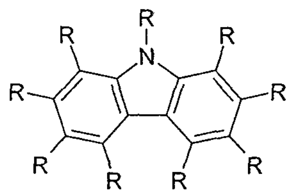
Formel (Carb-1)

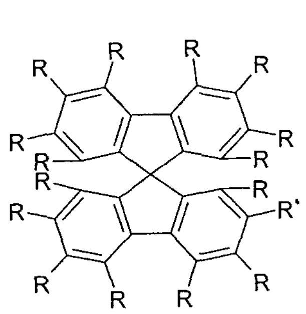
Formel (Spiro-1)

wobei die verwendeten Symbole die oben genannten Bedeutungen aufweisen. Dabei enthalten diese Gruppen statt einem der Reste R, der an ein Kohlenstoffatom oder ein Stickstoffatom gebunden ist, eine Bindung zu der Pyrimidin- bzw. Triazingruppe bzw. zu der verbrückenden Gruppe, die wiederum an die Pyrimidin- bzw. Triazingruppe gebunden ist.

Besonders bevorzugte Ausführungsformen der Indenocarbazolgruppe, der Indolocarbazolgruppe oder der Carbazolgruppe sind die Strukturen der folgenden Formeln (Indeno-1a), (Indeno-2a), (Indolo-1a), (Carb-1a) und (Spiro-1a),

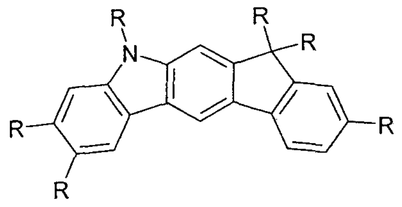

Formel (Indeno-1a)

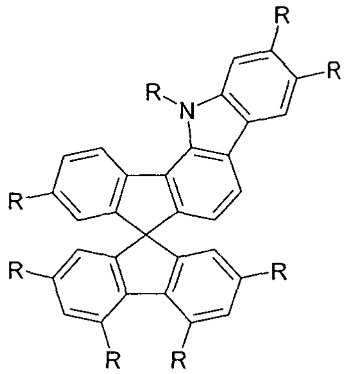

Formel (Indeno-2a)

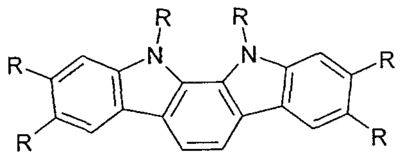

Formel (Indolo-1a)

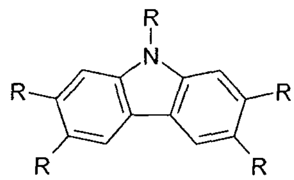

Formel (Carb-1a)

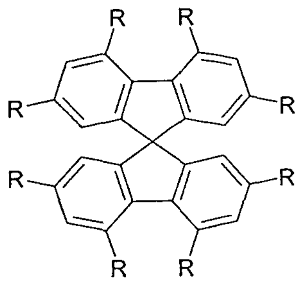

Formel (Spiro-1a)

wobei die verwendeten Symbole die oben genannten Bedeutungen aufweisen. Dabei enthalten diese Gruppen statt einem der Reste R, der an ein Kohlenstoffatom oder ein Stickstoffatom gebunden ist, eine Bindung zu der Pyrimidin- bzw. Triazingruppe bzw. zu der verbrückenden Gruppe, die wiederum an die Pyrimidin- bzw. Triazingruppe gebunden ist.

Bevorzugte verbrückende Gruppen, die die Pyrimidin- bzw. Triazingruppe mit der Indenocarbazolgruppe, der Indolocarbazolgruppe bzw. der Carbazolgruppe verknüpfen, sind ausgewählt aus bivalenten aromatischen oder heteroaromatischen Ringsystemen mit 5 bis 30 aromatischen Ringatomen, welche jeweils durch einen oder mehrere Reste R substituiert sein können. Dabei enthalten die aromatischen bzw. heteroaromatischen Ringsysteme bevorzugt keine kondensierten Aryl- bzw. Heteroarylgruppen, in denen mehr als zwei aromatische Sechsringe direkt aneinander ankondensiert sind. Besonders bevorzugt enthalten sie überhaupt keine Aryl- bzw. Heteroarylgruppen, in denen aromatische Sechsringe direkt aneinander ankondensiert sind.

Bevorzugte Reste R sind die oben unter der Beschreibung der Verbindungen der Formel (1) aufgeführten Reste R.

Beispiele für geeignete elektronentransportierende Verbindungen mit einem LUMO ≤ -2.4 eV sind die in der folgenden Tabelle abgebildeten Verbindungen.

| | | |
|---|---|---|
| 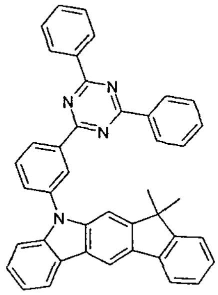 | 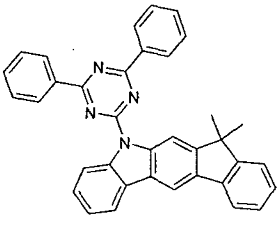 | 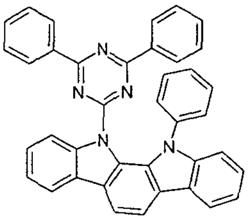 |
| 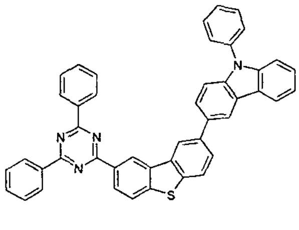 | 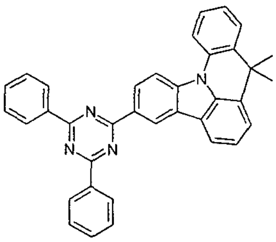 | 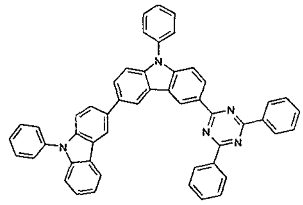 |
| 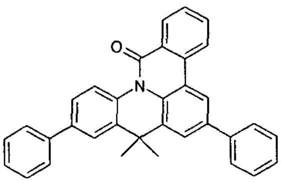 | 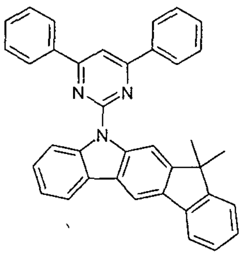 | 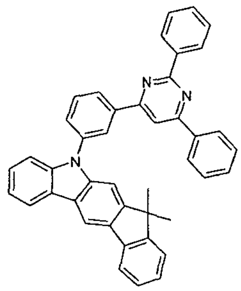 |
| 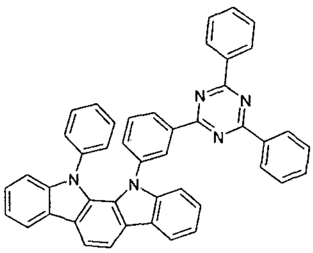 | 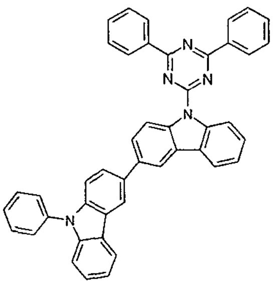 | 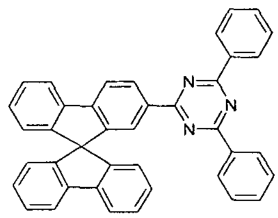 |
| 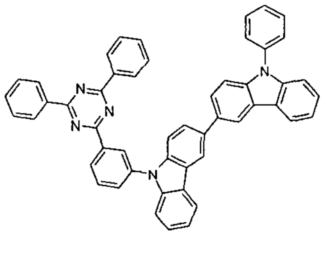 | 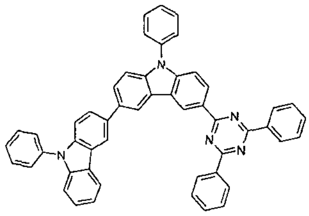 | 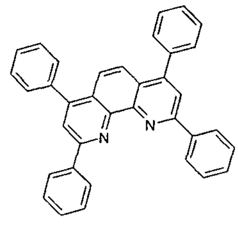 |

| | | |
|---|---|---|
| 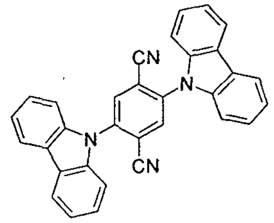 | 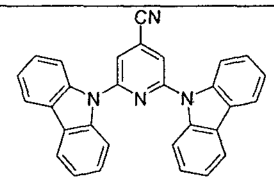 | 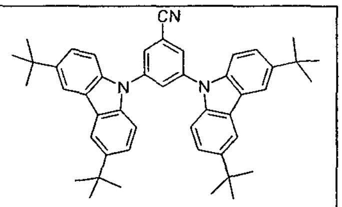 |
| 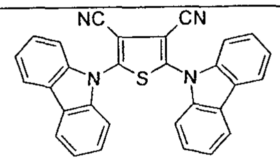 | 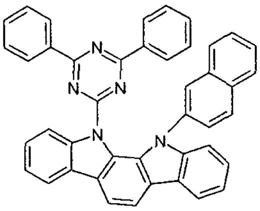 | 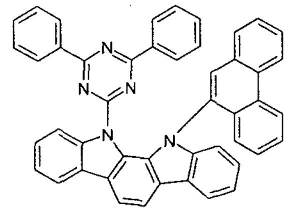 |
| 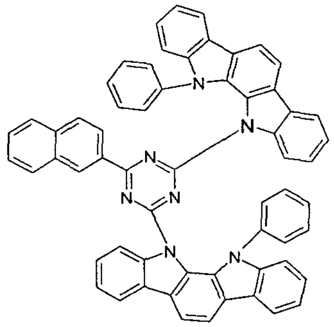 | 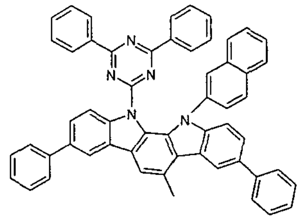 | 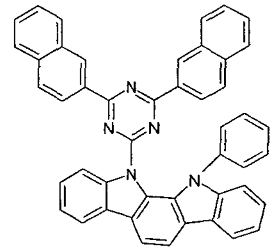 |
| 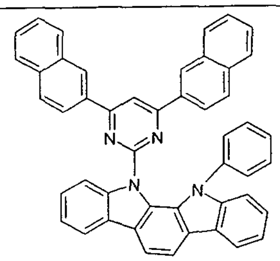 | 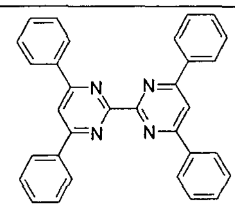 | 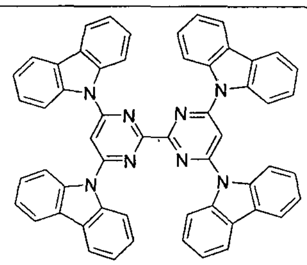 |
| 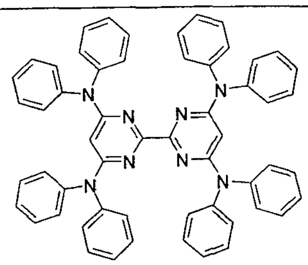 | 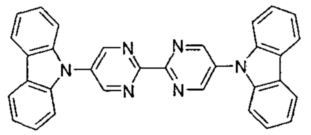 | 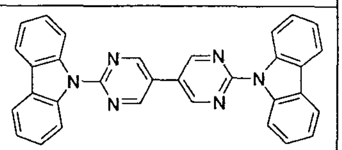 |
| 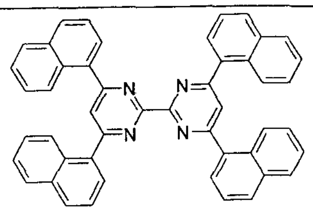 | 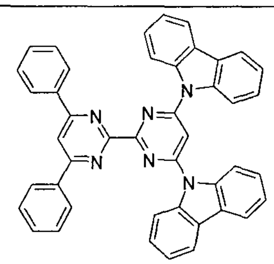 | 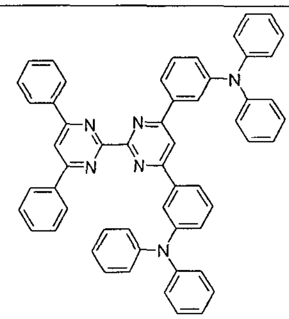 |

| | | |
|---|---|---|
| 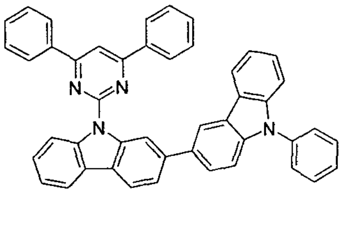 | 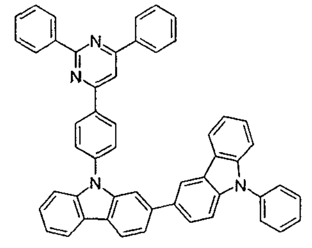 | 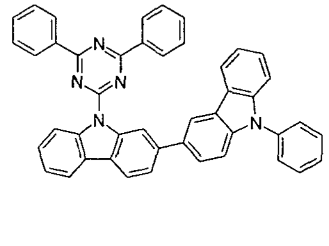 |
| 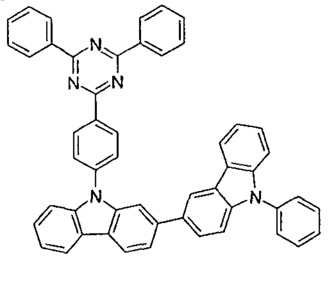 | 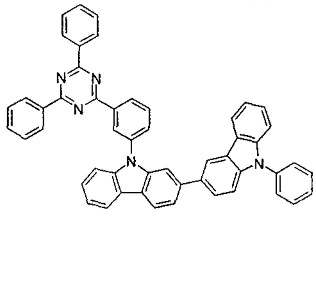 | 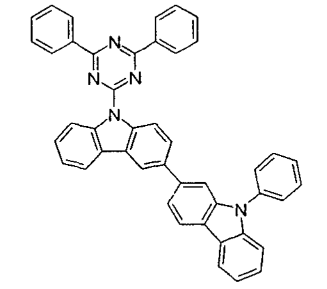 |
| 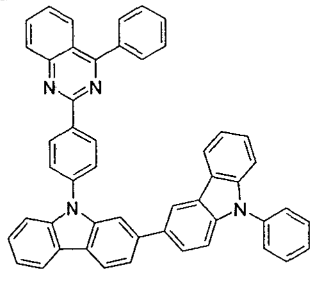 | 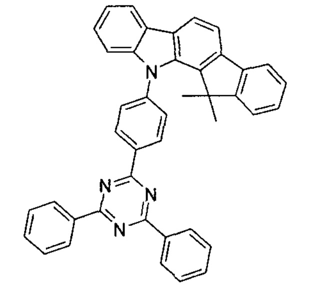 | 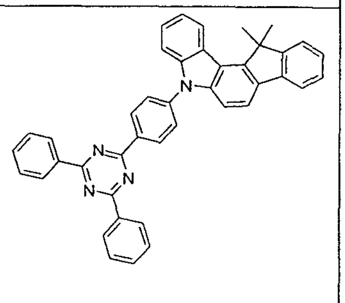 |
| 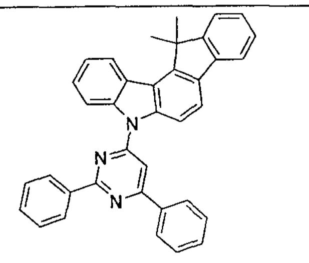 | 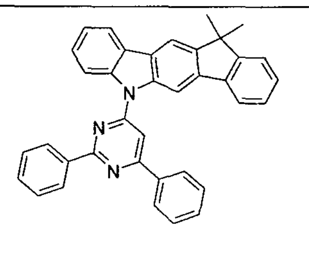 | 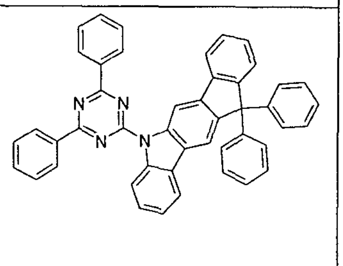 |
| 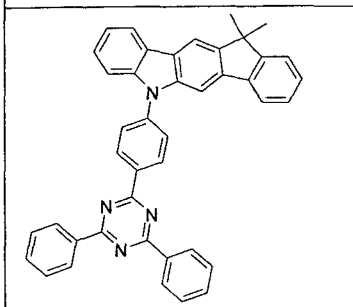 | 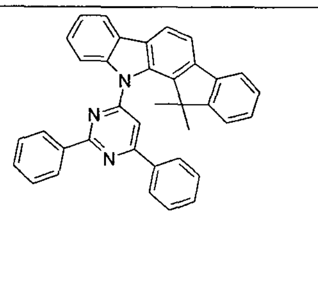 | 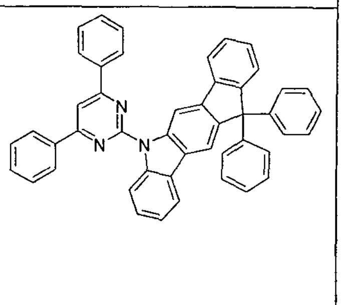 |
| 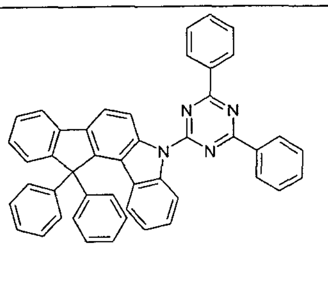 | 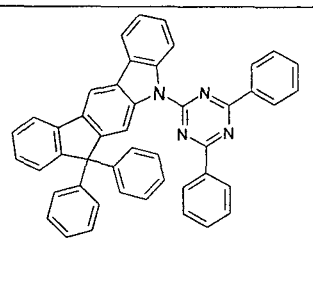 | 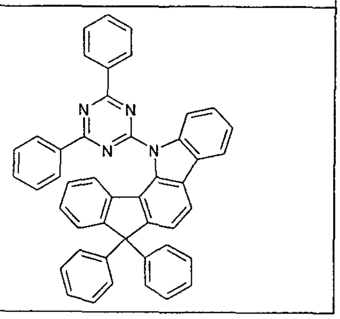 |

| | | |
|---|---|---|
| 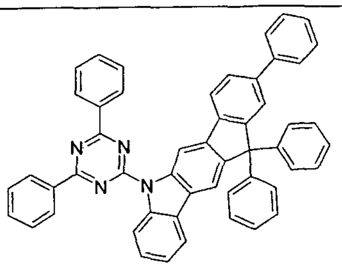 | 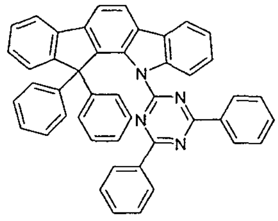 | 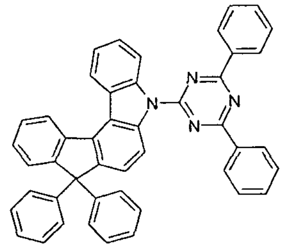 |
| 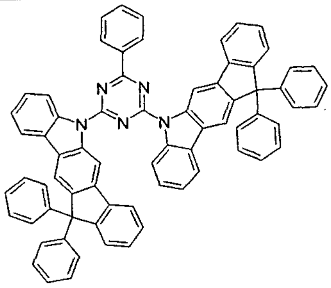 | 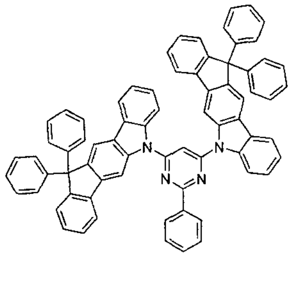 | 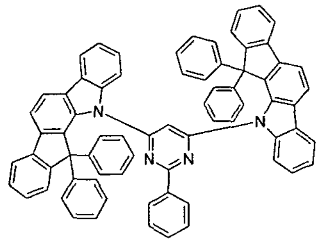 |
| 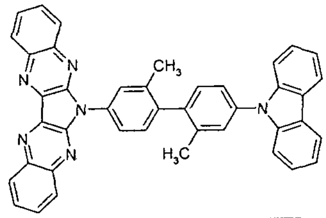 | 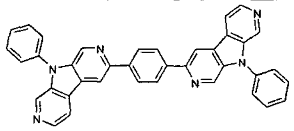 | 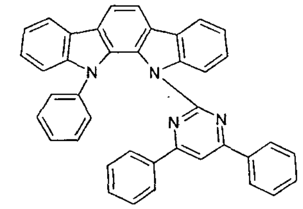 |
| 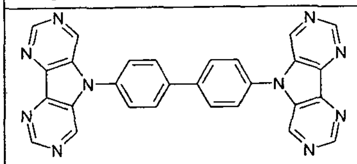 | 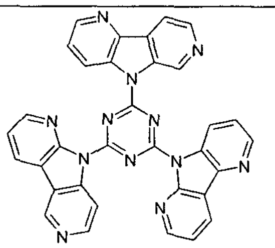 | 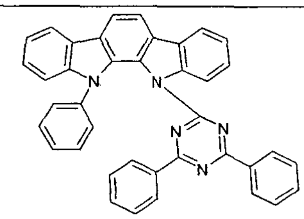 |
| 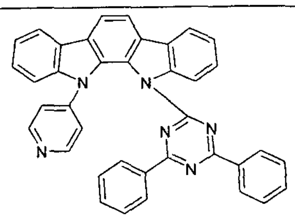 | 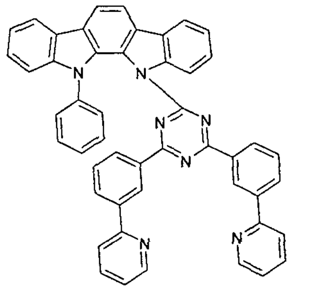 | 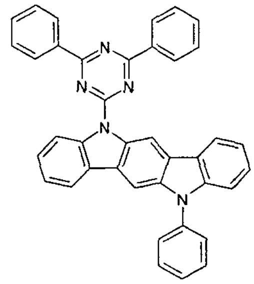 |
| 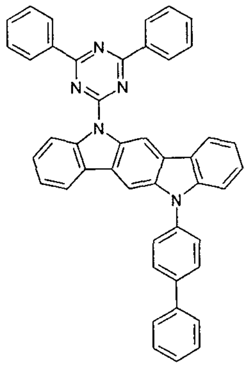 | 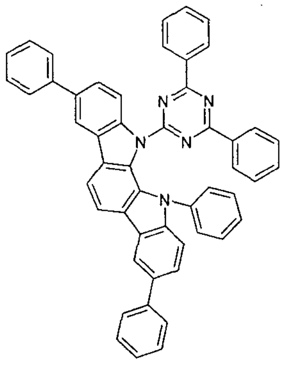 | 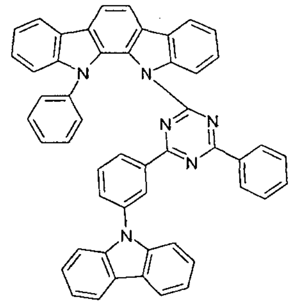 |

| | | |
|---|---|---|
| 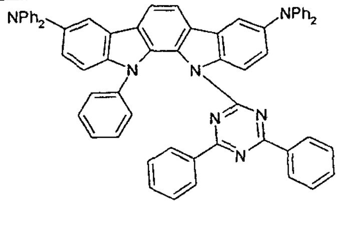 | 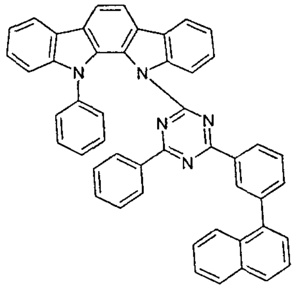 | 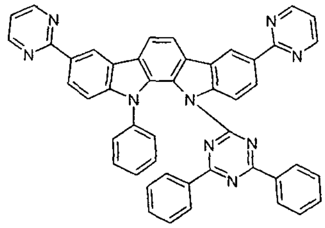 |
| 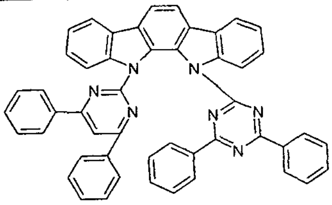 | 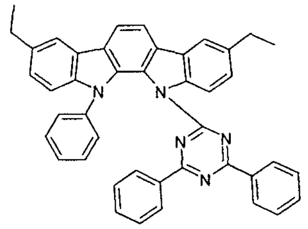 | 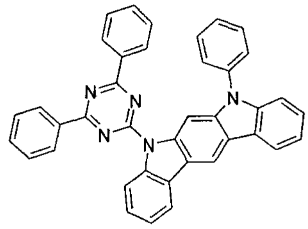 |
| 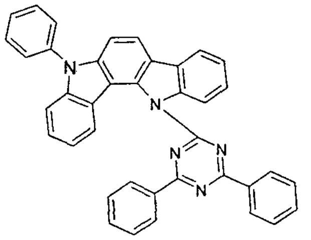 | 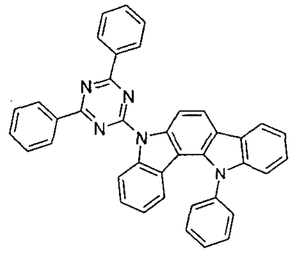 | 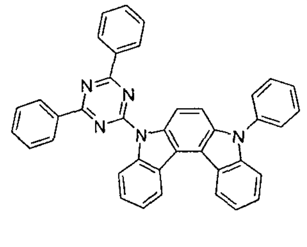 |
| 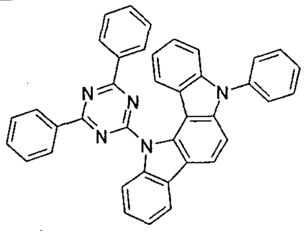 | 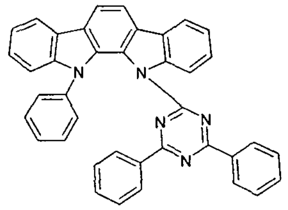 | 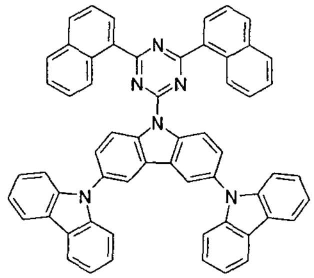 |
| 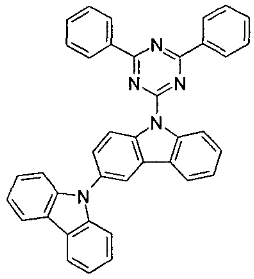 | 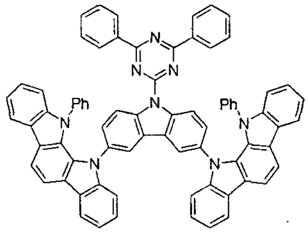 | 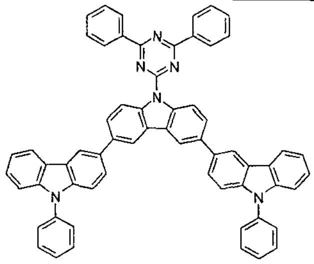 |
| 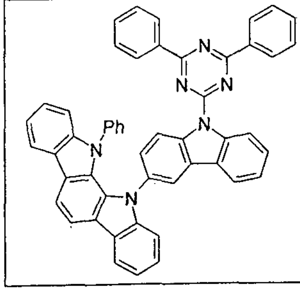 | 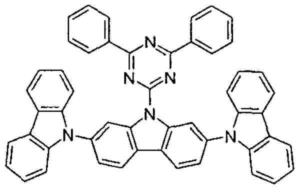 | 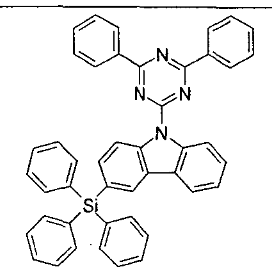 |

| | | |
|---|---|---|
| 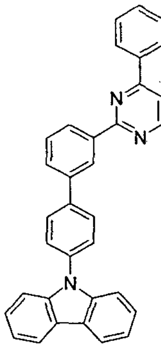 | 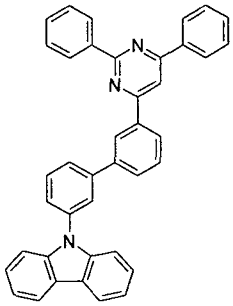 | 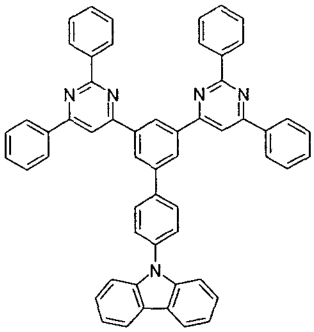 |
| 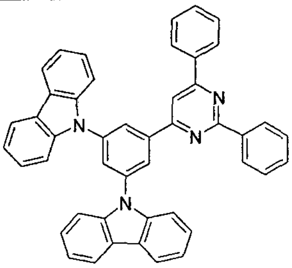 | 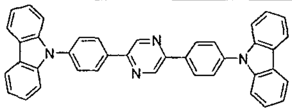 | 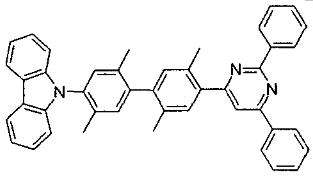 |
| 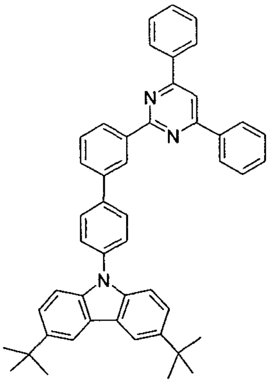 | 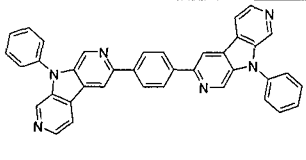 | 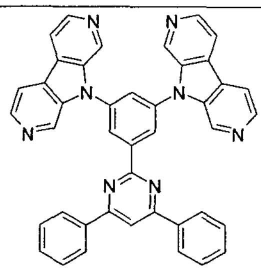 |
| 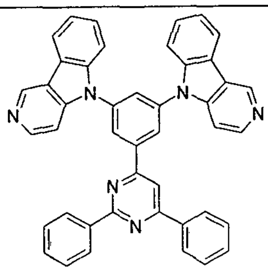 | 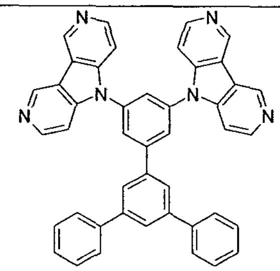 | 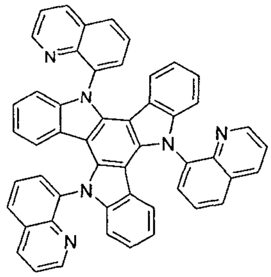 |
| 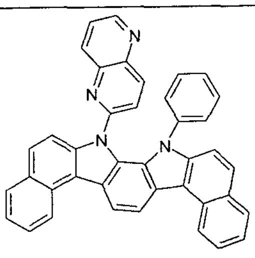 | 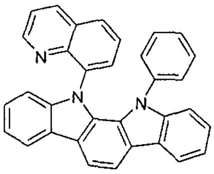 | 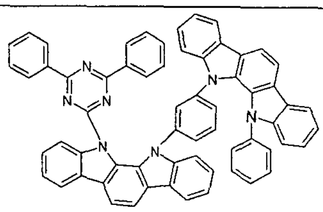 |

| | | |
|---|---|---|
| 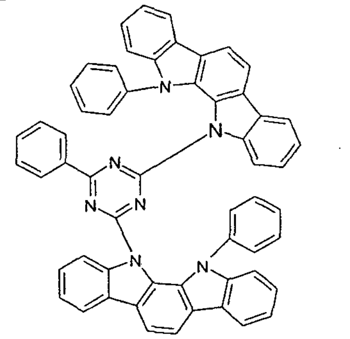 | 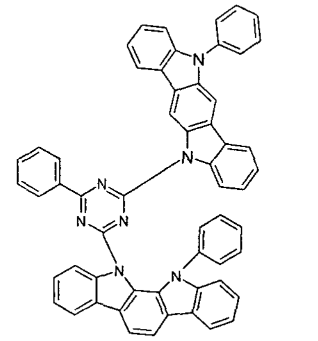 | 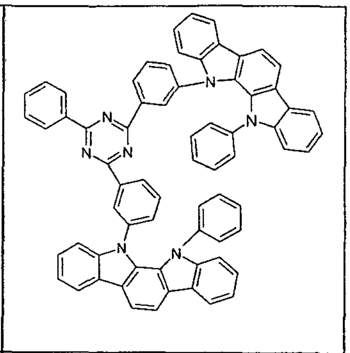 |
| 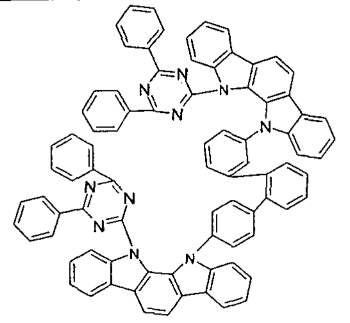 | 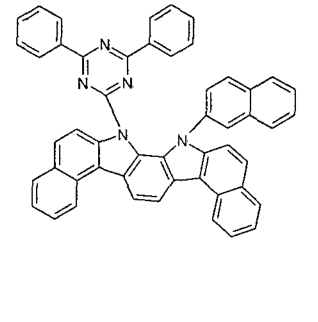 | 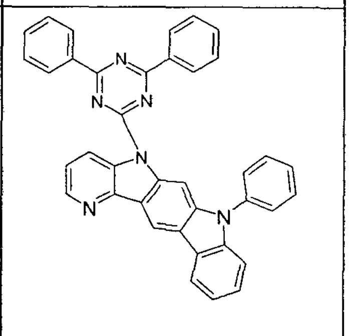 |
| 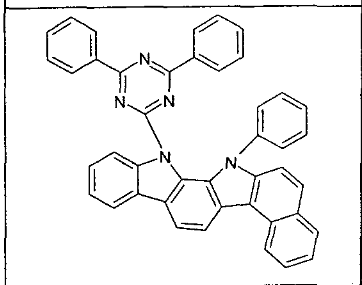 | 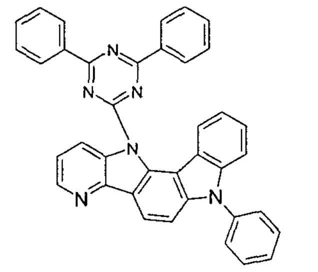 | 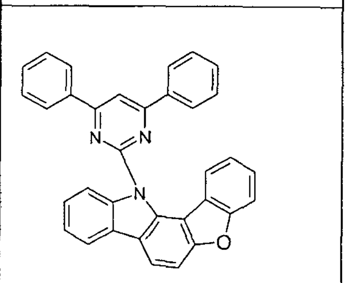 |
| 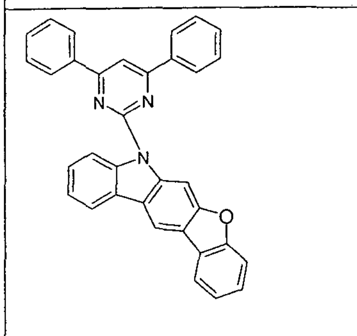 | 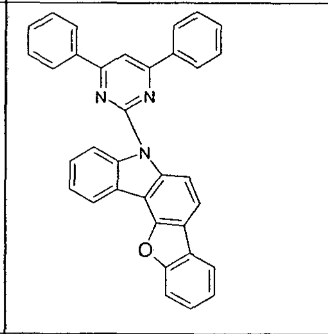 | 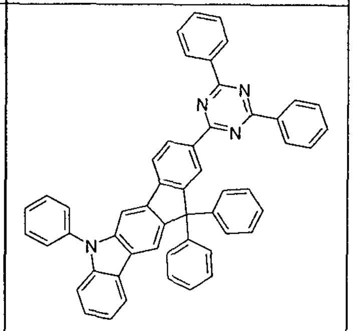 |
| 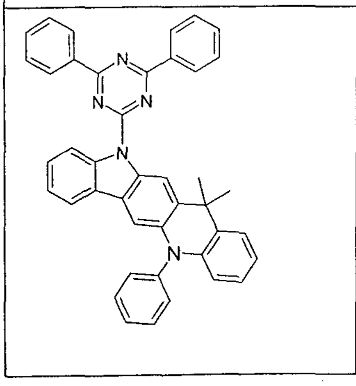 | 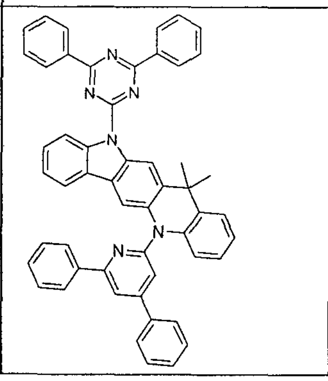 | 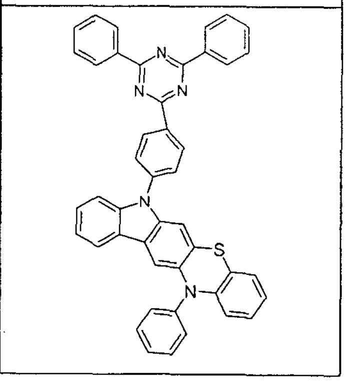 |

| | | |
|---|---|---|
| 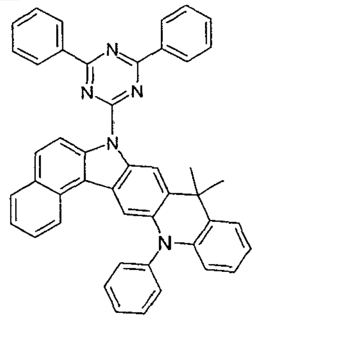 | 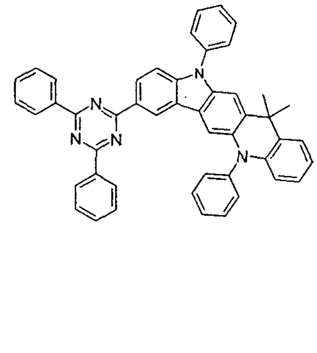 | 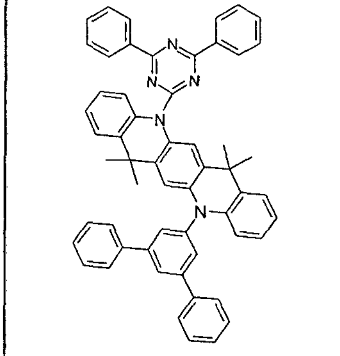 |
| 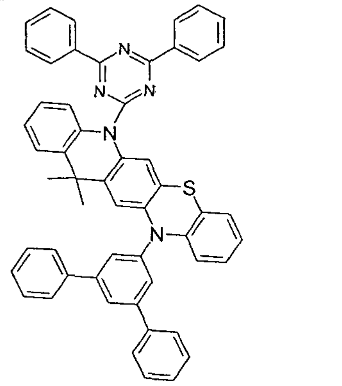 | 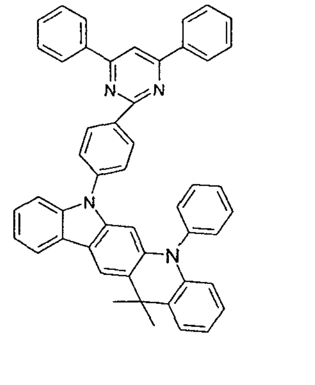 | 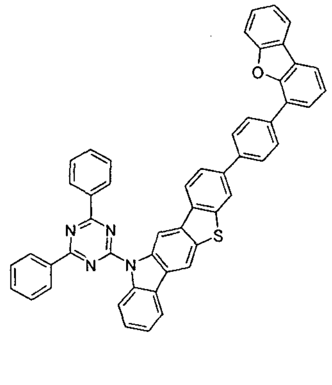 |
| 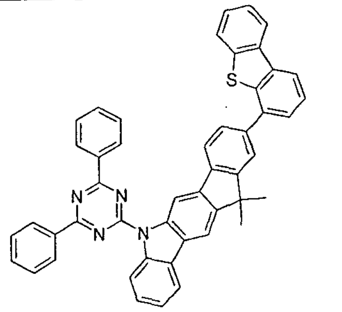 | 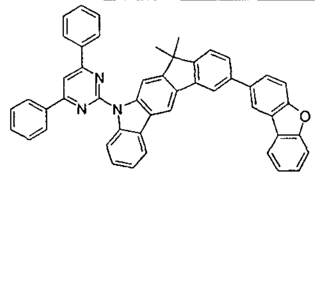 | 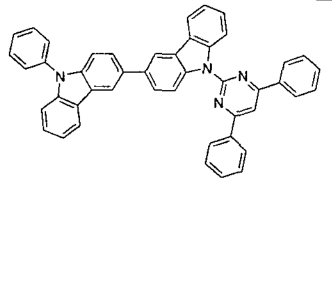 |
| 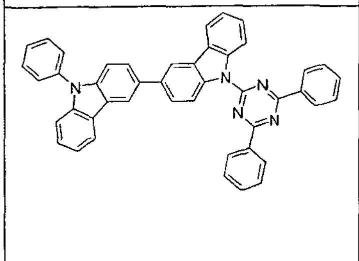 | 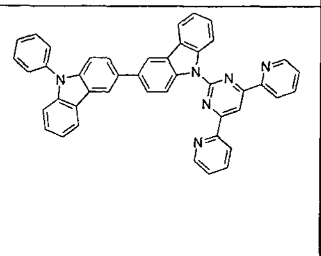 | 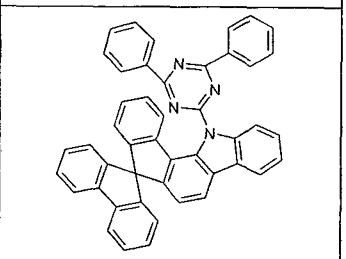 |
| 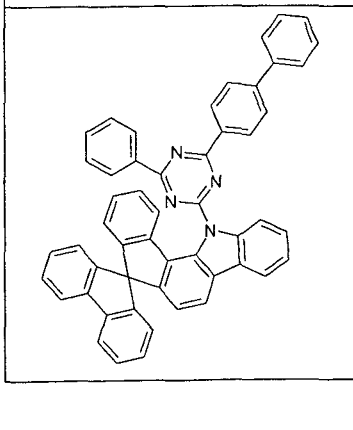 | 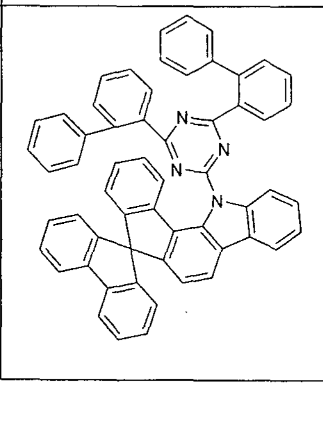 | 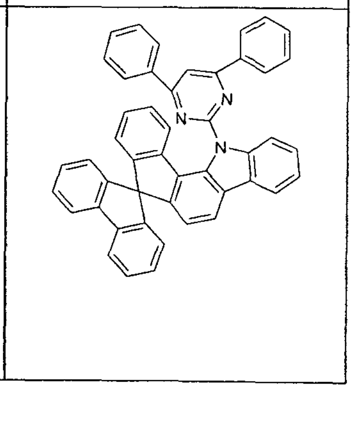 |

| | | |
|---|---|---|
| 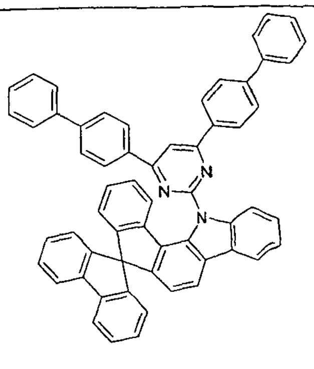 | 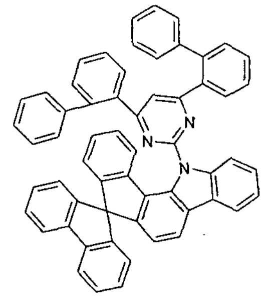 | 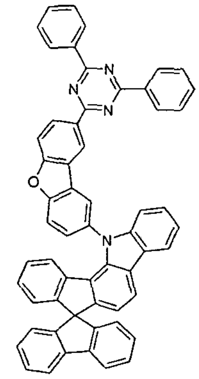 |
| 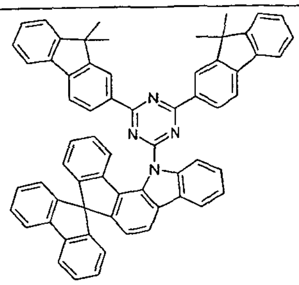 | 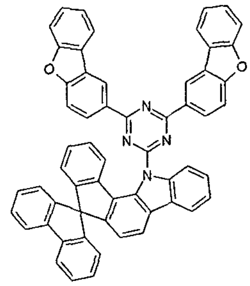 | 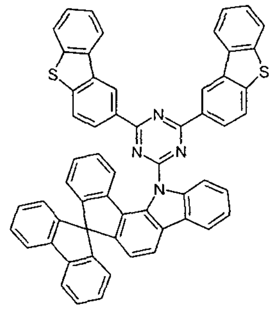 |
| 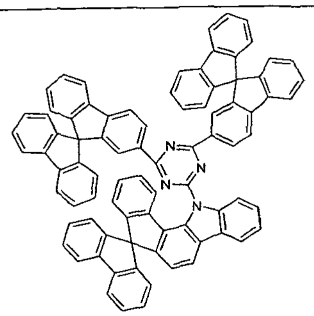 | 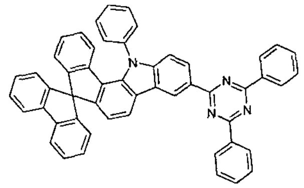 | 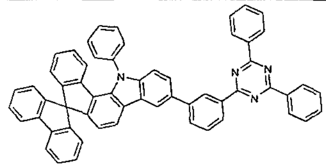 |
| 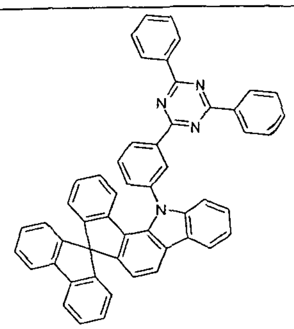 | 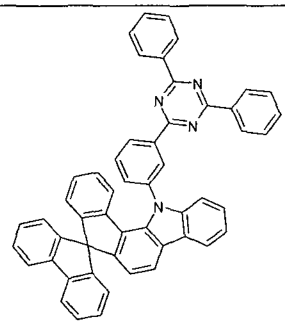 | 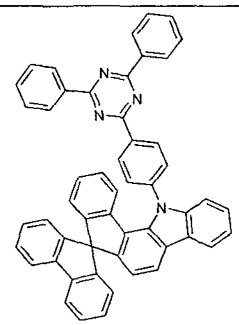 |
| 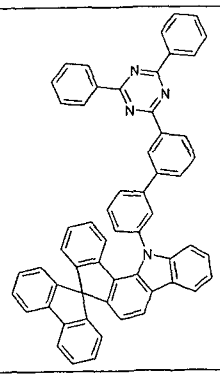 | 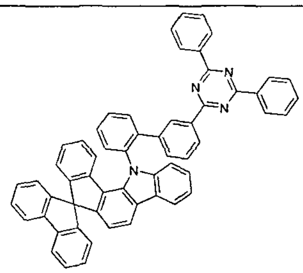 | 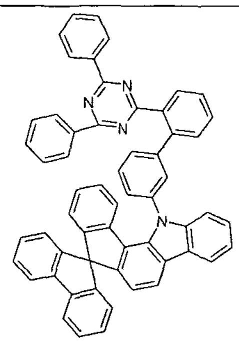 |

| | |
|---|---|
| 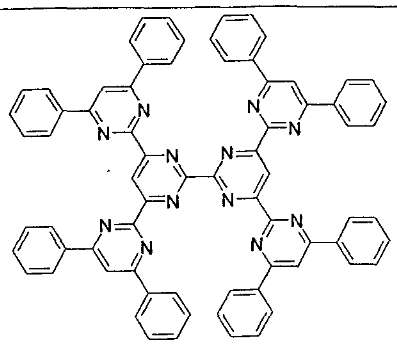 | 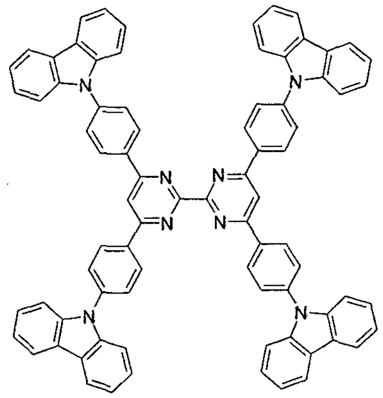 |
| 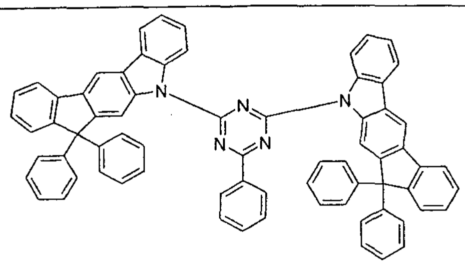 | 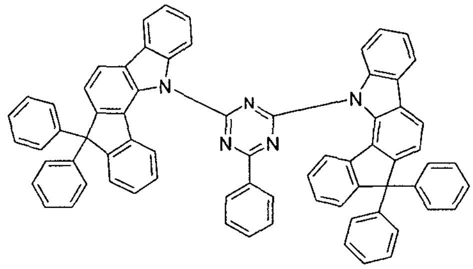 |
| 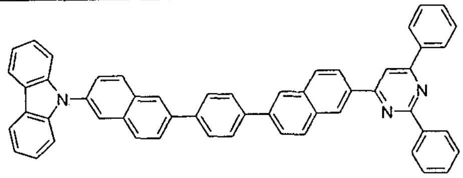 | 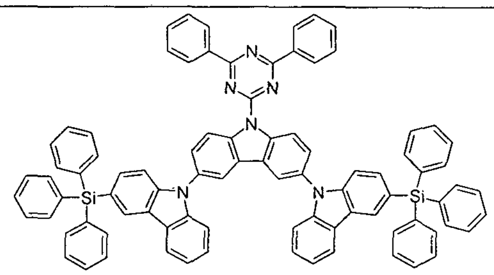 |
| 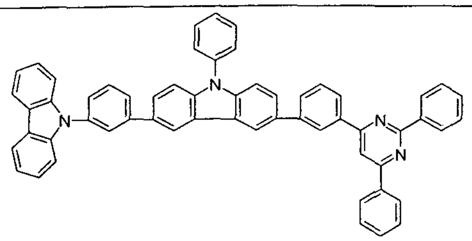 | 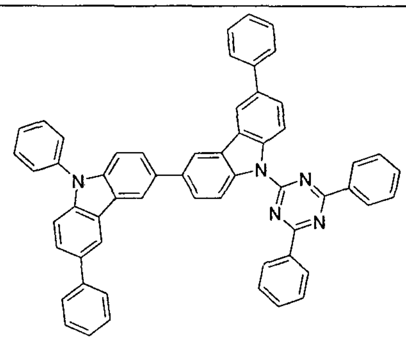 |
| 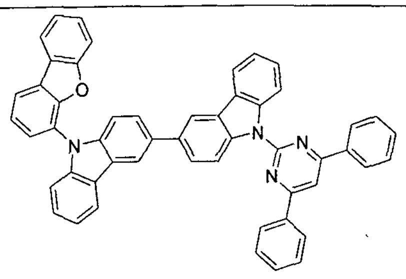 | 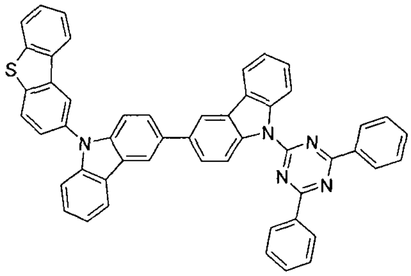 |

| | |
|---|---|
| 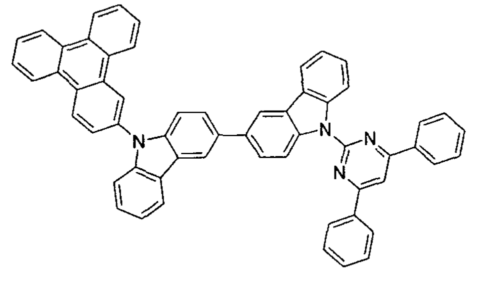 | 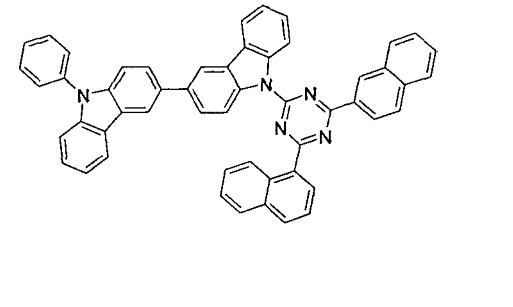 |

Im Folgenden werden bevorzugte phosphoreszierende Verbindungen beschrieben, wenn die Mischung der elektronentransportierenden Verbindung mit einem LUMO von ≤ -2.4 eV und der Verbindung der Formel (1) in einer emittierenden Schicht in Kombination mit einer phosphoreszierenden Verbindung eingesetzt wird.

Als phosphoreszierende Verbindungen (= Triplettemitter) eignen sich insbesondere Verbindungen, die bei geeigneter Anregung Licht, vorzugsweise im sichtbaren Bereich, emittieren und außerdem mindestens ein Atom der Ordnungszahl größer 20, bevorzugt größer 38 und kleiner 84, besonders bevorzugt größer 56 und kleiner 80 enthalten, insbesondere ein Metall mit dieser Ordnungszahl. Bevorzugt werden als Phosphoreszenzemitter Verbindungen, die Kupfer, Molybdän, Wolfram, Rhenium, Ruthenium, Osmium, Rhodium, Iridium, Palladium, Platin, Silber, Gold oder Europium enthalten, verwendet, insbesondere Verbindungen, die Iridium, Platin oder Kupfer enthalten.

Beispiele der oben beschriebenen Emitter können den Anmeldungen WO 00/70655, WO 2001/41512, WO 2002/02714, WO 2002/15645, EP 1191613, EP 1191612, EP 1191614, WO 2005/033244, WO 2005/019373, US 2005/0258742, WO 2010/086089, WO 2011/157339, WO 2012/007086, WO 2012/163471, WO 2013/000531 und WO 2013/020631 entnommen werden. Generell eignen sich alle phosphoreszierenden Komplexe, wie sie gemäß dem Stand der Technik für phosphoreszierende OLEDs verwendet werden und wie sie dem Fachmann auf dem Gebiet der organischen Elektrolumineszenz bekannt sind, und der Fachmann kann ohne erfinderisches Zutun weitere phosphoreszierende Komplexe verwenden.

Beispiele für geeignete phosphoreszierende Verbindungen sind in der folgenden Tabelle abgebildet.

| | | |
|---|---|---|
| 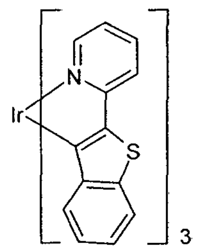 | 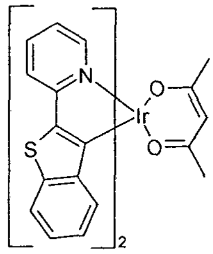 | 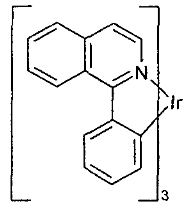 |
| 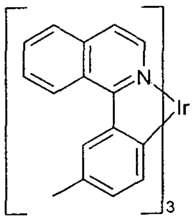 | 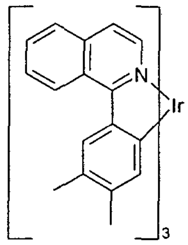 | 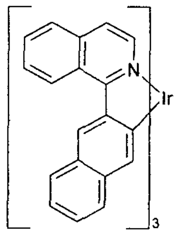 |
| 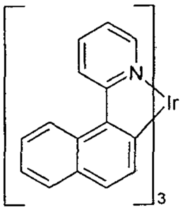 | 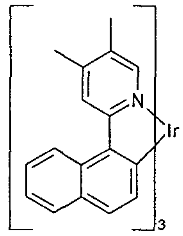 | 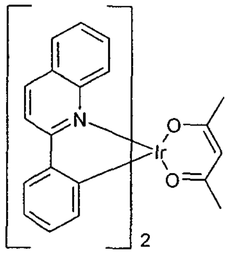 |
| 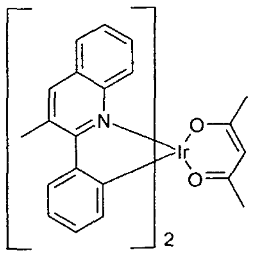 | 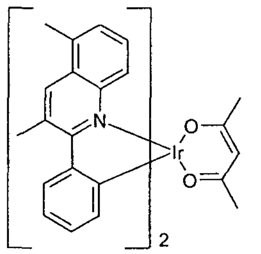 | 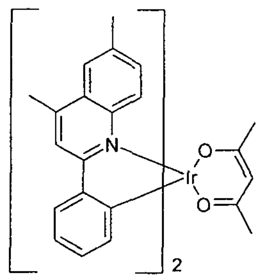 |
| 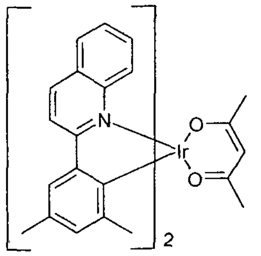 | 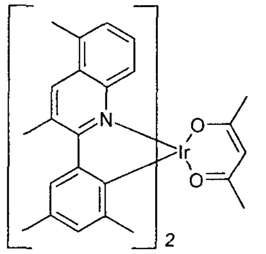 | 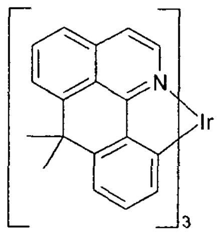 |

| | | |
|---|---|---|
| 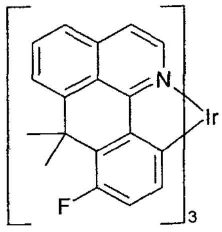 | 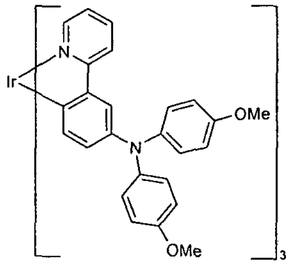 | 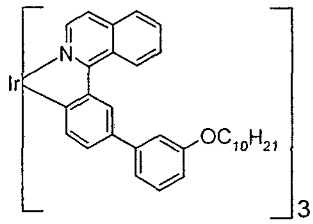 |
| 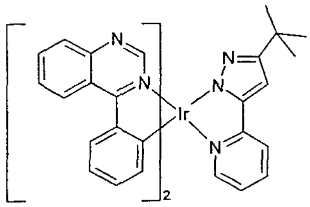 | 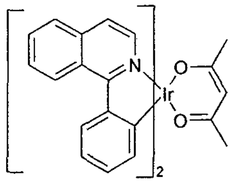 | 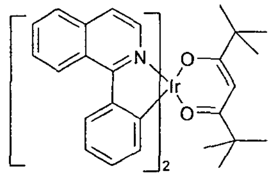 |
| 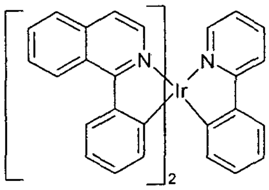 | 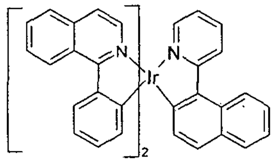 | 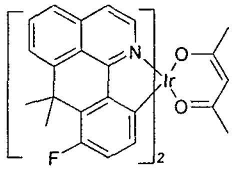 |
| 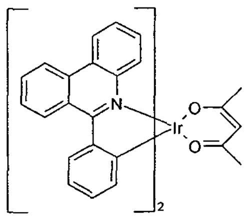 | 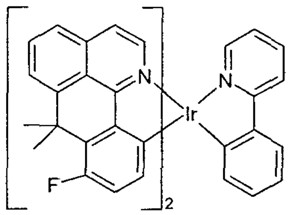 | 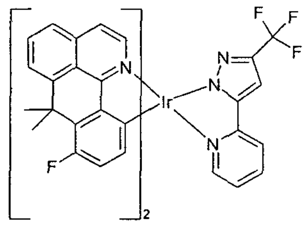 |
| 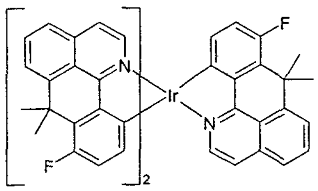 | 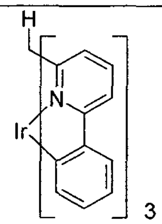 | 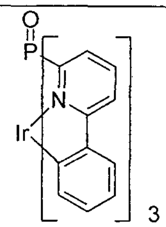 |
| 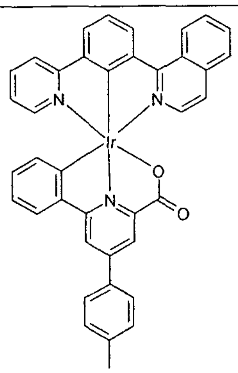 | 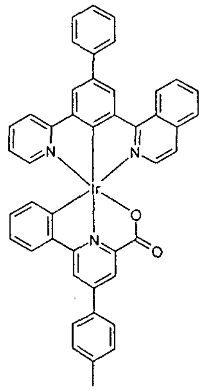 | 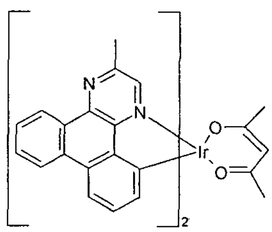 |

| | | |
|---|---|---|
| 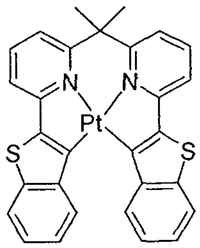 | 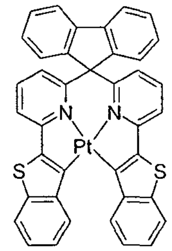 | 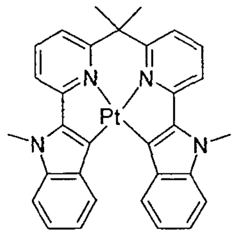 |
| 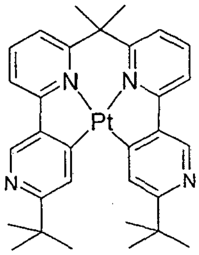 | 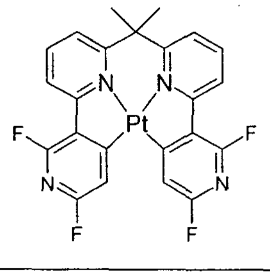 | 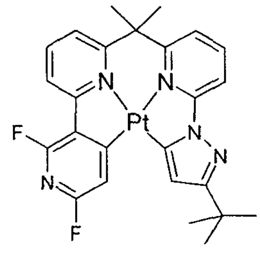 |
| 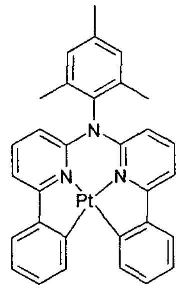 | 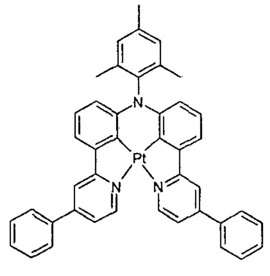 | 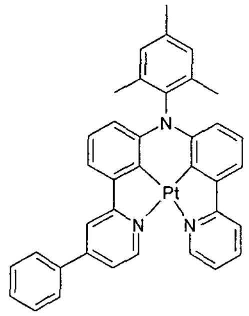 |
| 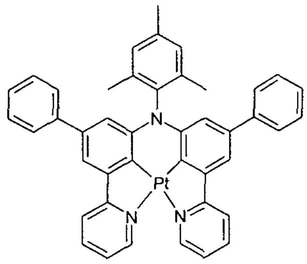 | 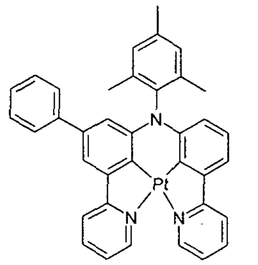 | 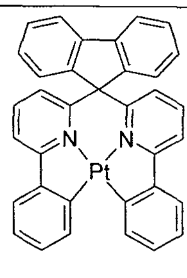 |
| 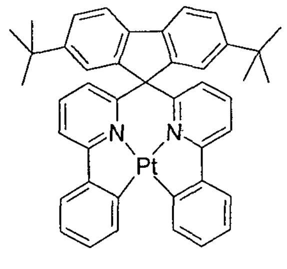 | 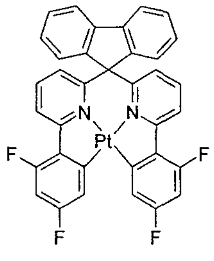 | 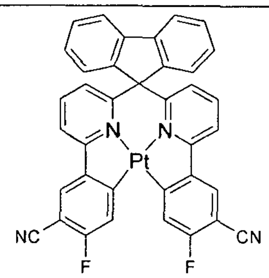 |
| 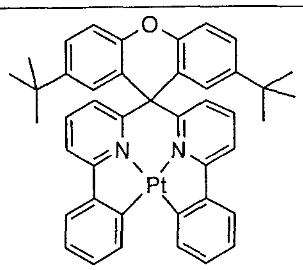 | 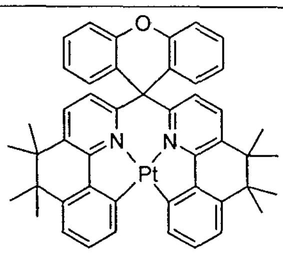 | 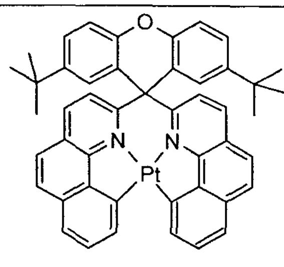 |

| | | |
|---|---|---|
| 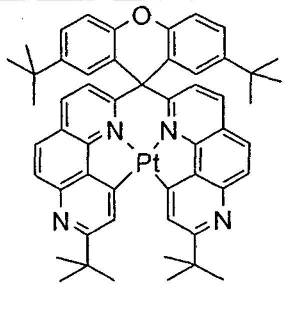 | 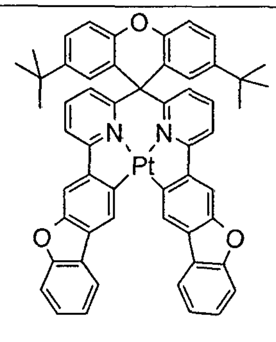 | 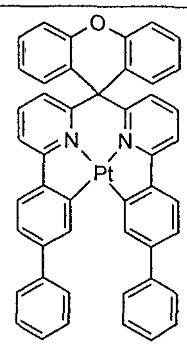 |
| 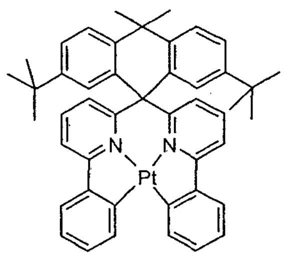 | 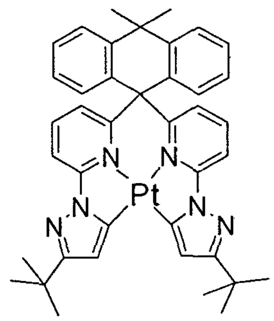 | 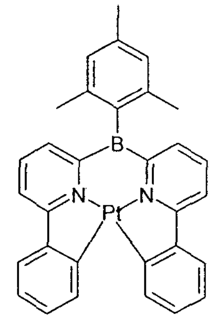 |
| 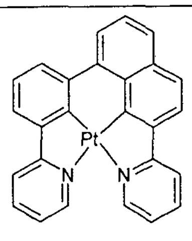 | 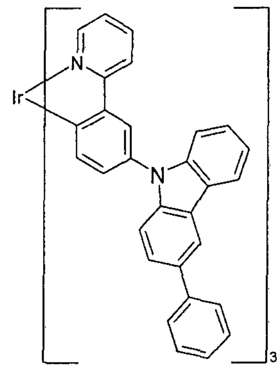 | 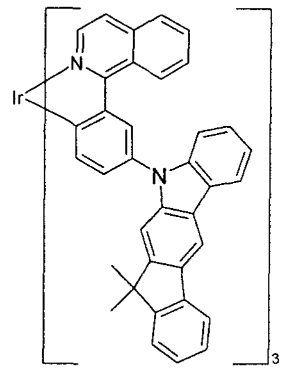 |
| 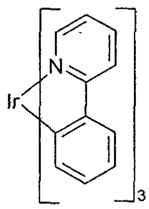 | 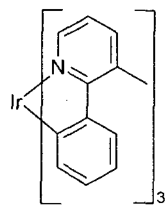 | 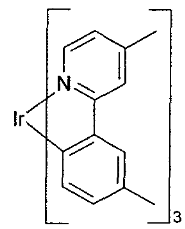 |
| 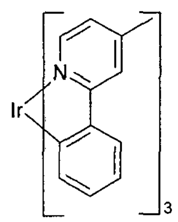 | 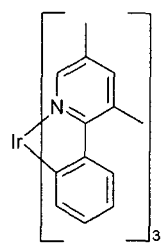 | 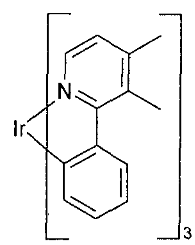 |

| | | |
|---|---|---|
| 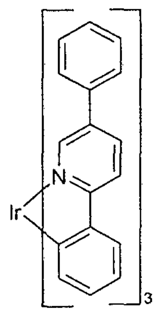 | 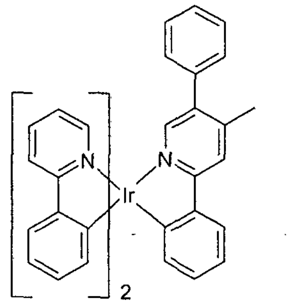 | 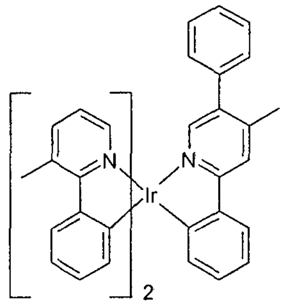 |
| 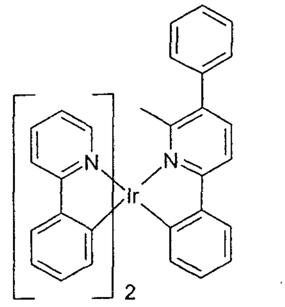 | 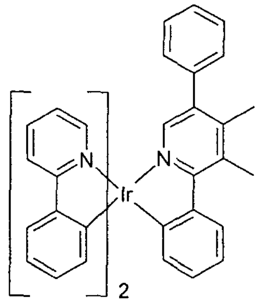 | 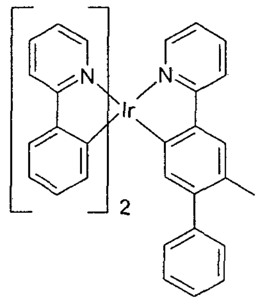 |
| 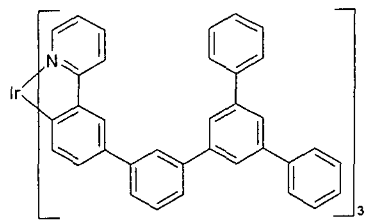 | 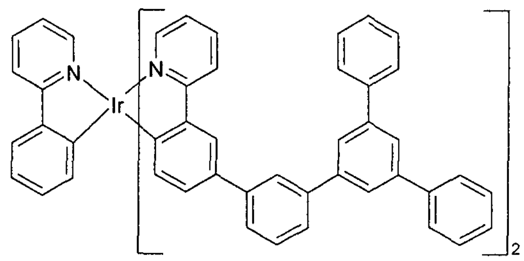 | |
| 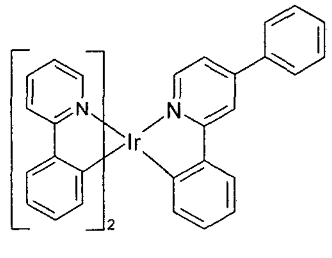 | 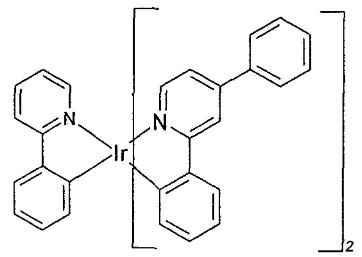 | 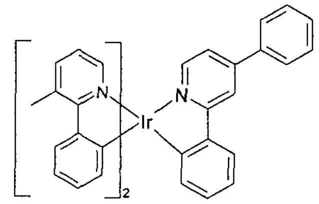 |
| 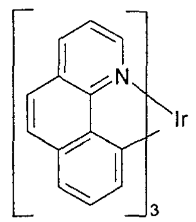 | 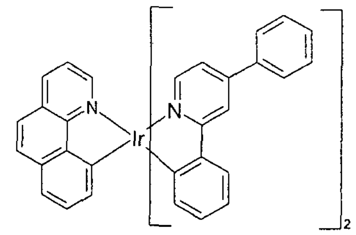 | 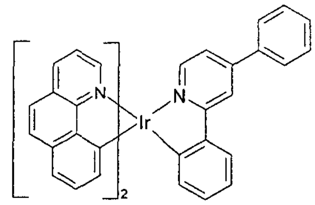 |

| | | |
|---|---|---|
| 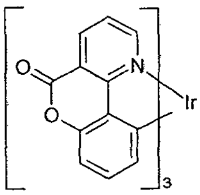 | 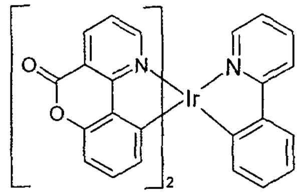 | 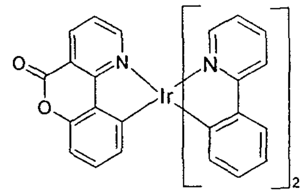 |
| 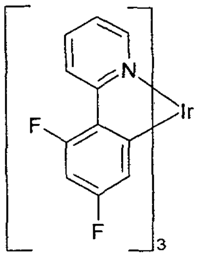 | 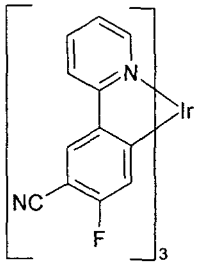 | 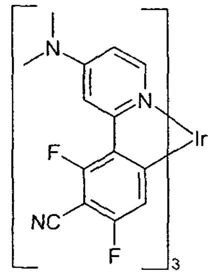 |
| 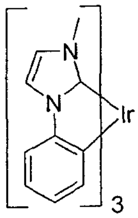 | 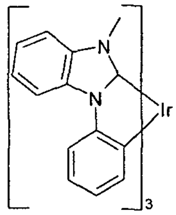 | 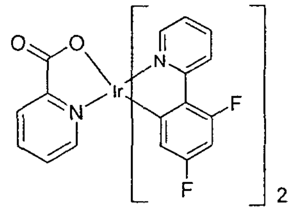 |
| 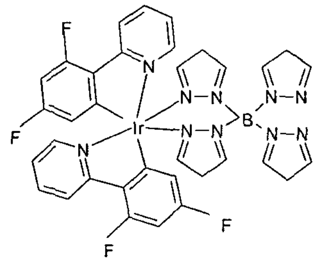 | 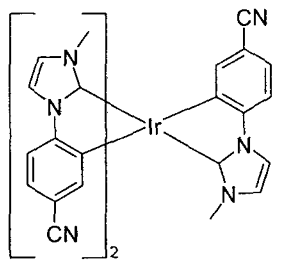 | 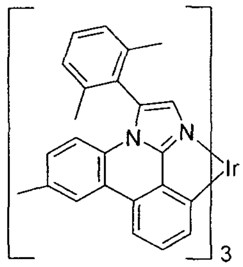 |
| 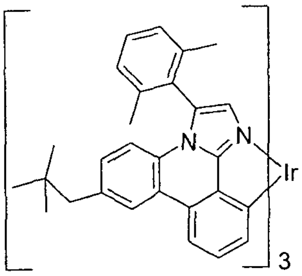 | 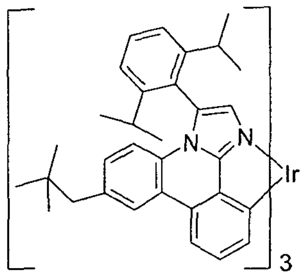 | 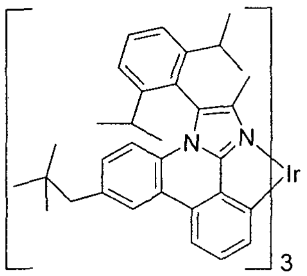 |
| 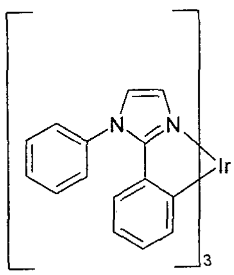 | 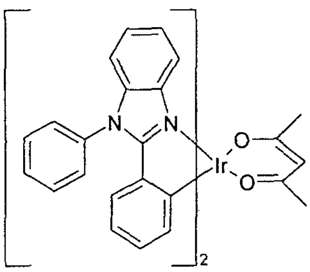 | 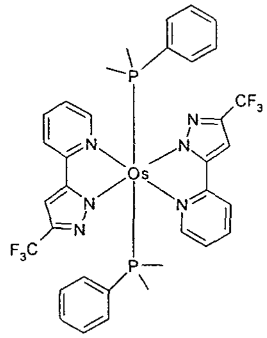 |

| | | |
|---|---|---|
| 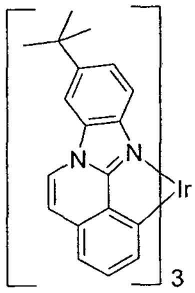 | 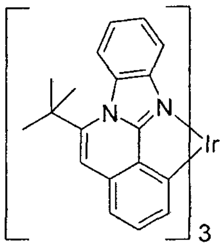 | 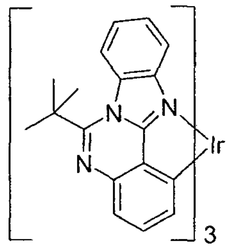 |
| 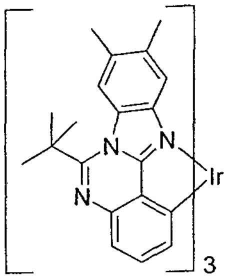 | 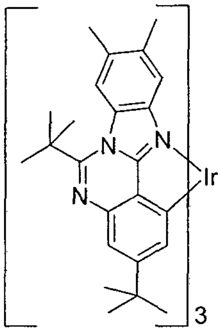 | 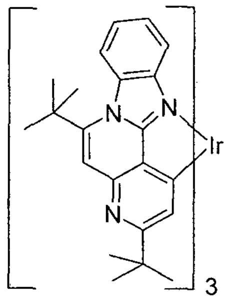 |

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten und/oder Ladungserzeugungsschichten (Charge-Generation Layers). Ebenso können zwischen zwei emittierende Schichten Interlayer eingebracht sein, welche beispielsweise eine exzitonenblockierende Funktion aufweisen. Es sei aber darauf hingewiesen, dass nicht notwendigerweise jede dieser Schichten vorhanden sein muss. Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Systeme mit drei emittierenden Schichten, wobei die drei Schichten blaue, grüne und orange oder rote Emission zeigen (für den prinzipiellen Aufbau siehe z. B. WO 2005/011013). Wenn mehr als eine emittierende Schicht vorhanden ist, dann enthält mindestens eine dieser Schichten erfindungsgemäß eine phosphoreszierende Verbindung, eine elektronentransportierende Verbindung mit einem LUMO $\leq$ -2.4 eV und eine Verbindung gemäß Formel (1) und/oder eine Elektronentransportschicht oder Elektroneninjektionsschicht enthält die elektronentransportierende Verbindung mit einem LUMO $\leq$ -2.4 eV und die Verbindung gemäß Formel (1).

In einer weiteren Ausführungsform der Erfindung enthält die erfindungsgemäße organische Elektrolumineszenzvorrichtung keine separate Lochinjektionsschicht und/oder Lochtransportschicht und/oder Lochblockierschicht und/oder Elektronentransportschicht, d. h. die emittierende Schicht grenzt direkt an die Lochinjektionschicht oder die Anode an, und/ oder die emittierende Schicht grenzt direkt an die Elektronentransportschicht oder die Elektroneninjektionsschicht oder die Kathode an, wie zum Beispiel in WO 2005/053051 beschrieben.

In den weiteren Schichten der erfindungsgemäßen organischen Elektrolumineszenzvorrichtung, insbesondere in den Lochinjektions- und -transportschichten und in den Elektroneninjektions- und -transportschichten, können alle Materialien verwendet werden, wie sie üblicherweise gemäß dem Stand der Technik eingesetzt werden. Der Fachmann kann daher ohne erfinderisches Zutun alle für organische Elektrolumineszenzvorrichtungen bekannten Materialien in Kombination mit der erfindungsgemäßen emittierenden Schicht einsetzen.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck kleiner $10^{-5}$ mbar, bevorzugt kleiner $10^{-6}$ mbar aufgedampft. Es ist aber auch möglich, dass der Anfangsdruck noch geringer ist, beispielsweise kleiner $10^{-7}$ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen $10^{-5}$ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck, LITI (Light Induced Thermal Imaging, Thermotransferdruck), Ink-Jet Druck (Tintenstrahldruck) oder Nozzle Printing, hergestellt werden. Hierfür sind lösliche Verbindungen nötig, welche beispielsweise durch geeignete Substitution erhalten werden. Diese Verfahren eignen sich insbesondere auch für Oligomere, Dendrimere und Polymere.

Weiterhin sind Hybridverfahren möglich, bei denen beispielsweise eine oder mehrere Schichten aus Lösung aufgebracht werden und eine oder mehrere weitere Schichten aufgedampft werden.

Diese Verfahren sind dem Fachmann generell bekannt und können von ihm ohne erfinderisches Zutun auf organische Elektrolumineszenzvorrichtungen enthaltend die erfindungsgemäßen Verbindungen angewandt werden.

Ein weiterer Gegenstand der vorliegenden Erfindung ist daher ein Verfahren zur Herstellung einer erfindungsgemäßen organischen Elektrolumineszenzvorrichtung, dadurch gekennzeichnet, dass mindestens eine Schicht mit einem Sublimationsverfahren aufgebracht wird und/oder dass mindestens eine Schicht mit einem OVPD (Organic Vapour Phase Deposition) Verfahren oder mit Hilfe einer Trägergassublimation aufgebracht wird und/oder dass mindestens eine Schicht aus Lösung, durch Spincoating oder mit einem Druckverfahren aufgebracht wird.

Nochmals ein weiterer Gegenstand ist eine Mischung enthaltend mindestens eine Verbindung gemäß der oben genannten Formel (1) bzw. (1a) und mindestens eine mindestens eine elektronentransportierende Verbindung, die ein LUMO $\leq$ -2.4 eV aufweist. Für die Mischung gelten dieselben Bevorzugungen, wie oben für die organische Elektrolumineszenzvorrichtung ausgeführt. Insbesondere kann es auch bevorzugt sein, wenn die Mischung weiterhin eine phosphoreszierende Verbindung enthält.

Für die Verarbeitung der erfindungsgemäßen Mischung aus flüssiger Phase, beispielsweise durch Spin-Coating oder durch Druckverfahren, sind Formulierungen der erfindungsgemäßen Verbindungen erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, $\alpha$-Terpineol, Benzothiazol, Butylbenzoat, Cumol, Cyclohexanol, Cyclohexanon, Cyclohexylbenzol, Decalin, Dodecylbenzol, Ethylbenzoat, Indan, Methylbenzoat, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropyleneglycoldimethylether, Tetraethyleneglycoldimethylether, 2-Isopropyfnaphthalin, Pentylbenzol, Hexylbenzol, Heptylbenzol, Octylbenzol, 1,1-Bis(3,4-dimethylphenyl)ethan oder Mischungen dieser Lösemittel.

Ein weiterer Gegenstand der vorliegenden Erfindung ist daher eine Formulierung, insbesondere eine Lösung oder Dispersion, enthaltend eine erfindungsgemäße Mischung und mindestens ein Lösemittel.

Die erfindungsgemäßen organischen Elektrolumineszenzvorrichtungen zeichnen sich durch folgende überraschende Vorteile gegenüber dem Stand der Technik aus:

1. Die erfindungsgemäßen organischen Elektrolumineszenzvorrichtungen weisen eine sehr gute Lebensdauer auf. Dabei ist die Lebensdauer höher im Vergleich zu Elektrolumineszenzvorrichtungen, welche entweder nur elektronentransportierende Verbindungen mit einem LUMO $\leq$ -2.4 eV oder nur Verbindungen der Formel (1) als Matrixmaterial enthalten.

2. Die erfindungsgemäßen organischen Elektrolumineszenzvorrichtungen weisen eine sehr niedrige Betriebsspannung auf. Dabei ist die Betriebsspannung niedriger im Vergleich zu Elektrolumineszenzvorrichtungen, welche entweder nur elektronentransportierende Verbindungen mit einem LUMO $\leq$ -2.4 eV oder nur Verbindungen der Formel (1) als Matrixmaterial enthalten.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen die Erfindung im gesamten offenbarten Bereich ausführen und ohne erfinderisches Zutun weitere erfindungsgemäße organische Elektrolumineszenzvorrichtungen herstellen.

**Beispiele:**

**Bestimmung der LUMO Lagen und des Triplett-Niveaus**

Die LUMO Lagen sowie das Triplettniveau der Materialien werden über quantenchemische Rechnungen bestimmt. Hierzu wird das Programmpaket "Gaussian03W" (Gaussian Inc.) verwendet. Zur Berechnung organischer Substanzen ohne Metalle (in Tabelle 5 mit Methode "org." bezeichnet) wird zuerst eine Geometrieoptimierung mit der Methode "Ground State/Semi-empirical/Default Spin/AM1/Charge 0/Spin Singlet" durchgeführt. Im Anschluss erfolgt auf Grundlage der optimierten Geometrie eine Energierechnung. Hierbei wird die Methode "TD-SFC/DFT/Default Spin/B3PW91" mit dem Basissatz "6-31G(d)" verwendet (Charge 0, Spin Singlet). Für metallorganische Verbindungen (in Tabelle 5 mit Methode "M-org." bezeichnet) wird die Geometrie über die Methode "Ground State/ Hartree-Fock/Default Spin/LanL2MB/Charge 0/Spin Singlet" optimiert. Die Energierechnung erfolgt analog zu den organischen Substanzen, wie oben beschrieben, mit dem Unterschied, dass für das Metallatom der Basissatz "LanL2DZ" und für die Liganden der Basissatz "6-31 G(d)" verwendet wird. Aus der Energierechnung erhält man das LUMO LEh in Hartree-Einheiten. Daraus wird der anhand von Cyclovoltammetriemessungen kalibrierte LUMO-Wert in Elektronenvolt wie folgt bestimmt:

$$LUMO(eV) = ((LEh*27.212)-2.0041)/1.385$$

Dieser Wert ist im Sinne dieser Anmeldung als LUMO der Materialien anzusehen.

Das Triplettniveau $T_1$ eines Materials ist definiert als die Energie des Triplettzustands mit der niedrigsten Energie, der sich aus der quantenchemischen Rechnung ergibt.

**Synthese der nicht literaturbekannten Materialien**

**Schema 1: Synthese der Lactame**

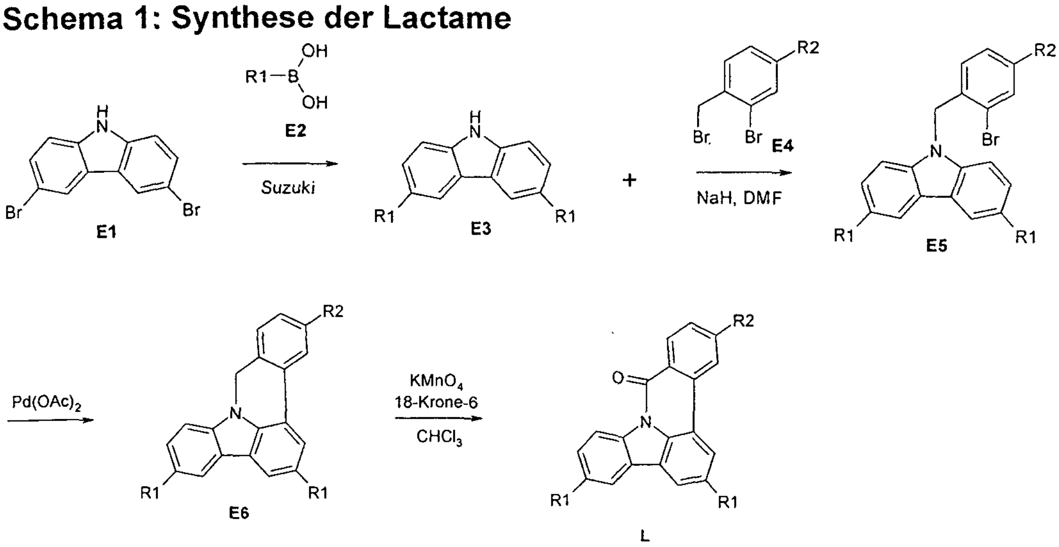


**Synthese von E3 am Beispiel L1**

In einem 4L-Vierhalskolben werden 100 g (310 mmol) 3,6-Dibromcarbazol (CAS 6825-20-3) **E1** zusammen mit 189 g (1550 mmol) Phenylboronsäure (CAS 98-80-6) **E2** und 430 g (3.1 mol) Kaliumcarbonat vorgelegt und in 1000 ml Tetrahydrofuran und 300 ml Wasser gelöst. Nach Entgasen des Gemisches für 30 Minuten werden 140 mg (0.62 mmol) Palladiumacetat und 650 mg Triphenylphosphin zugegeben und über Nacht am Rückfluss erhitzt. Anschließend wird der Ansatz mit 700 ml Wasser versetzt und die wässrige Phase mehrmals mit Dichlormethan extrahiert. Die vereinten organischen Phasen werden über Natriumsulfat getrocknet und das Lösemittelgemisch im Vakuum entfernt. Der erhaltene Rückstand wird in 1.5 L Dichlormethan gelöst und über Kieselgel filtriert. Das Lösungsmittel wird erneut im Vakuum entfernt und der Feststoff mit 600 ml Ethanol ausgerührt. Nach Filtration und Trocknung wurden 68 g (0.21 mol, 69%) des gewünschten Produkts erhalten.

| Edukt **E1** | Edukt **E2** | Produkt **E3** | Ausbeute |
|---|---|---|---|
| 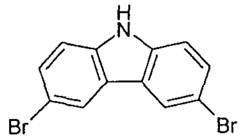 6825-20-3 | 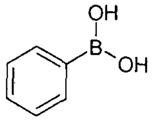 98-80-6 | 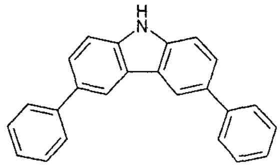 | 69% |
| 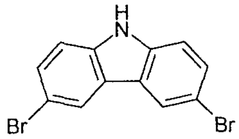 6825-20-3 | 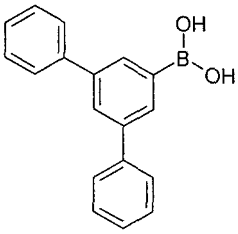 128388-54-5 | 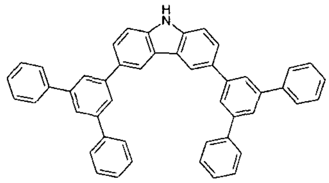 | 94% |
| 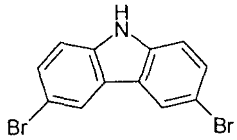 6825-20-3 | 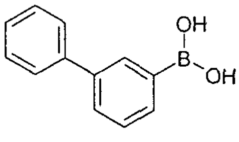 5122-95-2 | 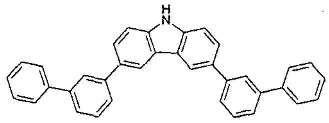 | 89% |
| 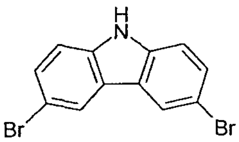 6825-20-3 | 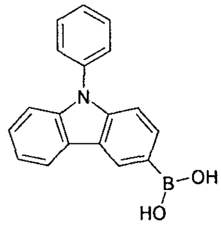 854952-58-2 | 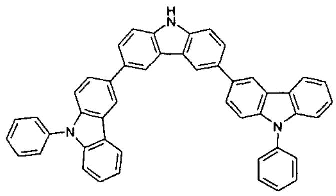 | 86% |
| 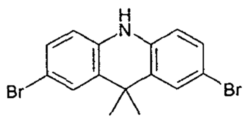 EP 11008708.7 | 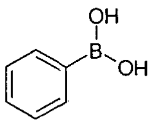 98-80-6 | 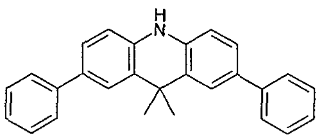 | 93% |

**Synthese von E5 am Beispiel L1**

In einem 2L-Vierhalskolben werden 100 g (313 mmol) 3,6-Diphenylcarbazol **E3** in 1 L getrocknetem DMF gelöst und unter Schutzgas und Eiskühlung portionsweise mit 24 g (610 mmol) Natriumhydrid (60% in Öl) versetzt. Anschließend werden 82 g (320 mmol) 1-Brom-2-brommethylbenzol in 360 ml DMF zugegeben und das Reaktionsgemisch über Nacht gerüht. Nach beendeter Reaktion wird 1 L Wasser zugegeben und der ausgefallene Feststoff abgesaugt. Es werden 149 g (305 mmol, 97%) des Produkts **E5** erhalten.

| Edukt **E3** | Edukt **E4** | Produkt **E5** | Ausbeute |
|---|---|---|---|
| 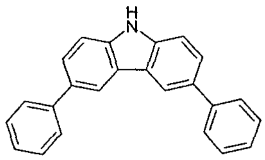 | 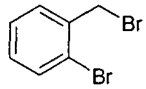 3433-80-5 | 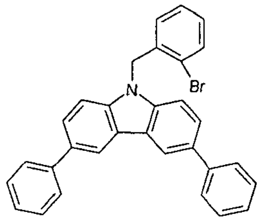 | 97% |
| 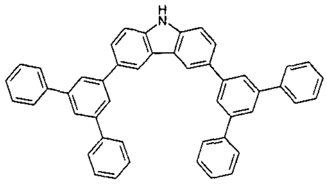 | 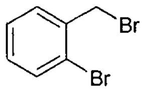 3433-80-5 | 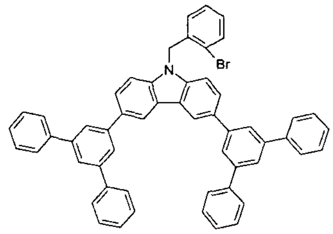 | 89% |
| 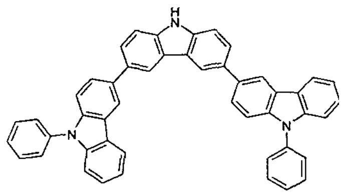 | 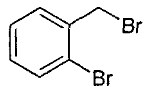 3433-80-5 | 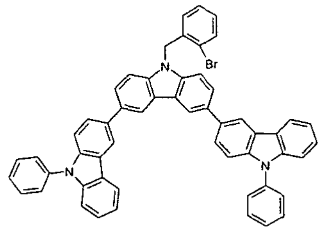 | 98% |
| 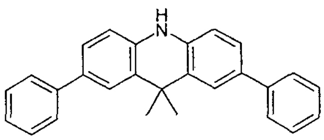 | 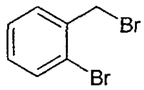 3433-80-5 | 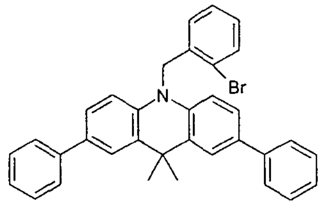 | 91% |
| 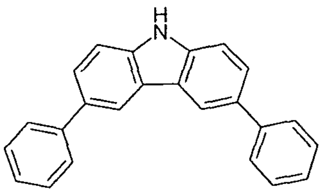 | 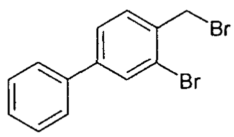 172976-02-2 | 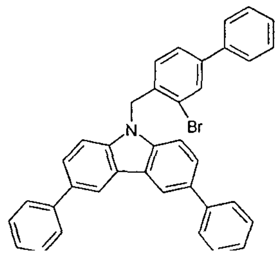 | 94% |

**Synthese von E6 am Beispiel L1**

In einem 4L-Kolben werden 149 g (305 mmol) des Eduktes **E5** zusammen mit 10 g (46 mmol) Palladiumacetat, 35 g (150 mmol) Benzyltrimethylammoniumbromid und 63 g (460 mmol) Kaliumcarbonat vorgelegt und mit 2 L DMF versetzt. Das Reaktionsgemisch wird 48 h gerührt und nach Zugabe von 1 L Wasser das entstandene Produkt gefällt. Der Rückstand wird abfiltriert und in 1.5 L Ethanol ausgerührt. Nach Trocknung im Vakuumtrockenschrank werden 125 g (304 mmol, 99%) des Produktes **E6** erhalten.

| Edukt **E5** | Produkt **E6** | Ausbeute |
|---|---|---|
| 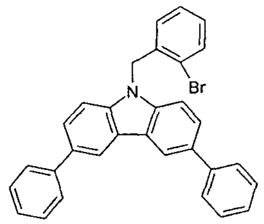 | 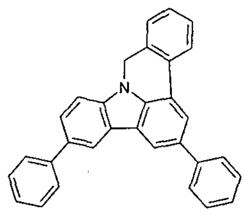 | 99% |
| 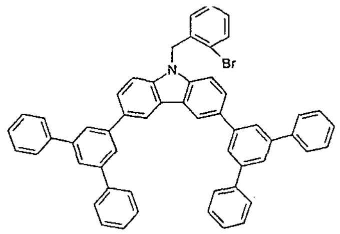 | 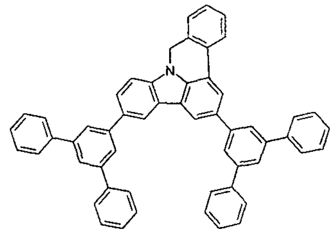 | 97% |
| 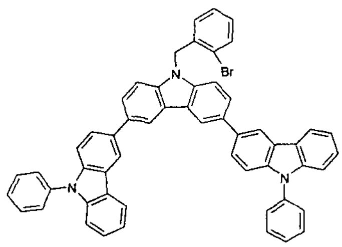 | 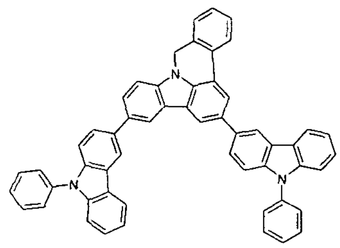 | 79% |
| 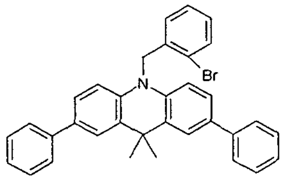 | 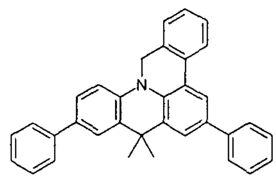 | 93% |
| 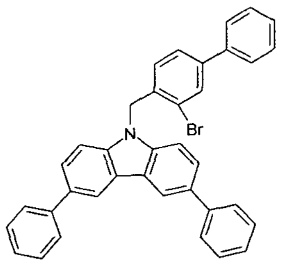 | 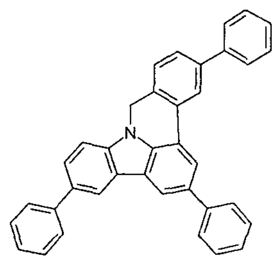 | 86% |

**Synthesebeispiel L1:**

In einem 4L-Kolben werden 124 g des Eduktes **E6** zusammen mit 430 g (2700 mmol) Kaliumpermanganat und 28 g (109 mmol) 18-Krone-6 in 3 L Chloroform gelöst und die erhaltene Suspension über Nacht am Rückfluss erhitzt. Nach beendeter Reaktion wird der erhaltene Feststoff abfiltriert und wiederholt mit Chloroform ausgewaschen. Die vereinten organischen Phasen werden mit 1 N HCl ausgewaschen und über Natriumsulfat getrocknet. Der erhaltene Feststoff wird mehrfach aus Toluol umkristallisiert bis eine Reinheit von 99.9% (mittels HPLC bestimmt) erreicht wird. Nach Sublimation werden 64 g (150 mmol, 49%) der Zielverbindung **L1** erhalten.

| Edukt **E6** | Produkt **L** | Ausbeute |
|---|---|---|
| 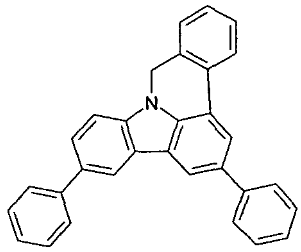 | 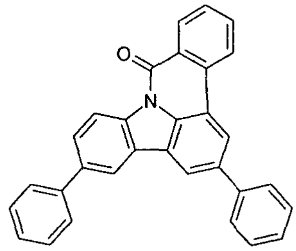<br>**L1** | 49% |
| 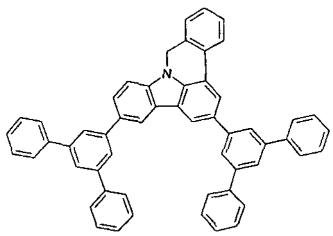 | 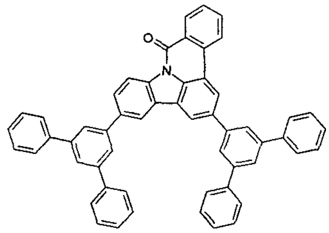<br>**L3** | 36% |
| 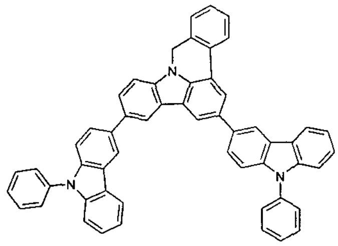 | 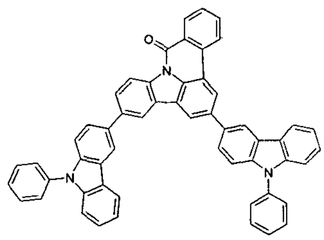<br>**L4** | 56% |
| 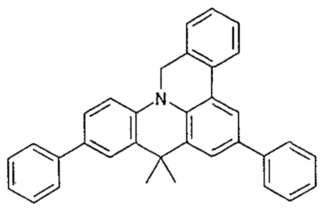 | 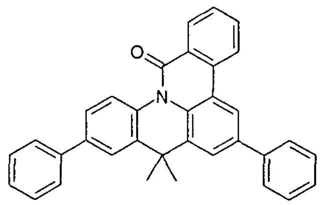<br>**CRL1** | 44% |
| 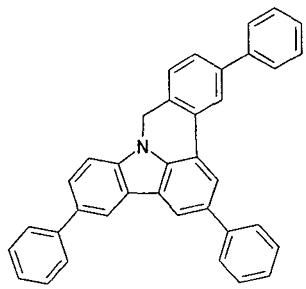 | 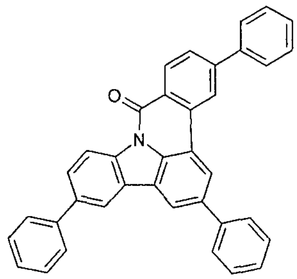 | 57% |

**Synthesebeispiel L8 und L9:**

**A) 9-(2-Brom-benzyl)-3,6-diphenyl-9H-carbazol**

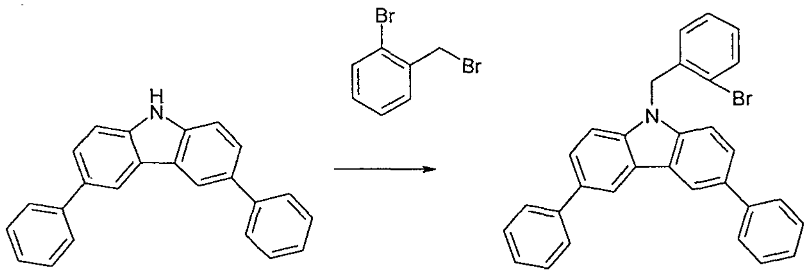

[56525-79-2]

9.7 g (224 mmol) NaH (60 %ig in Mineralöl) werden in 1000 mL THF unter Schutzgasatmosphäre gelöst. 60 g (50mmol) 3,6-Diphenyl-9H-carbazol und 11.5 g (52.5 mmol) 15-Krone-5, gelöst in 200 ml THF, werden zugegeben. Nach 1 h bei Raumtemperatur wird eine Lösung von 61 g (224 mmol) 2-Brombenzoylbromid in 250 mL THF zugetropft. Das Reaktionsgemisch wird 18 h bei Raumtemperatur gerührt. Nach dieser Zeit wird das Reaktionsgemisch auf Eis gegossen und dreimal mit Dichlormethan extrahiert. Die vereinigten organischen Phasen werden über $Na_2SO_4$ getrocknet und eingeengt. Der Rückstand wird mit Toluol heiß extrahiert und aus Toluol / n-Heptan umkristallisiert. Die Ausbeute beträgt 73 g (80 %).

Analog werden folgende Verbindungen erhalten:

| Bsp. | Edukt | | Produkt | Ausbeute |
|---|---|---|---|---|
| A1 | 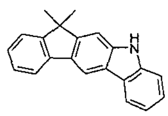 [1257220-47-5] | 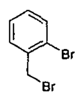 [3433-80-5] | 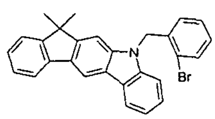 | 89% |
| A3 | 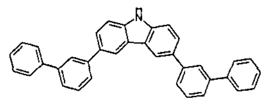 [850264-93-6] | 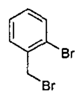 [3433-80-5] | 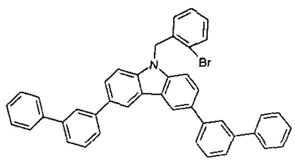 | 87% |
| A4 | 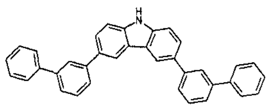 [850264-93-6] | 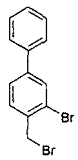 [1396865-04-5] | 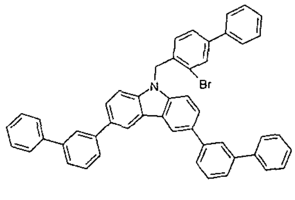 | |

**B: Cyclisierung,**

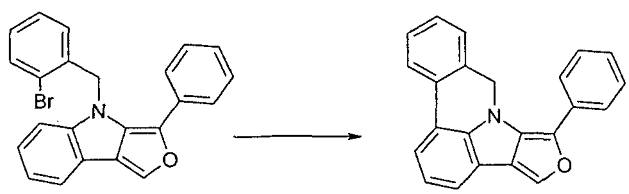

Unter Schutzgasatmosphäre werden 43 ml Tributylzinnhydrid (16 mmol) und 30 g (12.5 mmol) 1,1'-Azobis(cyclohexan-1-carbonitril) in 600 ml Toluol über eine Zeitraum von 4 h zu einer siedenden Lösung aus 5.2 g (12.5 mmol) 2-Brom-phenyl-(3-phenyl-furo[3,4-b]indol-4-yl)methanon in 600 ml Toluol getropft. Anschließend wird 3 h unter Rückfluss erhitzt. Nach dieser Zeit wird das Reaktionsgemisch auf Eis gegossen und dreimal mit Dichlormethan extrahiert. Die

vereinigten organischen Phasen werden über $Na_2SO_4$ getrocknet und eingeengt. Der Rückstand wird aus Toluol umkristallisiert. Die Ausbeute beträgt 3.1 g (76 %).

Analog werden folgende Verbindungen erhalten.

| Bsp. | Edukt 1 | Produkt 1 | Ausbeute |
|---|---|---|---|
| B1 | 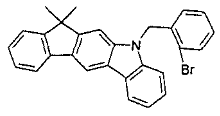 | 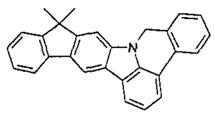 | 75% |
| B3 | 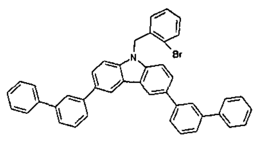 | 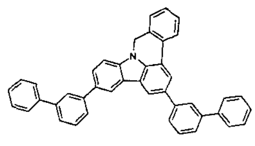 | 80% |
| B4 | 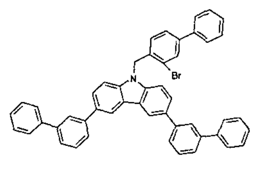 | 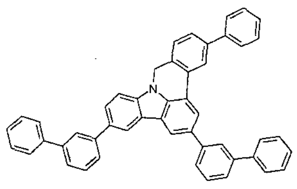 | 85% |

**C: Oxidation**

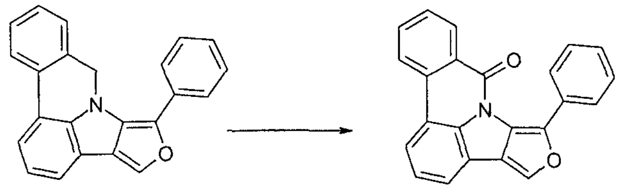

25 g (62 mmol) Benzylderivat werden in 1000 ml Dichlormethan gelöst. Anschließend werden 98 g (625 mmol) $KMnO_4$ zugegeben und 14 h bei Raumtemperatur gerührt. Nach dieser Zeit wird das das Rückstand abfiltriert, in Dichlormethan gelöst und über Kieselgel gesäult. Nach dem Einengen wird der Rückstand wird mit Toluol heiß extrahiert, aus Toluol umkristallisiert und abschließend im Hochvakuum sublimiert. Die Ausbeute beträgt nach Sublimation 20 g (59 mmol, 77 %) mit einer Reinheit von 99.9 %.

Analog werden folgende Verbindungen erhalten.

| Bsp. | Edukt 1 | Produkt 1 | Ausbeute |
|---|---|---|---|
| C1 | 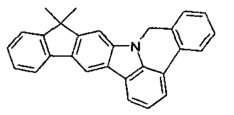 | 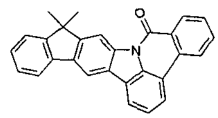 | 75% |
| C3 | 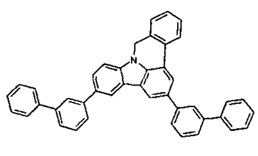 | 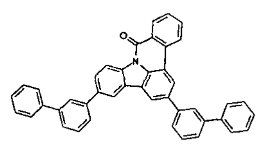 L8 | 80% |

(fortgesetzt)

| Bsp. | Edukt 1 | Produkt 1 | Ausbeute |
|---|---|---|---|
| C4 | 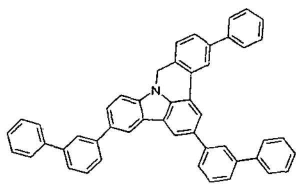 | 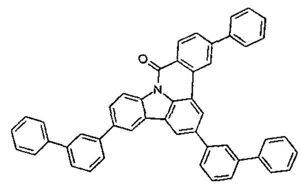 L9 | |

**Synthesebeispiel L6 and L7:**

**D: Monobromierung**

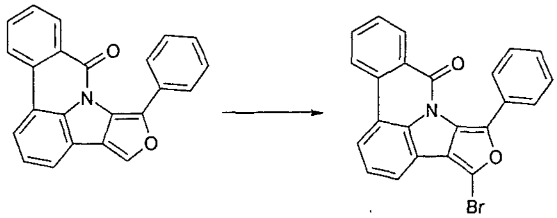

7.4 g (22.2 mmol) 3a werden in 150 mL $CH_2Cl_2$ vorgelegt. Anschließend tropft man unter Lichtausschluss bei -15 °C eine Lösung aus 4 g (22.5 mmol) NBS in 100 ml Acetonitril zu, lässt auf Raumtemperatur kommen und rührt 4 h weiter bei dieser Temperatur. Anschließend wird die Mischung mit 150 mL Wasser versetzt und mit $CH_2Cl_2$ extrahiert. Die organische Phase wird über $MgSO_4$ getrocknet und die Lösungsmittel im Vakuum entfernt. Das Produkt wird mit Hexan heiß ausgerührt und abgesaugt. Ausbeute: 7.3 g (17.7 mmol), 80 % d. Th., Reinheit nach $^1$H-NMR ca. 97 %.

Analog werden folgende Verbindungen erhalten:

| Bsp. | Edukt 1 | Produkt 1 | Ausbeute |
|---|---|---|---|
| D1 | 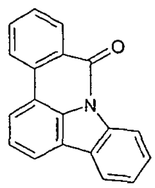 Tetrahedron (1989), 45(12), 3775-86. | 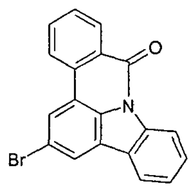 | 48% |
| D3 | 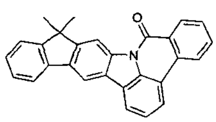 | 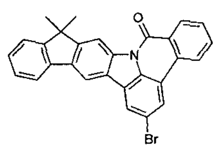 | 69% |

**C: Suzuki-Reaktion**

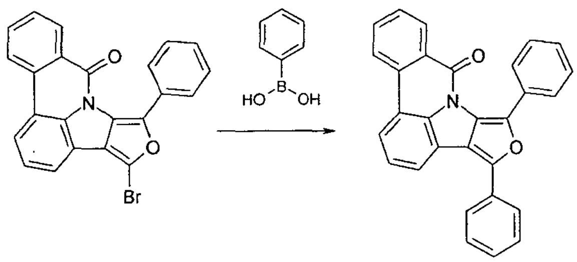

13.3 g (110.0 mmol) Phenylboronsäure, 45 g (110.0 mmol) 4a und 44.6 g (210.0 mmol) Trikaliumphosphat werden in 500 mL Toulol, 500 mL Dioxan und 500 mL Wasser suspendiert. Zu dieser Suspension werden 913 mg (3.0 mmol) Tri-o-tolylphosphin und dann 112 mg (0.5 mmol) Palladium(II)-acetat gegeben, und die Reaktionsmischung wird 16 h unter Rückfluss erhitzt. Nach Erkalten wird die organische Phase abgetrennt, über Kieselgel filtriert, dreimal mit 200 mL Wasser gewaschen und anschließend zur Trockene eingeengt. Der Rückstand wird aus Toluol und aus Dichlormethan / *iso*-Propanol umkristallisiert und abschließend im Hochvakuum sublimiert, Reinheit beträgt 99.9 %. Die Ausbeute beträgt 37 g (90 mmol), entsprechend 83 % der Theorie.

Analog werden folgende Verbindungen erhalten:

| **Bsp.** | **Edukt 1** | **Edukt 2** | **Produkt** | **Ausbeute.** |
|---|---|---|---|---|
| C1 | 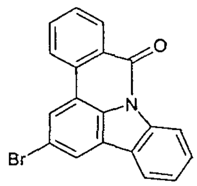 | 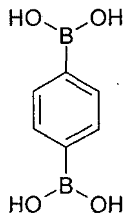 | 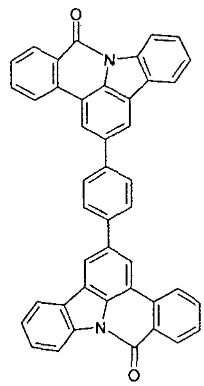 **L6** | 64 % |
| C2 | 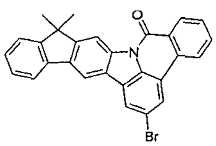 | 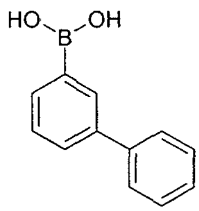 [5122-95-2] | 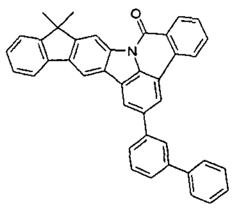 **L7** | 87% |

**Schema 2**

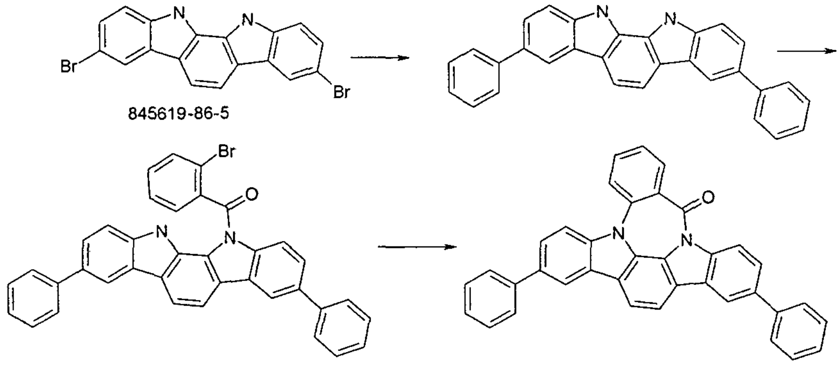

845619-86-5

L5

**1.Stufe: 3-[(Z)-1-Eth-(E)-ylidene-penta-2,4-dienyl]-8-phenyl-11,12-dihydro-11,12-diaza-indeno[2,1-a]fluoren**

13.3 g (110 mmol) Phenylboronsäure, 20 g (50 mmol) 3,8-Dibrom-11,12-dihydroindolo[2,3-a]carbazol und 45 g (210 mmol) Trikaliumphosphat werden in 500 mL Toulol, 500 mL Dioxan und 500 mL Wasser suspendiert. Zu dieser Suspension werden 910 mg (3.0 mmol) Tri-o-tolylphosphin und dann 112 mg (0.5 mmol) Palladium(II)acetat gegeben, und die Reaktionsmischung wird 16 h unter Rückfluss erhitzt. Nach Erkalten wird die organische Phase abgetrennt, über Kieselgel filtriert, dreimal mit 200 mL Wasser gewaschen und anschließend zur Trockene eingeengt. Der Rückstand wird aus Toluol und aus Dichlormethan / *iso*-Propanol umkristallisiert. Die Ausbeute beträgt 16 g (39 mmol), entsprechend 80% der Theorie.

**2.Stufe: (2-Bromphenyl)-(3,8-diphenyl-12H-11,12-diaza-indeno[2,1-a]fluoren-11-yl)-methanon**

2.1 g (53 mmol) NaH (60 %ig in Mineralöl) werden in 500 mL THF unter Schutzatmosphäre gelöst. 20 g (50 mmol) 3-[(Z)-1-Eth-(E)-ylidene-penta-2,4-dienyl]-8-phenyl-11,12-dihydro-11,12-diaza-indeno[2,1-a]fluoren und 12 g (53 mmol) 15-Krone-5 gelöst in 200 ml THF werden zugegeben. Nach 1 h bei Raumtemperatur wird eine Lösung von 12 g (55 mmol) 2-Brombenzoylchlorid in 250 mL THF zugetropft. Das Reaktionsgemisch wird 18 h bei Raumtemperatur gerührt. Nach dieser Zeit wird das Reaktionsgemisch auf Eis gegossen und dreimal mit Dichlormethan extrahiert. Die vereinigten organischen Phasen werden über $Na_2SO_4$ getrocknet und eingeengt. Der Rückstand wird mit Toluol heiß extrahiert und aus Toluol/n-Heptan umkristallisiert. Die Ausbeute beträgt 22 g (75%).

**3.Stufe Beispiel L5**

85 g (145 mmol) (2-Bromphenyl)-(3,8-diphenyl-12H-11,12-diaza-indeno-[2,1-a]fluoren-11-yl)-methanon werden mit 150 ml Di-n-butylether versetzt und die Lösung entgast. Anschließend wird die Mischung mit 10 g (158 mmol) Kupferpulver, 1.38 g (7 mmol) Kupfer(I)iodid und 22 g (160 mmol) $K_2CO_3$ versetzt und 4 Tage unter Schutzgas bei 144 °C gerührt. Die organische Phase wird über $MgSO_4$ getrocknet und das Lösungsmittel im Vakuum entfernt. Der Rückstand wird aus Aceton umkristallisiert und abschließend im Hochvakuum sublimiert. Ausbeute: 63 g (124 mmol), 86% d. Th., Reinheit nach HPLC 99.9 %.

**Synthese der nicht literaturbekannten Triazinderivate IC4 und IC5**

**Vorstufe: (2-Chlorphenyl)-4-spiro-9,9'-bifluorenyl-amin**

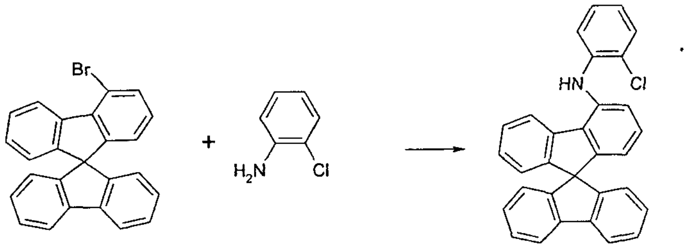

54 g (137 mmol) 4-Bromspiro-9,9'-bifluoren, 17.9 g (140 mmol) 2-Chloranilin, 68.2 g (710 mmol) Natrium-tert-butylat, 613 mg (3 mmol) Palladium-(II)acetat und 3.03 g (5 mmol) dppf werden in 1.3 L Toluol gelöst und 5 h unter Rückfluss gerührt. Das Reaktionsgemisch wird auf Raumtemperatur abgekühlt, mit Toluol erweitert und über Celite filtriert. Das Filtrat wird im Vakuum eingeengt und der Rückstand aus Toluol/Heptan kristallisiert. Das Produkt wird als farbloser Feststoff isoliert. Ausbeute: 52.2 g (118 mmol) 86% d.Th..

**Vorstufe: Spiro[9*H*-fluoren-9,7'(1'*H*)-indeno[1,2-a]carbazol]**

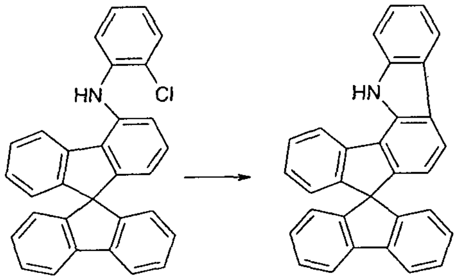

45 g (102 mmol) (2-Chlorpehyl)-4-spiro-9,9'-bifluorenyl-amin, 56 g (409 mmol) Kaliumcarbonat, 4.5 g (12 mmol) Tricyclohexylphosphintetrafluoroborat, 1.38 g (6 mmol) Palladium(II)acetat werden in 500 mL Dimethylacetamid suspendiert und 6 h unter Rückfluss gerührt. Nach Erkalten wird die Reaktionmischung mit 300 ml Wasser versetzt und die organische Phase mit 600 ml Dichlormethan erweitert. Man rührt 30 min. nach, trennt die organische Phase ab, filtriert diese über ein kurzes Celite-Bett und entfernt dann das Lösungsmittel im Vakuum. Das Rohprodukt wird mit Toluol heiß extrahiert und aus Toluol umkristallisiert. Das Produkt wird als beigefarbener Feststoff isoliert (32.5 g, 80 mmol, 78 % d.Th.).

**Synthese von IC4 (Spiro[9H-fluoren-9,7'(12'H)-indeno[1,2-a]carbazol]-12'-[2-(4,6-diphenyl-1,3,5-triazin-2-yl)])**

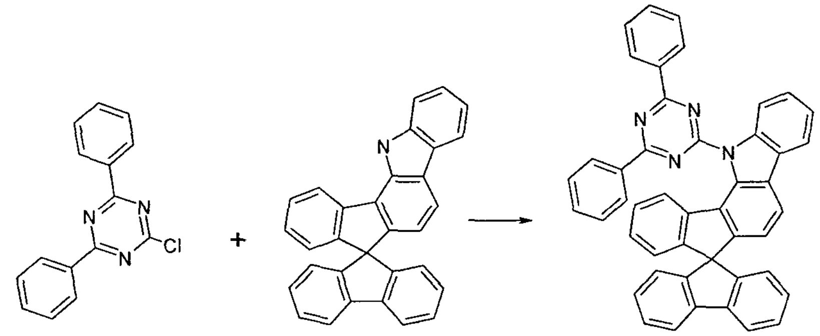

4.2 g NaH 60%ig in Mineralöl (0.106 mol) werden in 300 mL Dimethylformamid unter Schutzatmosphäre gelöst. 43 g (0.106 mol) Spiro[9H-fluoren-9,7'(1'*H*)-indeno[1,2-*a*]carbazol] werden in 250 mL DMF gelöst und zu der Reaktionsmischung zugetropft. Nach 1 h bei Raumtemperatur wird eine Lösung von 2-Chlor-4,6-diphenyl-[1,3,5]triazin (34.5 g, 0.122 mol) in 200 mL THF zugetropft. Das Reaktionsgemisch wird dann 12 h bei Raumtemperatur gerührt und dann auf Eis gegossen. Der dabei ausgefallene Feststoff wird nach Erwärmen auf Raumtemperatur filtriert und mit Ethanol und Heptan gewaschen. Der Rückstand wird mit Toluol heiß extrahiert, aus Toluol / n-Heptan umkristallisiert und abschließend im Hochvakuum sublimiert, Reinheit beträgt 99.9%. Die Ausbeute beträgt 28.4 g (44.5 mmol; 42 %).

**Synthese von IC5**

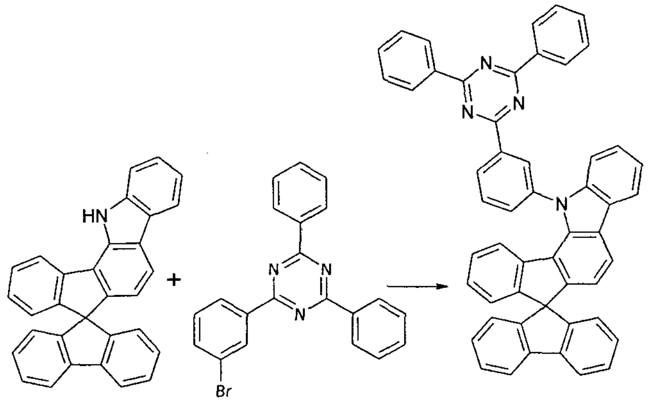

20.9 g (51.5 mmol) Spiro[9*H*-fluoren-9,7'(1'*H*)-indeno[1,2-*a*]carbazol], 20 g (51.5 mmol) 2-(3-Bromphenyl)-4,6-diphenyl-[1,3,5]triazin (CAS 864377-31-1) und 15 g NaOtBu werden in 1 L p-Xylol suspendiert. Zu dieser Suspension werden 0.23 g (1 mmol) $Pd(OAc)_2$ und 2 ml einer 1 M Tri-tert-butylphosphin Lösung gegeben. Die Reaktionsmischung wird 16 h unter Rückfluss erhitzt. Nach Erkalten wird die organische Phase abgetrennt, dreimal mit 200 mL Wasser gewaschen und anschließend zur Trockene eingeengt. Der Rückstand wird mit Toluol heiß extrahiert, aus Toluol umkristallisiert und abschließend im Hochvakuum sublimiert, Reinheit beträgt 99.9% bei einer Ausbeute von 13.8 g (19.3mmol; 38%)

**Herstellung der OLEDs**

In den folgenden Beispielen V1 bis E93 (siehe Tabellen 1 und 2) werden die Daten verschiedener OLEDs vorgestellt.

**Vorbehandlung für die Beispiele E1-E25:** Gereinigte Glasplättchen (Reinigung in Miele Laborspülmaschine, Reiniger Merck Extran), die mit strukturiertem ITO (Indium Zinn Oxid) der Dicke 50 nm beschichtet sind, werden zur verbesserten Prozessierung mit 20 nm PEDOT:PSS beschichtet (Poly(3,4-ethylendioxythiophen) poly(styrolsulfonat), bezogen als CLEVIOS™ P VP Al 4083 von Heraeus Precious Metals GmbH Deutschland, aus wässriger Lösung aufgeschleudert). Die Proben werden anschließend bei 180 °C für 10 min ausgeheizt. Diese beschichteten Glasplättchen bilden die Substrate, auf welche die OLEDs aufgebracht werden.

**Vorbehandlung für die Beispiele E26-E64:** Gereinigte Glasplättchen (Reinigung in Miele Laborspülmaschine, Reiniger Merck Extran), die mit strukturiertem ITO (Indium Zinn Oxid) der Dicke 50 nm beschichtet sind, werden 130 s lang mit einem Sauerstoffplasma behandelt. Diese mit Plasma behandelten Glasplättchen bilden die Substrate, auf welche die OLEDs aufgebracht werden. Die Substrate verbleiben vor der Beschichtung im Vakuum. Die Beschichtung beginnt innerhalb 10min nach der Plasmabehandlung.

**Vorbehandlung für die Beispiele E65-E93:** Gereinigte Glasplättchen (Reinigung in Miele Laborspülmaschine, Reiniger Merck Extran), die mit strukturiertem ITO (Indium Zinn Oxid) der Dicke 50 nm beschichtet sind, werden 130 s lang mit einem Sauerstoffplasma und anschließend 150 s lang mit einem Argonplasma behandelt. Diese mit Plasma behandelten Glasplättchen bilden die Substrate, auf welche die OLEDs aufgebracht werden. Die Substrate verbleiben vor der Beschichtung im Vakuum. Die Beschichtung beginnt innerhalb 10min nach der Plasmabehandlung.

Die OLEDs haben prinzipiell folgenden Schichtaufbau: Substrat / Lochtransportschicht (HTL) / optionale Zwischenschicht (IL) / Elektronenblockierschicht (EBL) / Emissionsschicht (EML) / optionale Lochblockierschicht (HBL) / Elektronentransportschicht (ETL) / optionale Elektroneninjektionsschicht (EIL) und abschließend eine Kathode. Die Kathode wird durch eine 100 nm dicke Aluminiumschicht gebildet. Der genaue Aufbau der OLEDs ist Tabelle 1 zu entnehmen. Die zur Herstellung der OLEDs benötigten Materialien sind in Tabelle 3 gezeigt. Die LUMO-Werte und $T_1$-Niveaus der Verbindungen sind in Tabelle 4 zusammengefasst.

Alle Materialien werden in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Coverdampfung in einem bestimmten Volumenanteil beigemischt wird. Eine Angabe wie ST1:L2:TEG1 (55%:35%:10%) bedeutet hierbei, dass das Material ST1 in einem Volumenanteil von 55%, L2 in einem Anteil von 35% und TEG1 in einem Anteil von 10% in der Schicht vorliegt. Analog kann auch die Elektronentransportschicht aus einer Mischung von zwei Materialien bestehen.

Die OLEDs werden standardmäßig charakterisiert. Hierfür werden die Elektrolumineszenzspektren, die Stromeffizienz (gemessen in cd/A), die Leistungseffizienz (gemessen in lm/W) und die externe Quanteneffizienz (EQE, gemessen in Prozent) in Abhängigkeit der Leuchtdichte, berechnet aus Strom-Spannungs-Leuchtdichte-Kennlinien (IUL-Kennlinien) unter Annahme einer lambertschen Abstrahlcharakteristik sowie die Lebensdauer bestimmt. Die Elektrolumineszenzspektren werden bei einer Leuchtdichte von 1000 $cd/m^2$ bestimmt und daraus die CIE 1931 x und y Farbkoordinaten berechnet. Die Angabe U1000 in Tabelle 2 bezeichnet die Spannung, die für eine Leuchtdichte von 1000 $cd/m^2$ benötigt wird. SE1000 und LE1000 bezeichnen die Strom- bzw. Leistungseffizienz, die bei 1000 $cd/m^2$ erreicht werden. EQE1000 schließlich bezeichnet die externe Quanteneffizienz bei einer Betriebsleuchtdichte von 1000 $cd/m^2$. Als Lebensdauer LD wird die Zeit definiert, nach der die Leuchtdichte bei Betrieb mit konstanter Stromdichte $j_0$ von der Startleuchtdichte auf einen gewissen Anteil L1 absinkt. Eine Angabe L1 = 80% in Tabelle 2 bedeutet, dass die in Spalte LD angegebene Lebensdauer der Zeit entspricht, nach der die Leuchtdichte auf 80% ihres Anfangswertes absinkt.

Die Daten der verschiedenen OLEDs sind in Tabelle 2 zusammengefasst. Die Beispiel V1-V8 sind Vergleichsbeispiele gemäß dem Stand der Technik, die Beispiele E1-E93 zeigen Daten von erfindungsgemäßen OLEDs.

Im Folgenden werden einige der Beispiele näher erläutert, um die Vorteile der erfindungsgemäßen OLEDs zu verdeutlichen.

**Verwendung von erfindungsgemäßen Mischungen in der Emissionsschicht phosphoreszenter OLEDs**

Durch Einsatz von erfindungsgemäßen Verbindungen in Kombination mit dem Wide-Bandgap Material WB1 lassen sich gute externe Quanteneffizienzen realisieren (Beispiele V1-V8). Bei Verwendung einer elektronenleitenden zweiten Komponente erhält man nur eine leichte Verbesserung der EQE, aufgrund der niedrigeren Spannung aber deutlich verbesserte Leistungseffizienzen von bis zu etwa 30% mehr (Beispiele V1,E7). Weiterhin erhält man ausgezeichnete Verbesserungen bezüglich Lebensdauer um mehr als das doppelte (Beispiele V2, E15).

Insbesondere mit einer Mischung der Verbindungen IC4 und L8 erhält man hervorragende Lebensdauern (Beispiel E45), mit CbzT4 und L1 herausragende Effizienz (Beispiel E61).

Weiterhin erhält man mit Mischungen von unterschiedlichen Lactamen, elektronenleitenden Verbindungen und phosphoreszierenden Emittern ausgezeichnete Leistungsdaten, was die breite Anwendbarkeit der erfindungsgemäßen Schichten demonstriert.

**Verwendung von erfindungsgemäßen Mischungen als Elektronentransportschicht**

Verwendet man statt einer Mischung aus L1 und LiQ gemäß dem Stand der Technik eine erfindungsgemäße Mischung aus L1 und ST1 als Elektronentransportschicht, so erhält man eine deutlich bessere Spannung sowie bessere Effizienz und Lebensdauer (Beispiele V3, E25).

Tabelle 1: Aufbau der OLEDs

| Bsp | HTL Dicke | IL Dicke | EBL Dicke | EML Dicke | HBL Dicke | ETL Dicke | EIL Dicke |
|---|---|---|---|---|---|---|---|
| V1 | SpA1 70nm | HATCN 5nm | SpMA1 90nm | L1:WB1:TEG1 (45%:45%:10%) 40nm | --- | ST2:LiQ (50%:50%) 30nm | --- |
| V2 | SpA1 70nm | HATCN 5nm | SpMA1 90nm | L1:WB1:TEG1 (45%:45%:10%) 40nm | IC1 5nm | ST2:LiQ (50%:50%) 25nm | --- |
| V3 | SpA1 70nm | HATCN 5nm | SpMA1 90nm | IC1:TEG1 (90%:10%) 30nm | --- | L1:LiQ(50%:50%) 40nm | LiQ 3nm |
| V4 | SpA1 70nm | HATCN 5nm | SpMA1 90nm | L1:TEG1 (90%:10%) 40nm | --- | ST2:LiQ (50%:50%) 30nm | --- |
| V5 | SpA1 70nm | HATCN 5nm | SpMA1 90nm | IC1:TEG1 (90%:10%) 40nm | --- | ST2:LiQ (50%:50%) 30nm | --- |
| V6 | SpA1 90nm | HATCN 5nm | SpMA1 130nm | IC3:TER1 (92%:8%) 40nm | --- | ST2:LiQ (50%:50%) 40nm | --- |
| V7 | SpA1 70nm | HATCN 5nm | SpMA1 90nm | L2:WB1:TEG1 (45%:45%:10%) 40nm | --- | ST2:LiQ (50%:50%) 30nm | --- |
| V8 | SpA1 70nm | HATCN 5nm | SpMA1 90nm | L2:WB1:TEG1 (45%:45%:10%) 40nm | --- | ST2 30nm | LiQ 3nm |
| E1 | SpA1 70nm | HATCN 5nm | SpMA1 90nm | L1:IC1:TEG1 (45%:45%:10%) 40nm | --- | ST2:LiQ (50%:50%) 30nm | --- |

(fortgesetzt)

| Bsp | HTL Dicke | IL Dicke | EBL Dicke | EML Dicke | HBL Dicke | ETL Dicke | EIL Dicke |
|---|---|---|---|---|---|---|---|
| E2 | SpA1 70nm | HATCN 5nm | SpMA1 90nm | L1:IC1:TEG1 (45%:45%:10%) 40nm | IC1 5nm | ST2:LiQ (50%:50%) 25nm | --- |
| E3 | SpA1 70nm | HATCN 5nm | SpMA1 90nm | L1:IC3:TEG1 (45%:45%:10%) 40nm | --- | ST2:LiQ (50%:50%) 30nm | --- |
| E4 | SpA1 70nm | HATCN 5nm | SpMA1 90nm | L1:IC2:TEG1 (45%:45%:10%) 40nm | --- | ST2:LiQ (50%:50%) 30nm | --- |
| E5 | SpA1 70nm | HATCN 5nm | SpMA1 90nm | L1:IC3:TEG1 (45%:45%:10%) 40nm | --- | ST2 30nm | LiQ 3nm |
| E6 | SpA1 70nm | HATCN 5nm | SpMA1 90nm | L1:CbzT1:TEG1 (45%:45%:10%) 40nm | --- | ST2 30nm | LiQ 3nm |
| E7 | SpA1 70nm | HATCN 5nm | SpMA1 90nm | L1:CbzT1:TEG1 (45%:45%:10%) 40nm | --- | ST2:LiQ (50%:50%) 30nm | --- |
| E8 | SpA1 70nm | HATCN 5nm | SpMA1 90nm | L2:CbzT1:TEG1 (45%:45%:10%) 40nm | --- | ST2 30nm | LiQ 3nm |
| E9 | SpA1 70nm | HATCN 5nm | SpMA1 90nm | L2:CbzT1:TEG1 (45%:45%:10%) 40nm | --- | ST2:LiQ (50%:50%) 30nm | --- |
| E10 | SpA1 70nm | HATCN 5nm | SpMA1 90nm | L2:IC3:TEG1 (45%:45%:10%) 40nm | --- | ST2:LiQ (50%:50%) 30nm | --- |
| E11 | SpA1 70nm | HATCN 5nm | SpMA1 90nm | L2:IC3:TEG1 (45%:45%:10%) 40nm | --- | ET1 30nm | LiF 1.5nm |
| E12 | SpA1 70nm | HATCN 5nm | SpMA1 90nm | L2:IC3:TEG1 (45%:45%:10%) 30nm | IC1 10nm | ET2:LiQ(50%:50%) 30nm | --- |
| E13 | SpA1 70nm | HATCN 5nm | SpMA1 90nm | L2:IC3:TEG1 (45%:45%:10%) 40nm | --- | ST2 30nm | LiQ 3nm |
| E14 | SpA1 70nm | HATCN 5nm | SpMA1 130nm | L1:IC3:TER1 (46%:46%:8%) 40nm | --- | ST2:LiQ (50%:50%) 30nm | --- |
| E15 | SpA1 70nm | HATCN 5nm | SpMA1 90nm | L1:CRL1:TEG1 (45%:45%:10%) 40nm | IC1 5nm | ST2:LiQ(50%:50%) 25nm | --- |
| E16 | SpA1 70nm | HATCN 5nm | SpMA1 90nm | L3:IC3:TEG1 (45%:45%:10%) 40nm | --- | ST2:LiQ (50%:50%) 30nm | --- |
| E17 | SpA1 70nm | HATCN 5nm | SpMA1 90nm | L4:IC3:TEG1 (45%:45%:10%) 40nm | --- | ST2:LiQ (50%:50%) 30nm | --- |
| E18 | SpA1 70nm | HATCN 5nm | SpMA1 90nm | L5:IC3:TEG1 (45%:45%:10%) 40nm | --- | ST2:LiQ (50%:50%) 30nm | --- |
| E19 | SpA1 70nm | HATCN 5nm | SpMA1 90nm | L5:IC3:TEG1 (45%:45%:10%) 40nm | --- | ST2 30nm | LiQ 3nm |
| E20 | SpA1 70nm | HATCN 5nm | SpMA1 90nm | L6:IC3:TEG1 (45%:45%:10%) 40nm | --- | ST2:LiQ (50%:50%) 30nm | --- |
| E21 | SpA1 70nm | HATCN 5nm | SpMA1 90nm | L7:IC3:TEG1 (45%:45%:10%) 30nm | ST2 10nm | ST2:LiQ (50%:50%) 30nm | |
| E22 | SpA1 70nm | HATCN 5nm | SpMA1 90nm | L1:ST1:TEG1 (45%:45%:10%) 40nm | --- | ST2:LiQ (50%:50%) 30nm | --- |

(fortgesetzt)

| Bsp | HTL Dicke | IL Dicke | EBL Dicke | EML Dicke | HBL Dicke | ETL Dicke | EIL Dicke |
|---|---|---|---|---|---|---|---|
| E23 | SpA1 70nm | HATCN 5nm | SpMA1 90nm | L1:CbzT2:TEG1 (45%:45%:10%) 40nm | IC1 5nm | ST2:LiQ (50%:50%) 25nm | --- |
| E24 | SpA1 70nm | HATCN 5nm | SpMA1 90nm | L1:CbzT3:TEG1 (45%:45%:10%) 40nm | IC1 5nm | ST2:LiQ (50%:50%) 25nm | --- |
| E25 | SpA1 70nm | HATCN 5nm | SpMA1 90nm | IC1:TEG1 (90%:10%) 30nm | --- | L1:ST1 (50%:50%) 40nm | LiQ 3nm |
| E26 | HATCN 5nm | SpMA1 75nm | SpMA2 15nm | IC3:L1:TEY1 (45%:45%:10%) 25nm | --- | ST2:LiQ (50%:50%) 45nm | --- |
| E27 | HATCN 5nm | SpMA1 75nm | SpMA2 15nm | IC3:L1:TEY1 (60%:30%:10%) 25nm | --- | ST2:LiQ (50%:50%) 45nm | --- |
| E28 | HATCN 5nm | SpMA1 75nm | SpMA2 15nm | IC3:L1:TEY1 (30%:60%:10%) 25nm | --- | ST2:LiQ (50%:50%) 45nm | --- |
| E29 | HATCN 5nm | SpMA1 75nm | SpMA2 15nm | IC3:L1:TEY1 (20%:70%:10%) 25nm | --- | ST2:LiQ (50%:50%) 45nm | --- |
| E30 | HATCN 5nm | SpMA1 75nm | SpMA2 15nm | IC3:L1:TEY1 (48%:47%:5%) 25nm | --- | ST2:LiQ (50%:50%) 45nm | --- |
| E31 | HATCN 5nm | SpMA1 75nm | SpMA2 15nm | IC3:L1:TEY1 (47%:46%:7%) 25nm | --- | ST2:LiQ (50%:50%) 45nm | --- |
| E32 | HATCN 5nm | SpMA1 75nm | SpMA2 15nm | IC3:L1:TEY1 (43%:42%:15%) 25nm | --- | ST2:LiQ (50%:50%) 45nm | --- |
| E33 | HATCN 5nm | SpMA1 75nm | SpMA2 15nm | IC3:L1:TEY1 (45%:45%:10%) 25nm | --- | ST2 45nm | LiQ 3nm |
| E34 | HATCN 5nm | SpMA1 75nm | SpMA2 15nm | IC3:L1:TEY1 (60%:30%:10%) 25nm | --- | ST2 45nm | LiQ 3nm |
| E35 | HATCN 5nm | SpMA1 75nm | SpMA2 15nm | IC3:L1:TEY1 (30%:60%:10%)25nm | --- | ST2 45nm | LiQ 3nm |
| E36 | HATCN 5nm | SpMA1 75nm | SpMA2 15nm | IC3:L1:TEY1 (20%:70%:10%) 25nm | --- | ST2 45nm | LiQ 3nm |
| E37 | HATCN 5nm | SpMA1 75nm | SpMA2 15nm | IC3:L1:TEY1 (48%:47%:5%) 25nm | --- | ST2 45nm | LiQ 3nm |
| E38 | HATCN 5nm | SpMA1 75nm | SpMA2 15nm | IC3:L1:TEY1 (47%:46%:7%) 25nm | --- | ST2 45nm | LiQ 3nm |
| E39 . | HATCN 5nm | SpMA1 75nm | SpMA2 15nm | IC3:L1:TEY1 (43%:42%:15%) 25nm | --- | ST2 45nm | LiQ 3nm |
| E40 | HATCN 5nm | --- | SpMA2 90m | IC3:L7:TEY2 (40%:50%:10%) 30nm | --- | ST1 40nm | LiQ 3nm |
| E41 | HATCN 5nm | --- | SpMA2 90m | IC3:L8:TEY2 (45%:45%:10%) 30nm | --- | ST1 40nm | LiQ 3nm |
| E42 | HATCN 5nm | --- | SpMA2 90m | IC3:L8:TEY2 (47%:48%:15%) 30nm | --- | ST1 40nm | LiQ 3nm |
| E43 | HATCN 5nm | SpMA1 75nm | SpMA2 15nm | L1:L8:TEY2 (45%:45%:10%) 30nm | --- | ST1 40nm | LiQ 3nm |

(fortgesetzt)

| Bsp | HTL Dicke | IL Dicke | EBL Dicke | EML Dicke | HBL Dicke | ETL Dicke | EIL Dicke |
|---|---|---|---|---|---|---|---|
| E44 | HATCN 5nm | --- | SpMA2 90m | L8:IC4:TEY2 (45%:45%:10%) 30nm | --- | ST1 40nm | LiQ 3nm |
| E45 | HATCN 5nm | --- | SpMA5 90m | L8:IC4:TEY2 (45%:45%:10%) 30nm | --- | ST1 40nm | LiQ 3nm |
| E46 | HATCN 5nm | --- | SpMA4 90m | L8:IC4:TEY2 (45%:45%:10%) 30nm | --- | ST1 40nm | LiQ 3nm |
| E47 | HATCN 5nm | --- | SpMA6 90m | L8:IC4:TEY2 (45%:45%:10%) 30nm | --- | ST1 40nm | LiQ 3nm |
| E48 | HATCN 5nm | --- | SpMA2 90m | L8:CbzT3:TEY2 (45%:45%:10%) 30nm | --- | ST1 40nm | LiQ 3nm |
| E49 | HATCN 5nm | --- | SpMA2 90m | L8:IC6:TEY2 (45%:45%:10%) 30nm | --- | ST1 40nm | LiQ 3nm |
| E50 | HATCN 5nm | --- | SpMA5 90m | L8:IC6:TEY2 (45%:45%:10%) 30nm | --- | ST1 40nm | LiQ 3nm |
| E51 | HATCN 5nm | --- | SpMA4 90m | L8:IC6:TEY2 (45%:45%:10%) 30nm | --- | ST1 40nm | LiQ 3nm |
| E52 | HATCN 5nm | --- | SpMA6 90m | L8:IC6:TEY2 (45%:45%:10%) 30nm | --- | ST1 40nm | LiQ 3nm |
| E53 | HATCN 5nm | SpMA1 75nm | SpMA2 10nm | IC3:L9:TEY2 (45%:45%:10%) 25nm | --- | ST2 45nm | LiQ 3nm |
| E54 | HATCN 5nm | SpMA1 75nm | SpMA2 10nm | IC3:L1:TEY2 (45%:45%:10%) 25nm | --- | ST2 45nm | LiQ 3nm |
| E55 | HATCN 5nm | SpMA1 70nm | SpMA2 15nm | CbzT1:L1:TEY2 (45%:45%:10%) 30nm | --- | ST2 40nm | LiQ 3nm |
| E56 | HATCN 5nm | SpMA7 70nm | SpMA2 15nm | CbzT1:L1:TEY2 (45%:45%:10%) 30nm | --- | ST2 40nm | LiQ 3nm |
| E57 | HATCN 5nm | SpMA1 70nm | SpMA8 15nm | CbzT1:L1:TEY2 (45%:45%:10%) 30nm | --- | ST2 40nm | LiQ 3nm |
| E58 | HATCN 5nm | SpMA7 70nm | SpMA8 15nm | CbzT1:L1:TEY2 (45%:45%:10%) 30nm | --- | ST2 40nm | LiQ 3nm |
| E59 | HATCN 5nm | CbzA1 70nm | SpMA2 15nm | CbzT1:L1:TEY2 (45%:45%:10%) 30nm | --- | ST2 40nm | LiQ 3nm |
| E60 | HATCN 5nm | SpMA9 70nm | SpMA2 15nm | CbzT1:L1:TEY2 (45%:45%:10%) 30nm | --- | ST2 40nm | LiQ 3nm |
| E61 | HATCN 5nm | SpMA1 70nm | SpMA2 15nm | CbzT4:L1:TEY2 (45%:45%:10%) 25nm | --- | ST2 45nm | LiQ 3nm |
| E62 | HATCN 5nm | SpMA1 70nm | SpMA2 15nm | CbzT5:L1:TEY2 (45%:45%:10%) 25nm | --- | ST2 45nm | LiQ 3nm |
| E63 | HATCN 5nm | SpMA1 75nm | SpMA2 15nm | CbzT1:L1:TEY1 (45%:45:10%) 25nm | --- | ST2:LiQ (50%:50%) 45nm | --- |
| E64 | HATCN 5nm | SpMA1 75nm | SpMA2 15nm | CbzT1:L1:TEY1 (45%:45:10%) 25nm | --- | ST2 45nm | LiQ 3nm |

(fortgesetzt)

| Bsp | HTL Dicke | IL Dicke | EBL Dicke | EML Dicke | HBL Dicke | ETL Dicke | EIL Dicke |
|---|---|---|---|---|---|---|---|
| E65 | SpMA1:F4T (95%:5%) 20nm | SpMA1 200nm | SpMA3 20nm | IC4:L1:TEG2 (53%:30%:17%) 30nm | ST2 10nm | ST2:LiQ (50%:50%) 30nm | LiQ 1 nm |
| E66 | SpMA1:F4T (95%:5%) 20nm | SpMA1 200nm | SpMA3 20nm | IC4:L1:TEG2 (38%:50%:12%) 30nm | ST2 10nm | ST2:LiQ (50%:50%) 30nm | LiQ 1nm |
| E67 | SpMA1:F4T (95%:5%) 20nm | SpMA1 200nm | SpMA3 20nm | IC4:L1:TEG2 (33%:50%:17%) 30nm | ST2 10nm | ST2:LiQ (50%:50%) 30nm | LiQ 1nm |
| E68 | SpMA1:F4T (95%:5%) 20nm | SpMA1 200nm | SpMA3 20nm | IC5:L1:TEG2 (53%:30%:17%) 30nm | ST2 10nm | ST2:LiQ (50%:50%) 30nm | LiQ 1nm |
| E69 | SpMA1:F4T (95%:5%) 20nm | SpMA1 200nm | SpMA3 20nm | IC5:L1:TEG2 (38%:50%:12%) 30nm | ST2 10nm | ST2:LiQ (50%:50%) 30nm | LiQ 1nm |
| E70 | SpMA1:F4T (95%:5%) 20nm | SpMA1 200nm | SpMA3 20nm | L8:IC5:TEG2 (58%:25%:17%) 30nm | ST2 10nm | ST2:LiQ (50%:50%) 30nm | LiQ 1nm |
| E71 | SpMA1:F4T (95%:5%) 20nm | SpMA1 200nm | SpMA10 20nm | L8:IC5:TEG2 (58%:25%:17%) 30nm | ST2 10nm | ST2:LiQ (50%:50%) 30nm | LiQ 1nm |
| E72 | SpMA1:F4T (95%:5%) 20nm | SpMA1 200nm | SpMA3 20nm | IC5:L7:TEG2 (63%:25%:12%) 30nm | ST2 10nm | ST2:LiQ (50%:50%) 30nm | LiQ 1nm |
| E73 | SpMA1:F4T (95%:5%) 20nm | SpMA1 200nm | SpMA3 20nm | IC5:L7:TEG2 (23%:65%:12%) 30nm | ST2 10nm | ST2:LiQ (50%:50%) 30nm | LiQ 1nm |
| E74 | SpMA1:F4T (95%:5%) 20nm | SpMA1 210nm | SpMA3 10nm | IC3:L9:TEG2 (40%:45%:15%) 30nm | - | ST2:LiQ (50%:50%) 40nm | - |
| E75 | SpMA1:F4T (95%:5%) 20nm | SpMA1 210nm | SpMA3 10nm | IC3:L9:TEG2 (45%:45%:10%) 30nm | --- | ST2:LiQ (50%:50%) 40nm | - |
| E76 | SpMA1:F4T (95%:5%) 20nm | SpMA1 220nm | SpMA2 10nm | IC3:L9:TEG1 (45%:45%:10%) 30nm | --- | ST2:LiQ (50%:50%) 40nm | --- |
| E77 | SpMA1:F4T (95%:5%) 20nm | --- | SpMA1 220nm | IC4:L9:TEG2 (35%:45%:20%) | --- | ST2:LiQ (50%:50%) 40nm | --- |
| E78 | SpMA1:F4T (95%:5%) 20nm | --- | SpMA1 220nm | IC4:L9:TEG2 (45%:45%:10%) | --- | ST2:LiQ (50%:50%) 40nm | --- |
| E79 | SpMA1:F4T (95%:5%) 20nm | --- | SpMA1 220nm | IC4:L9:TEG2 (40%:45%:15%) | --- | ST2:LiQ (50%:50%) 40nm | --- |

(fortgesetzt)

| Bsp | HTL Dicke | IL Dicke | EBL Dicke | EML Dicke | HBL Dicke | ETL Dicke | EIL Dicke |
|---|---|---|---|---|---|---|---|
| E80 | SpMA1:F4T (95%:5%) 20nm | SpMA1 210nm | SpMA2 10nm | IC4:L9:TEG2 (35%:45%:20%) | --- | ST2:LiQ (50%:50%) 40nm | --- |
| E81 | SpMA1:F4T (95%:5%) 20nm | SpMA1 210nm | SpMA2 10nm | [C4:L9:TEG2 (40%:45%:15%) | --- | ST2:LiQ (50%:50%) 40nm | --- |
| E82 | SpMA1:F4T (95%:5%) 20nm | SpMA1 200nm | SpMA2 20nm | L8:IC4:TEG2 (63%:25%:12%) | ST2 10nm | ST2:LiQ (50%:50%) 30nm | LiQ 1nm |
| E83 | SpMA1:F4T (95%:5%) 20nm | SpMA1 200nm | SpMA2 20nm | L8:IC4:TEG2 (58%:25%:17%) | ST2 10nm | ST2:LiQ (50%:50%) 30nm | LiQ 1nm |
| E84 | SpMA1:F4T (95%:5%) 20nm | SpMA1 200nm | SpMA2 20nm | L8:IC4:TEG2 (38%:45%:17%) | ST2 10nm | ST2:LiQ (50%:50%) 30nm | LiQ 1nm |
| E85 | SpMA1:F4T (95%:5%) 20nm | SpMA1 200nm | SpMA2 20nm | L8:IC4:TEG2 (18%:65%:17%) | ST2 10nm | ST2:LiQ (50%:50%) 30nm | LiQ 1nm |
| E86 | SpMA1:F4T (95%:5%) 20nm | SpMA1 200nm | SpMA4 20nm | L8:IC4:TEG2 (63%:25%:12%) | ST2 10nm | ST2:LiQ (50%:50%) 30nm | LiQ 1nm |
| E87 | SpMA1:F4T (95%:5%) 20nm | SpMA1 200nm | SpMA4 20nm | L8:IC4:TEG2 (43%:45%:12%) | ST2 10nm | ST2:LiQ (50%:50%) 30nm | LiQ 1nm |
| E88 | SpMA1:F4T (95%:5%) 20nm | SpMA1 200nm | SpMA4 20nm | L8:IC4:TEG2 (58%:25%:17%) | ST2 10nm | ST2:LiQ (50%:50%) 30nm | LiQ 1 nm |
| E89 | SpMA1:F4T (95%:5%) 20nm | SpMA1 200nm | SpMA4 20nm | L8:IC4:TEG2 (38%:45%:17%) | ST2 10nm | ST2:LiQ (50%:50%) 30nm | LiQ 1nm |
| E90 | SpMA1:F4T (95%:5%) 20nm | SpMA1 200nm | SpMA4 20nm | L8:IC4:TEG2 (18%:65%:17%) | ST2 10nm | ST2:LiQ (50%:50%) 30nm | LiQ 1nm |
| E91 | SpMA1:F4T (95%:5%) 20nm | SpMA1 200nm | SpMA2 20nm | L8:L7:TEG2 (58%:25%:17%) | ST2 10nm | ST2:LiQ (50%:50%) 30nm | LiQ 1nm |
| E92 | SpMA1:F4T (95%:5%) 20nm | SpMA1 200nm | SpMA4 20nm | L8:L7:TEG2 (58%:25%:17%) | ST2 10nm | ST2:LiQ (50%:50%) 30nm | LiQ 1nm |
| E93 | SpMA1:F4T (95%:5%) 20nm | SpMA1 200nm | SpMA4 20nm | L8:L7:TEG2 (38%:45%:17%) | ST2 10nm | ST2:LiQ (50%:50%) 30nm | LiQ 1nm |

Tabelle 2: Daten der OLEDs

| Bsp. | U1000 (V) | SE1000 (cd/A) | LE1000 (lm/W) | EQE 1000 | CIE x/y bei 1000 cd/$m^2$ | $j_0$ | L1 % | LD (h) |
|---|---|---|---|---|---|---|---|---|
| V1 | 4.0 | 64 | 51 | 17.1% | 0.33/0.62 | 20mA/$cm^2$ | 80 | 130 |
| V2 | 3.9 | 62 | 50 | 16.9% | 0.32/0.63 | 20mA/$cm^2$ | 80 | 125 |
| V3 | 3.8 | 56 | 46 | 15.6% | 0.33/0.62 | 20mA/$cm^2$ | 80 | 120 |
| V4 | 3.4 | 58 | 54 | 16.1% | 0.33/0.62 | 20mA/$cm^2$ | 80 | 140 |
| V5 | 3.6 | 56 | 49 | 15.7% | 0.33/0.62 | 20mA/$cm^2$ | 80 | 145 |
| V6 | 4.5 | 11.2 | 7.8 | 12.1% | 0.67/0.33 | 40mA/$cm^2$ | 80 | 340 |
| V7 | 3.5 | 60 | 55 | 16.2% | 0.33/0.62 | 20mA/$cm^2$ | 80 | 120 |
| V8 | 3.3 | 58 | 55 | 16.0% | 0.33/0.62 | 20mA/$cm^2$ | 80 | 100 |
| E1 | 3.3 | 61 | 58 | 16.5% | 0.33/0.62 | 20mA/$cm^2$ | 80 | 205 |
| E2 | 3.3 | 62 | 59 | 16.6% | 0.33/0.63 | 20mA/$cm^2$ | 80 | 210 |
| E3 | 3.1 | 63 | 63 | 17.3% | 0.33/0.62 | 20mA/$cm^2$ | 80 | 230 |
| E4 | 3.2 | 61 | 60 | 17.0% | 0.32/0.62 | 20mA/$cm^2$ | 80 | 190 |
| E5 | 2.9 | 62 | 67 | 17.1% | 0.33/0.62 | 20mA/$cm^2$ | 80 | 155 |
| E6 | 2.7 | 61 | 70 | 16.9% | 0.33/0.62 | 20mA/$cm^2$ | 80 | 170 |
| E7 | 2.9 | 62 | 67 | 17.2% | 0.33/0.62 | 20mA/$cm^2$ | 80 | 260 |
| E8 | 2.6 | 59 | 71 | 16.4% | 0.32/0.62 | 20mA/$cm^2$ | 80 | 165 |
| E9 | 3.0 | 62 | 65 | 17.2% | 0.33/0.62 | 20mA/$cm^2$ | 80 | 140 |
| E10 | 2.9 | 57 | 61 | 15.8% | 0.32/0.63 | 20mA/$cm^2$ | 80 | 200 |
| E11 | 4.0 | 49 | 38 | 13.6% | 0.32/0.62 | 20mA/$cm^2$ | 80 | 260 |
| E12 | 3.5 | 58 | 52 | 16.0% | 0.33/0.62 | 20mA/$cm^2$ | 80 | 235 |
| E13 | 2.7 | 57 | 66 | 15.9% | 0.32/0.63 | 20mA/$cm^2$ | 80 | 135 |
| E14 | 4.2 | 12.0 | 8.9 | 13.0% | 0.67/0.33 | 40mA/$cm^2$ | 80 | 455 |
| E15 | 3.0 | 52 | 55 | 14.7% | 0.32/0.62 | 20mA/$cm^2$ | 80 | 290 |
| E16 | 3.2 | 61 | 60 | 16.7% | 0.32/0.62 | 20mA/$cm^2$ | 80 | 175 |
| E17 | 3.3 | 57 | 55 | 16.0% | 0.33/0.62 | 20mA/$cm^2$ | 80 | 130 |
| E18 | 3.4 | 58 | 54 | 16.2% | 0.32/0.62 | 20mA/$cm^2$ | 80 | 145 |
| E19 | 3.2 | 58 | 57 | 16.1% | 0.33/0.62 | 20mA/$cm^2$ | 80 | 120 |
| E20 | 3.0 | 59 | 62 | 16.5% | 0.32/0.62 | 20mA/$cm^2$ | 80 | 255 |
| E21 | 3.2 | 60 | 59 | 16.0% | 0.32/0.62 | 20mA/$cm^2$ | 80 | 240 |
| E22 | 3.1 | 60 | 60 | 16.5% | 0.32/0.62 | 20mA/$cm^2$ | 80 | 155 |
| E23 | 3.5 | 53 | 48 | 14.8% | 0.32/0.63 | 20mA/$cm^2$ | 80 | 190 |
| E24 | 3.4 | 55 | 51 | 15.4% | 0.33/0.63 | 20mA/$cm^2$ | 80 | 215 |
| E25 | 3.3 | 58 | 54 | 16.4% | 0.33/0.62 | 20mA/$cm^2$ | 80 | 140 |
| E26 | 2.8 | 72 | 80 | 20.6% | 0.44/0.55 | 50mA/$cm^2$ | 95 | 110 |
| E27 | 2.8 | 73 | 81 | 20.8% | 0.44/0.55 | 50mA/$cm^2$ | 95 | 90 |
| E28 | 2.9 | 72 | 78 | 20.8% | 0.44/0.55 | 50mA/$cm^2$ | 95 | 105 |
| E29 | 3.0 | 72 | 77 | 20.7% | 0.44/0.55 | 50mA/$cm^2$ | 95 | 105 |

(fortgesetzt)

| Bsp. | U1000 (V) | SE1000 (cd/A) | LE1000 (lm/W) | EQE 1000 | CIE x/y bei 1000 cd/m$^2$ | $j_0$ | L1 % | LD (h) |
|---|---|---|---|---|---|---|---|---|
| E30 | 2.8 | 72 | 79 | 20.0% | 0.42/0.57 | 50mA/cm$^2$ | 95 | 85 |
| E31 | 2.8 | 72 | 79 | 20.3% | 0.43/0.56 | 50mA/cm$^2$ | 95 | 105 |
| E32 | 2.9 | 63 | 68 | 18.4% | 0.45/0.55 | 50mA/cm$^2$ | 95 | 100 |
| E33 | 2.6 | 75 | 89 | 21.5% | 0.44/0.55 | 50mA/cm$^2$ | 95 | 42 |
| E34 | 2.6 | 74 | 90 | 21.6% | 0.44/0.55 | 50mA/cm$^2$ | 95 | 43 |
| E35 | 2.7 | 74 | 87 | 21.5% | 0.44/0.55 | 50mA/cm$^2$ | 95 | 45 |
| E36 | 2.7 | 75 | 86 | 21.6% | 0.44/0.55 | 50mA/cm$^2$ | 95 | 50 |
| E37 | 2.6 | 74 | 89 | 20.7% | 0.43/0.56 | 50mA/cm$^2$ | 95 | 50 |
| E38 | 2.6 | 74 | 89 | 20.9% | 0.43/0.56 | 50mA/cm$^2$ | 95 | 48 |
| E39 | 2.7 | 68 | 81 | 19.8% | 0.45/0.54 | 50mA/cm$^2$ | 95 | 40 |
| E40 | 3.0 | 84 | 87 | 24.9% | 0.44/0.55 | 50mA/cm$^2$ | 90 | 165 |
| E41 | 2.7 | 76 | 89 | 22.4% | 0.44/0.55 | 50mA/cm$^2$ | 90 | 350 |
| E42 | 2.7 | 75 | 87 | 22.0% | 0.44/0.55 | 50mA/cm$^2$ | 90 | 375 |
| E43 | 2.6 | 86 | 103 | 24.9% | 0.43/0.56 | 50mA/cm$^2$ | 90 | 100 |
| E44 | 2.9 | 87 | 95 | 25.6% | 0.44/0.55 | 50mA/cm$^2$ | 90 | 345 |
| E45 | 2.8 | 86 | 96 | 25.5% | 0.45/0.55 | 50mA/cm$^2$ | 90 | 480 |
| E46 | 2.9 | 88 | 94 | 26.0% | 0.44/0.55 | 50mA/cm$^2$ | 90 | 210 |
| E47 | 2.9 | 85 | 92 | 25.1% | 0.44/0.55 | 50mA/cm$^2$ | 90 | 400 |
| E48 | 3.0 | 86 | 90 | 25.3% | 0.44/0.55 | 50mA/cm$^2$ | 90 | 130 |
| E49 | 2.7 | 84 | 97 | 24.4% | 0.44/0.55 | 50mA/cm$^2$ | 90 | 190 |
| E50 | 2.9 | 83 | 91 | 24.6% | 0.44/0.55 | 50mA/cm$^2$ | 90 | 225 |
| E51 | 3.0 | 86 | 91 | 25.4% | 0.44/0.55 | 50mA/cm$^2$ | 90 | 140 |
| E52 | 2.9 | 80 | 86 | 23.5% | 0.44/0.55 | 50mA/cm$^2$ | 90 | 180 |
| E53 | 2.6 | 78 | 93 | 22.8% | 0.45/0.55 | 50mA/cm$^2$ | 90 | 195 |
| E54 | 2.7 | 82 | 94 | 23.8% | 0.44/0.55 | 50mA/cm$^2$ | 90 | 115 |
| E55 | 2.7 | 81 | 95 | 23.8% | 0.44/0.55 | 50mA/cm$^2$ | 90 | 255 |
| E56 | 2.5 | 82 | 102 | 23.9% | 0.44/0.55 | 50mA/cm$^2$ | 90 | 330 |
| E57 | 2.9 | 84 | 92 | 24.3% | 0.44/0.55 | 50mA/cm$^2$ | 90 | 190 |
| E58 | 2.7 | 85 | 100 | 24.8% | 0.44/0.55 | 50mA/cm$^2$ | 90 | 300 |
| E59 | 2.9 | 79 | 85 | 23.5% | 0.45/0.54 | 50mA/cm$^2$ | 90 | 110 |
| E60 | 2.9 | 85 | 91 | 24.7% | 0.43/0.56 | 50mA/cm$^2$ | 90 | 170 |
| E61 | 2.8 | 90 | 103 | 26.0% | 0.43/0.56 | 50mA/cm$^2$ | 90 | 105 |
| E62 | 2.8 | 88 | 93 | 25.9% | 0.45/0.55 | 50mA/cm$^2$ | 90 | 140 |
| E63 | 2.9 | 66 | 73 | 19.0% | 0.43/0.56 | 50mA/cm$^2$ | 95 | 125 |
| E64 | 2.7 | 69 | 81 | 19.6% | 0.44/0.56 | 50mA/cm$^2$ | 95 | 48 |
| E65 | 3.3 | 71 | 68 | 18.9% | 0.35/0.62 | 40mA/cm$^2$ | 80 | 235 |
| E66 | 3.4 | 70 | 65 | 18.8% | 0.35/0.62 | 40mA/cm$^2$ | 80 | 170 |

(fortgesetzt)

| Bsp. | U1000 (V) | SE1000 (cd/A) | LE1000 (lm/W) | EQE 1000 | CIE x/y bei 1000 $cd/m^2$ | $j_0$ | L1 % | LD (h) |
|---|---|---|---|---|---|---|---|---|
| E67 | 3.3 | 71 | 68 | 18.9% | 0.34/0.63 | $40mA/cm^2$ | 80 | 270 |
| E68 | 3.2 | 74 | 72 | 19.7% | 0.34/0.63 | $40mA/cm^2$ | 80 | 210 |
| E69 | 3.3 | 74 | 71 | 19.7% | 0.34/0.63 | $40mA/cm^2$ | 80 | 165 |
| E70 | 3.4 | 59 | 55 | 16.6% | 0.32/0.63 | $40mA/cm^2$ | 80 | 345 |
| E71 | 3.4 | 56 | 52 | 15.6% | 0.32/0.63 | $40mA/cm^2$ | 80 | 370 |
| E72 | 3.4 | 82 | 77 | 22.2% | 0.33/0.63 | $40mA/cm^2$ | 80 | 190 |
| E73 | 3.7 | 78 | 66 | 20.9% | 0.33/0.63 | $40mA/cm^2$ | 80 | 225 |
| E74 | 3.1 | 60 | 60 | 16.1% | 0.31/0.64 | $20mA/cm^2$ | 90 | 410 |
| E75 | 3.1 | 61 | 63 | 16.9% | 0.30/0.64 | $20mA/cm^2$ | 90 | 235 |
| E76 | 3.2 | 63 | 62 | 17.3% | 0.33/0.63 | $20mA/cm^2$ | 80 | 340 |
| E77 | 3.1 | 52 | 53 | 14.4% | 0.31/0.64 | $20mA/cm^2$ | 90 | 395 |
| E78 | 3.2 | 53 | 52 | 14.4% | 0.31/0.64 | $20mA/cm^2$ | 90 | 420 |
| E79 | 3.1 | 58 | 60 | 16.0% | 0.31/0.64 | $20mA/cm^2$ | 90 | 460 |
| E80 | 3.3 | 58 | 56 | 15.7% | 0.31/0.64 | $20mA/cm^2$ | 90 | 365 |
| E81 | 3.2 | 65 | 64 | 17.9% | 0.31/0.64 | $20mA/cm^2$ | 90 | 300 |
| E82 | 3.5 | 69 | 63 | 18.4% | 0.35/0.62 | $40mA/cm^2$ | 80 | 235 |
| E83 | 3.4 | 65 | 60 | 17.3% | 0.35/0.62 | $40mA/cm^2$ | 80 | 405 |
| E84 | 3.3 | 68 | 64 | 18.2% | 0.35/0.62 | $40mA/cm^2$ | 80 | 320 |
| E85 | 3.3 | 71 | 69 | 19.0% | 0.35/0.62 | $40mA/cm^2$ | 80 | 220 |
| E86 | 3.2 | 67 | 67 | 18.0% | 0.35/0.62 | $40mA/cm^2$ | 80 | 325 |
| E87 | 3.1 | 70 | 71 | 18.8% | 0.35/0.61 | $40mA/cm^2$ | 80 | 245 |
| E88 | 3.1 | 67 | 69 | 18.0% | 0.35/0.62 | $40mA/cm^2$ | 80 | 425 |
| E89 | 3.2 | 67 | 67 | 18.1% | 0.35/0.61 | $40mA/cm^2$ | 80 | 315 |
| E90 | 3.0 | 69 | 72 | 18.5% | 0.35/0.61 | $40mA/cm^2$ | 80 | 220 |
| E91 | 3.2 | 73 | 71 | 19.6% | 0.33/0.64 | $40mA/cm^2$ | 80 | 155 |
| E92 | 3.0 | 73 | 77 | 19.4% | 0.33/0.63 | $40mA/cm^2$ | 80 | 185 |
| E93 | 3.0 | 78 | 81 | 20.8% | 0.33/0.63 | $40mA/cm^2$ | 80 | 160 |

Tabelle 3: Strukturformeln der Materialien für die OLEDs

| | |
|---|---|
| 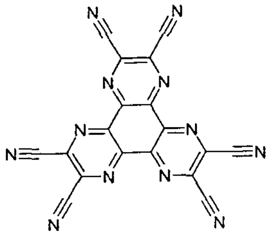 | 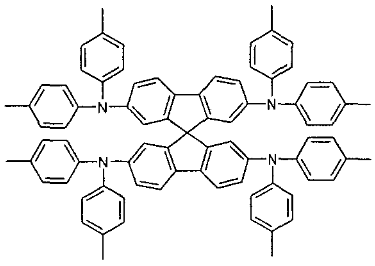 |
| HATCN | SpA1 |

(fortgesetzt)

| | |
|---|---|
| 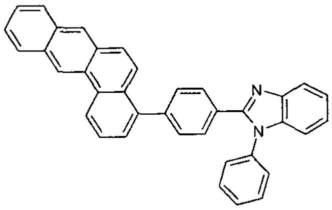 | 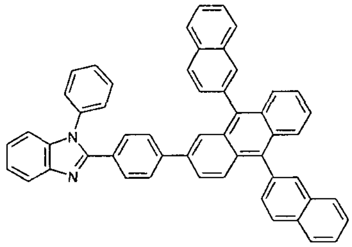 |
| ET1 | ET2 |
| 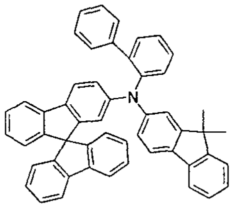 | 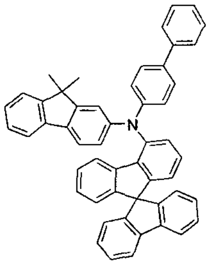 |
| SpMA1 | SpMA2 |
| 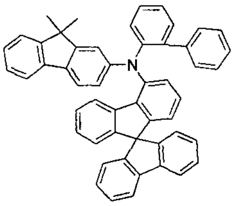 | 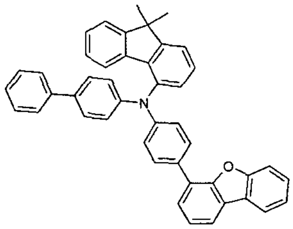 |
| SpMA3 | SpMA4 |
| 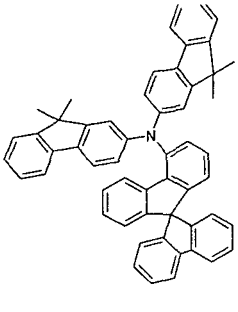 | 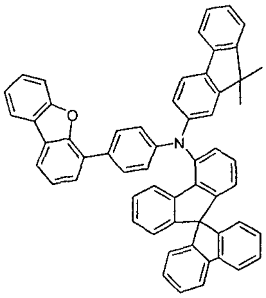 |
| SpMA5 | SpMA6 |
| 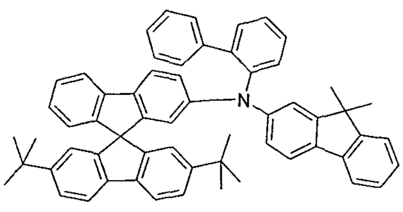 | 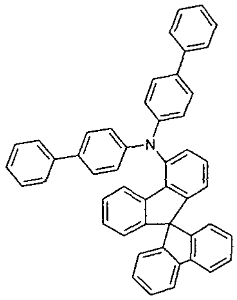 |
| SpMA7 | SpMA8 |

(fortgesetzt)

| | |
|---|---|
| 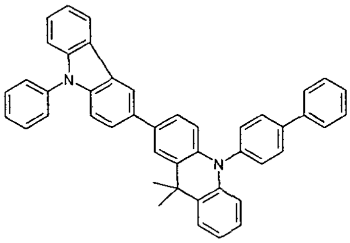 | 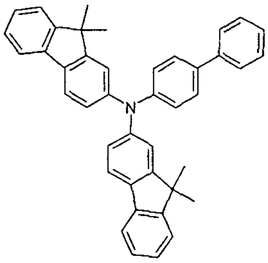 |
| CbzA1 | SpMA9 |
| 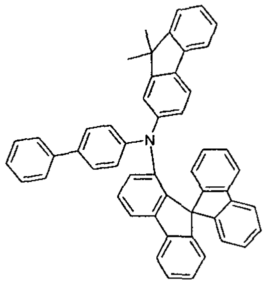 | 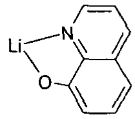 |
| SpMA10 | LiQ |
| 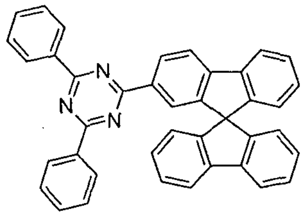 | 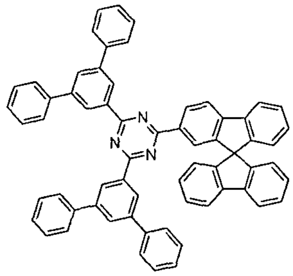 |
| ST1 | ST2 |
| 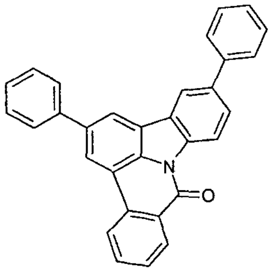 | 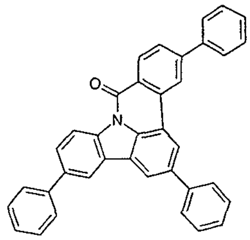 |
| L1 | L2 |
| 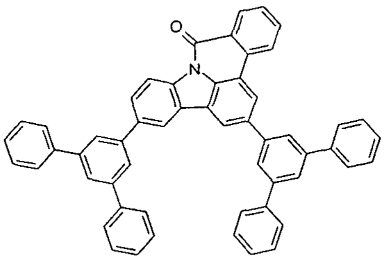 | 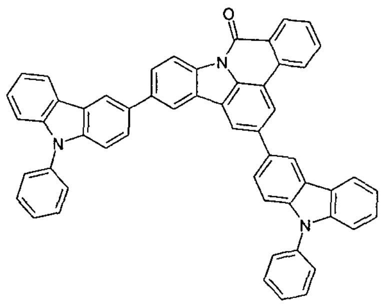 |
| L3 | L4 |

(fortgesetzt)

| | |
|---|---|
| 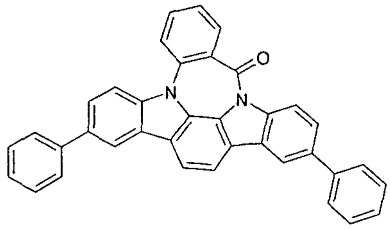 | 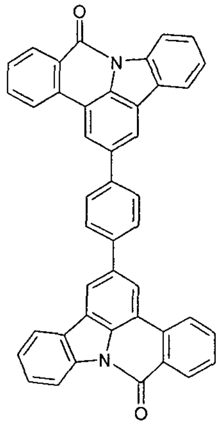 |
| L5 | L6 |
| 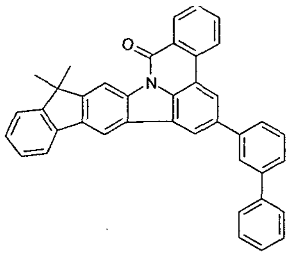 | 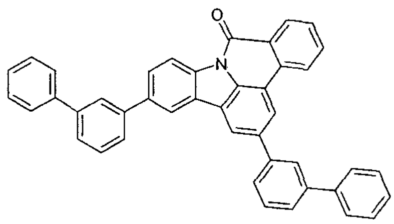 |
| L7 | L8 |
| 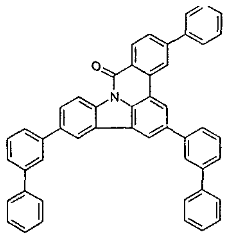 | 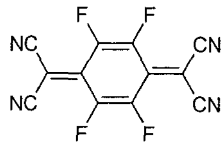 |
| L9 | F4T |
| 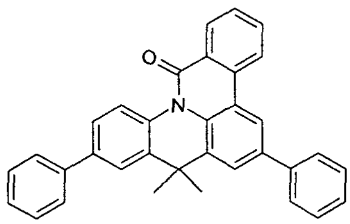 | 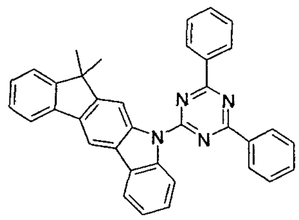 |
| CRL1 | IC1 |
| 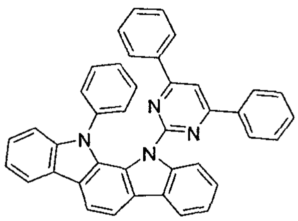 | 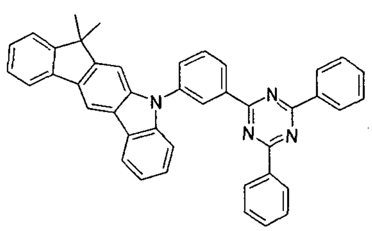 |
| IC2 | IC3 |

(fortgesetzt)

| | |
|---|---|
| 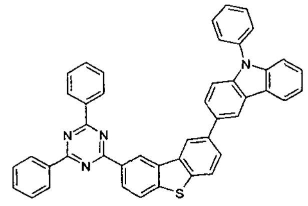 | 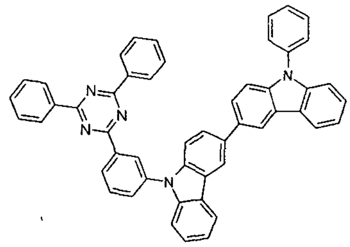 |
| CbzT1 | CbzT2 |
| 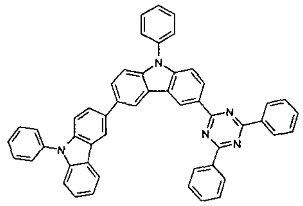 | 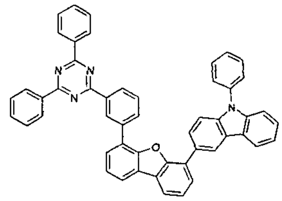 |
| CbzT3 | CbzT4 |
| 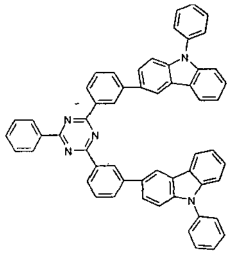 | 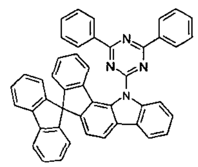 |
| CbzT5 | IC4 |
| 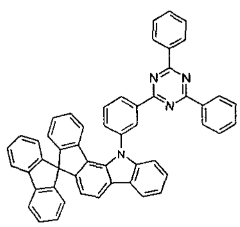 | 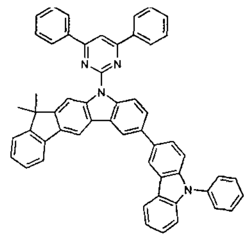 |
| IC5 | IC6 |
| 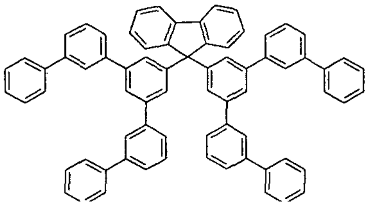 | 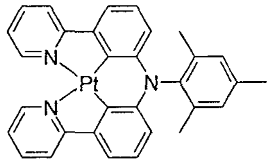 |
| WB1 | TER1 |
| 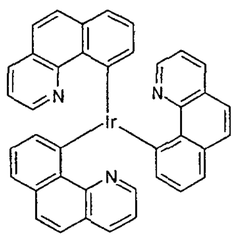 | 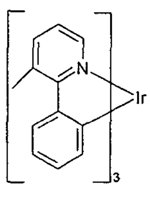 |

(fortgesetzt)

| TEY1 | TEG1 |
|---|---|
| 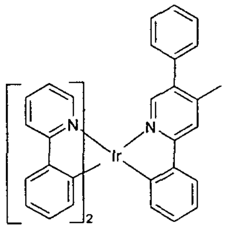 | 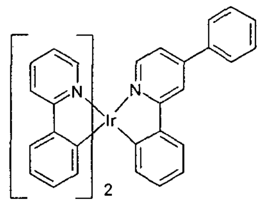 |
| TEG2 | TEY2 |

Tabelle 4: LUMO-Werte

| Material | LUMO (eV) | T1 (eV) | Methode |
|---|---|---|---|
| IC1 | -2.83 | 2.69 | org. |
| IC2 | -2.68 | 2.79 | org. |
| IC3 | -2.87 | 2.72 | org. |
| IC4 | -2.85 | 2.72 | org. |
| IC5 | -2.87 | 2.72 | org. |
| IC6 | -2.74 | 2.73 | org. |
| CRL1 | -2.59 | 2.71 | orq. |
| CbzT1 | -2.76 | 2.84 | orq. |
| CbzT2 | -2.85 | 2.72 | org. |
| CbzT3 | -2.68 | 2.80 | org. |
| CbzT4 | -2.76 | 2.83 | org. |
| CbzT5 | -2.73 | 2.90 | org. |
| WB1 | -2.24 | 2.95 | org. |
| LiQ | -2.30 | 1.81 | M-org. |
| TEG1 | -2.26 | 2.68 | M-org. |
| TEG2 | -2.31 | 2.71 | M-org. |
| TER1 | -2.64 | 2.03 | M-org. |
| TEY1 | -2.51 | 2.60 | M-org. |
| TEY2 | -2.52 | 2.57 | M-org. |
| L1 | -2.82 | 2.68 | org. |
| L7 | -2.80 | 2.58 | org. |
| L8 | -2.83 | 2.68 | org. |

**Patentansprüche**

**1.** Organische Elektrolumineszenzvorrichtung, enthaltend Kathode, Anode und mindestens eine Schicht, die die folgenden Verbindungen enthält:

a) mindestens eine elektronentransportierende Verbindung, die ein LUMO ≤ -2.4 eV aufweist, das durch quantenchemische Rechnungen bestimmt wird; und

b) mindestens eine Verbindung gemäß der folgenden Formel (1) oder (1a),

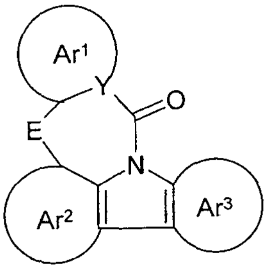

Formel (1)

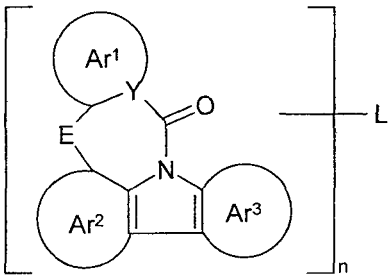

Formel (1a)

wobei für die verwendeten Symbole und Indizes gilt:

E ist eine Einfachbindung oder $NAr^4$;

Y ist C, wenn $Ar^1$ eine 6-Ring-Aryl- oder 6-Ring-Heteroarylgruppe darstellt, bzw. ist C oder N, wenn $Ar^1$ eine 5-Ring-Heteroarylgruppe darstellt;

$Ar^1$ ist zusammen mit der Gruppe Y und dem explizit dargestellten Kohlenstoffatom ein aromatisches oder heteroaromatisches Ringsystem mit 5 bis 30 aromatischen Ringatomen, welches durch einen oder mehrere Reste R substituiert sein kann;

$Ar^2$, $Ar^3$ ist gleich oder verschieden bei jedem Auftreten zusammen mit den explizit dargestellten Kohlenstoffatomen ein aromatisches oder heteroaromatisches Ringsystem mit 5 bis 30 aromatischen Ringatomen, welches durch einen oder mehrere Reste R substituiert sein kann;

$Ar^4$ ist ein aromatisches oder heteroaromatisches Ringsystem mit 5 bis 30 aromatischen Ringatomen, welches durch einen oder mehrere Reste R substituiert sein kann; dabei kann $Ar^4$ auch mit $Ar^2$ oder $Ar^1$ durch eine Einfachbindung verknüpft sein;

L ist für n = 2 eine Einfachbindung oder eine bivalente Gruppe, bzw. für n = 3 eine trivalente Gruppe bzw. für n = 4 eine tetravalente Gruppe, welche jeweils an eine beliebige Position an $Ar^1$, $Ar^2$, $Ar^3$ oder $Ar^4$ gebunden ist;

R ist bei jedem Auftreten gleich oder verschieden ausgewählt aus der Gruppe bestehend aus H, D, F, Cl, Br, I, CN, $NO_2$, $N(Ar^5)_2$, $N(R^1)_2$, $C(=O)Ar^5$, $C(=O)R^1$, $P(=O)(Ar^5)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^1$ substituiert sein kann, wobei eine oder mehrere nicht-benachbarte $CH_2$-Gruppen durch $R^1C=CR^1$, $C\equiv C$, $Si(R^1)_2$, $Ge(R^1)_2$, $Sn(R^1)_2$, C=O, C=S, C=Se, $C=NR^1$, $P(=O)(R^1)$, SO, $SO_2$, $NR^1$, O, S oder $CONR^1$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 80, bevorzugt 5 bis 60, aromatischen Ringatomen, das jeweils mit einem oder mehreren Resten $R^1$ substituiert sein kann, einer Aryloxy- oder Heteroaryloxygruppe mit 5 bis 60 aromatischen Ringatomen, die mit einem oder mehreren Resten $R^1$ substituiert sein kann, oder einer Kombination dieser Systeme, wobei optional zwei oder mehr benachbarte Substituenten R ein monocyclisches oder polycyclisches, aliphatisches, aromatisches oder heteroaromatisches Ringsystem bilden können, das mit einem oder mehreren Resten $R^1$ substituiert sein kann;

$R^1$ ist bei jedem Auftreten gleich oder verschieden ausgewählt aus der Gruppe bestehend aus H, D, F, Cl, Br, I, CN, $NO_2$, $N(Ar^5)_2$, $N(R^2)_2$, $C(=O)Ar^5$, $C(=O)R^2$, $P(=O)(Ar^5)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^2$ substituiert sein kann, wobei eine oder mehrere nicht-benachbarte $CH_2$-Gruppen durch $R^2C=CR^2$, $C\equiv C$, $Si(R^2)_2$, $Ge(R^2)_2$, $Sn(R^2)_2$, C=O, C=S, C=Se, $C=NR^2$, $P(=O)(R^2)$, SO, $SO_2$, $NR^2$, O, S oder $CONR^2$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 60 aromatischen Ringatomen, das jeweils mit einem oder mehreren Resten $R^2$ substituiert sein kann, einer Aryloxy- oder Heteroaryloxygruppe mit 5 bis 60 aromatischen Ringatomen, die mit einem oder mehreren Resten $R^2$ substituiert sein kann, oder einer Kombination dieser Systeme, wobei optional zwei oder mehr benachbarte Substituenten R ein monocyclisches oder polycyclisches, aliphatisches, aromatisches oder heteroaromatisches Ringsystem bilden können, das mit einem oder mehreren Resten $R^2$ substituiert sein

kann;

$Ar^5$ ist bei jedem Auftreten gleich oder verschieden ein aromatisches oder heteroaromatisches Ringsystem mit 5-30 aromatischen Ringatomen, das mit einem oder mehreren nichtaromatischen Resten $R^2$ substituiert sein kann; dabei können zwei Reste $Ar^5$, welche an dasselbe N-Atom oder P-Atom binden, auch durch eine Einfachbindung oder eine Brücke, ausgewählt aus $N(R^2)$, $C(R^2)_2$ oder O, miteinander verbrückt sein;

$R^2$ ist ausgewählt aus der Gruppe bestehend aus H, D, F, CN, einem aliphatischem Kohlenwasserstoffrest mit 1 bis 20 C-Atomen, einem aromatischem oder heteroaromatischem Ringsystem mit 5 bis 30 aromatischen Ringatomen, in dem ein oder mehrere H-Atome durch D, F, Cl, Br, I oder CN ersetzt sein können, wobei zwei oder mehr benachbarte Substituenten $R^2$ miteinander ein mono- oder polycyclisches, aliphatisches, aromatisches oder heteroaromatisches Ringsystem bilden können;

n ist 2, 3 oder 4.

2. Organische Elektrolumineszenzvorrichtung nach Anspruch 1, **dadurch gekennzeichnet, dass** es sich bei der Schicht, die die elektronentransportierende Verbindung mit einem LUMO $\leq$ -2.4 eV und die Verbindung der Formel (1) bzw. (1a) enthält, um eine emittierende Schicht, um eine Elektronentransport- bzw. Elektroneninjektionsschicht oder um eine Lochblockierschicht handelt.

3. Organische Elektrolumineszenzvorrichtung nach Anspruch 1 oder 2, **dadurch gekennzeichnet, dass** das Verhältnis der elektronentransportierenden Verbindung mit einem LUMO $\leq$ -2.4 eV zu der Verbindung gemäß Formel (1) bzw. (1a) zwischen 10:90 und 90:10, bevorzugt zwischen 20:80 und 80:20, besonders bevorzugt zwischen 30:70 und 70:30 und ganz besonders bevorzugt zwischen 40:60 und 60:40 liegt.

4. Organische Elektrolumineszenzvorrichtung nach einem oder mehreren der Ansprüche 1 bis 3, **dadurch gekennzeichnet, dass** in Verbindungen der Formel (1) bzw. (1a) die Gruppe $Ar^1$ für eine Gruppe der Formel (2), (3), (4), (5) oder (6) steht,

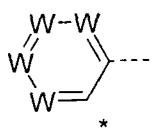
Formel (2)

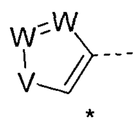
Formel (3)

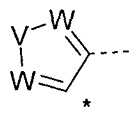
Formel (4)

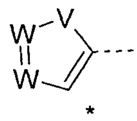
Formel (5)

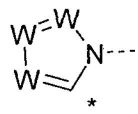
Formel (6)

wobei die gestrichelte Bindung die Verknüpfung mit der Carbonylgruppe andeutet, * die Position der Verknüpfung mit E andeutet und weiterhin gilt:

W ist gleich oder verschieden bei jedem Auftreten CR oder N; oder zwei benachbarte Gruppen W stehen für eine Gruppe der folgenden Formel (7) oder (8),

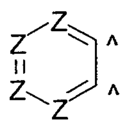
Formel (7)

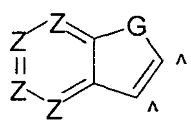
Formel (8)

wobei G für $CR_2$, NR, O oder S steht, Z gleich oder verschieden bei jedem Auftreten für CR oder N steht und ^ die entsprechenden benachbarten Gruppen W in der Formel (2) bis (6) andeuten;

V ist NR, O oder S;

und dass die Gruppe $Ar^2$ für eine Gruppe gemäß einer der Formeln (9), (10) oder (11) steht,

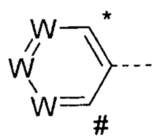
Formel (9)

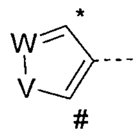
Formel (10)

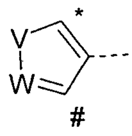
Formel (11)

wobei die gestrichelte Bindung die Verknüpfung mit N andeutet, # die Position der Verknüpfung mit $Ar^3$ andeutet, * die Verknüpfung mit E andeutet und W und V die oben genannten Bedeutungen aufweisen;
und dass die Gruppe $Ar^3$ für eine Gruppe gemäß einer der Formeln (12), (13), (14) oder (15) steht,

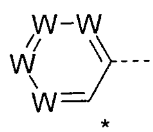
Formel (12)

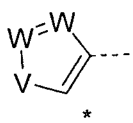
Formel (13)

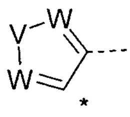
Formel (14)

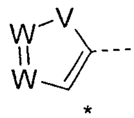
Formel (15)

wobei die gestrichelte Bindung die Verknüpfung mit N andeutet, * die Verknüpfung mit $Ar^2$ andeutet und W und V die oben genannten Bedeutungen aufweisen.

5. Organische Elektrolumineszenzvorrichtung nach einem oder mehreren der Ansprüche 1 bis 4, **dadurch gekennzeichnet, dass** die Verbindung der Formel (1) ausgewählt ist aus den Verbindungen der Formeln (16) bis (32),

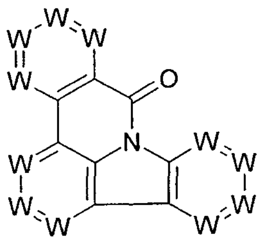
Formel (16)

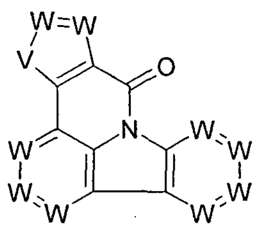
Formel (17)

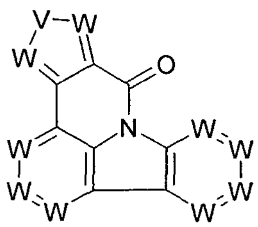
Formel (18)

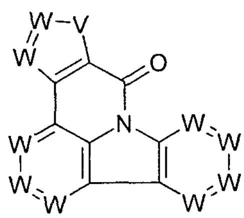
Formel (19)

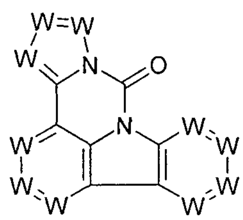
Formel (20)

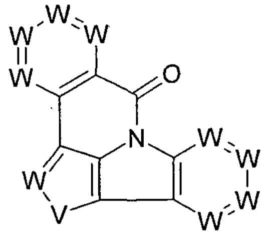
Formel (21)

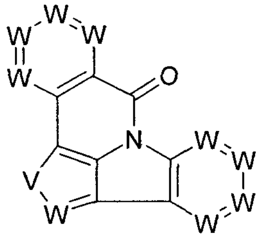
Formel (22)

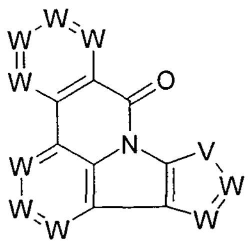
Formel (23)

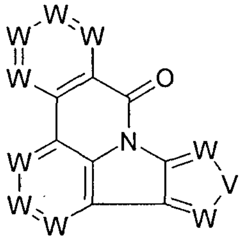
Formel (24)

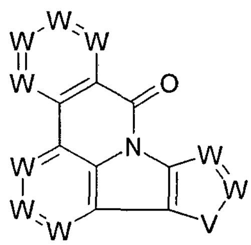
Formel (25)

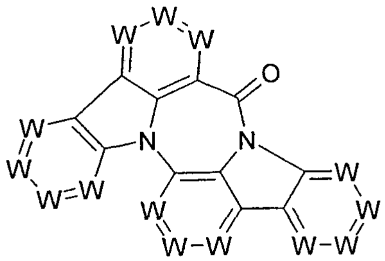
Formel (26)

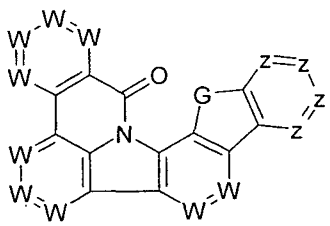
Formel (27)

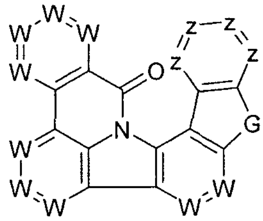
Formel (28)

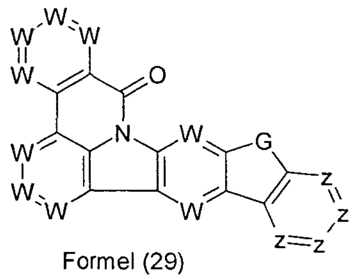
Formel (29)

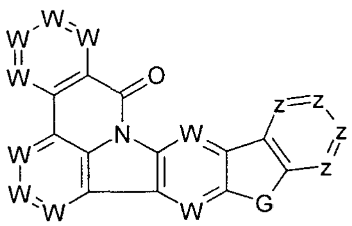
Formel (30)

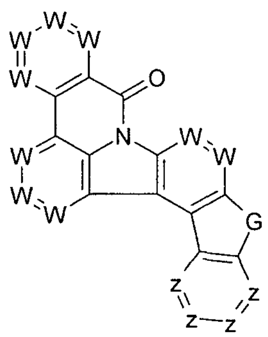
Formel (31)

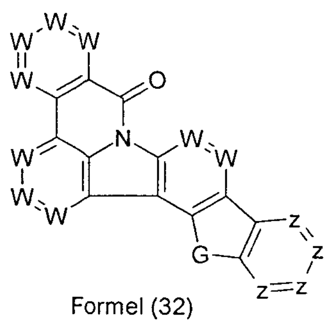
Formel (32)

wobei die verwendeten Symbole die in Anspruch 1 und 4 genannten Bedeutungen aufweisen.

6. Organische Elektrolumineszenzvorrichtung nach einem oder mehreren der Ansprüche 1 bis 5, **dadurch gekennzeichnet, dass** die Verbindung der Formel (1) ausgewählt ist aus den Verbindungen gemäß den Formeln (16a) bis (32a),

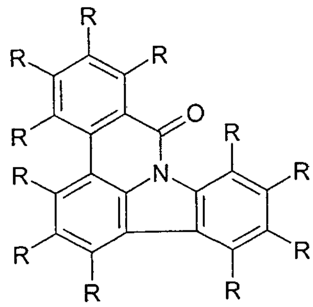
Formel (16a)

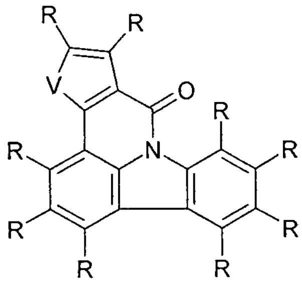
Formel (17a)

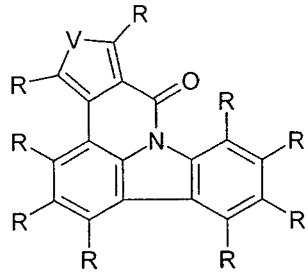
Formel (18a)

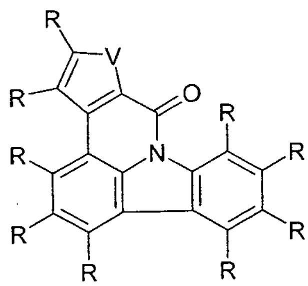
Formel (19a)

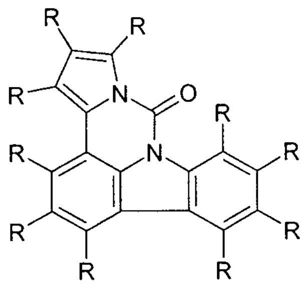
Formel (20a)

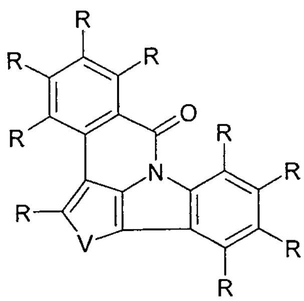
Formel (21a)

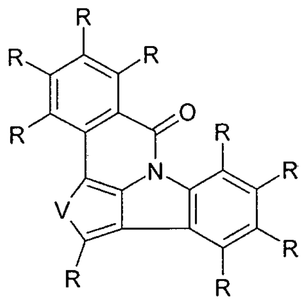
Formel (22a)

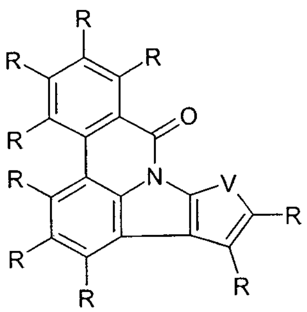
Formel (23a)

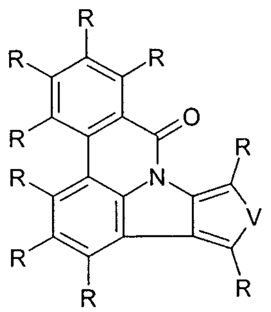
Formel (24a)

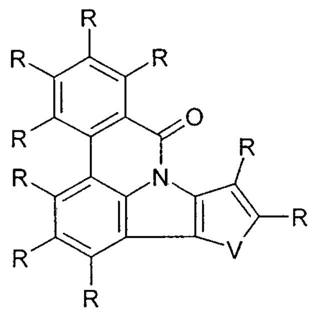
Formel (25a)

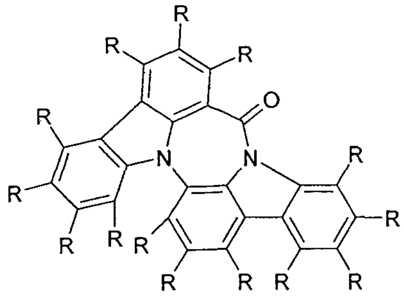

Formel (26a)

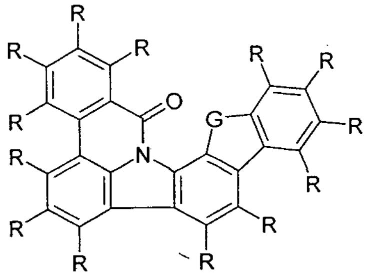

Formel (27a)

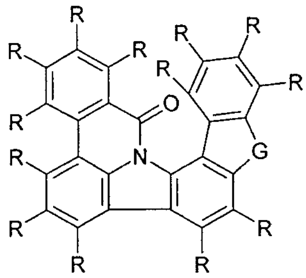

Formel (28a)

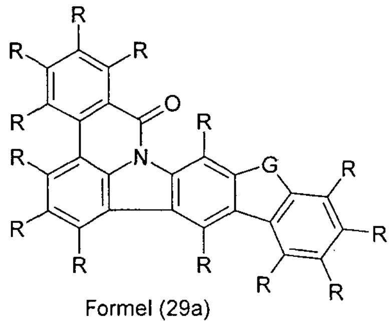

Formel (29a)

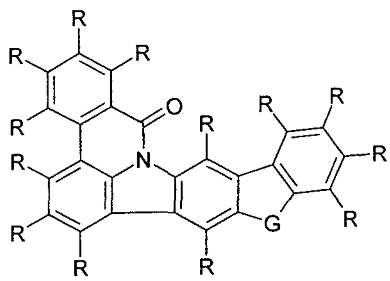

Formel (30a)

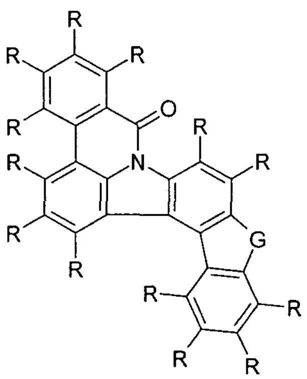

Formel (31a)

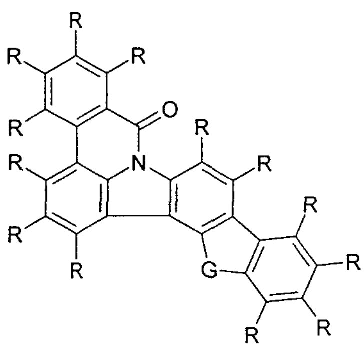

Formel (32a)

wobei die verwendeten Symbole die in Anspruch 1 und 4 genannten Bedeutungen aufweisen.

**7.** Organische Elektrolumineszenzvorrichtung nach einem oder mehreren der Ansprüche 1 bis 6, **dadurch gekennzeichnet, dass** die Verbindung der Formel (1) ausgewählt ist aus den Verbindungen gemäß den Formeln (16b) bis (32b),

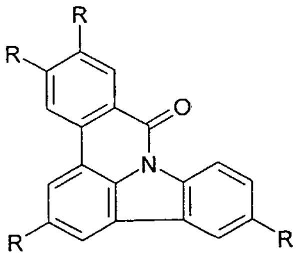

Formel (16b)

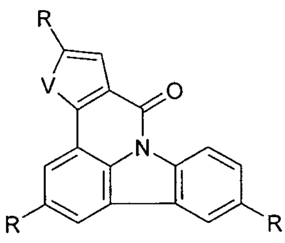

Formel (17b)

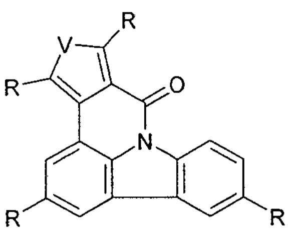

Formel (18b)

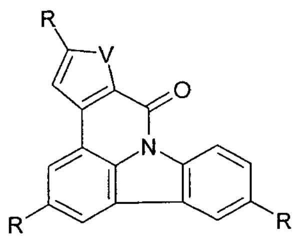
Formel (19b)

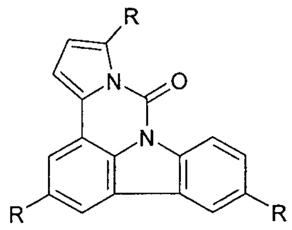
Formel (20b)

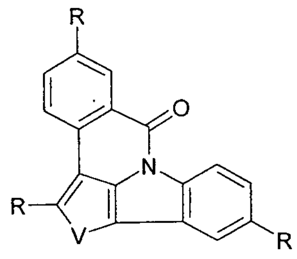
Formel (21b)

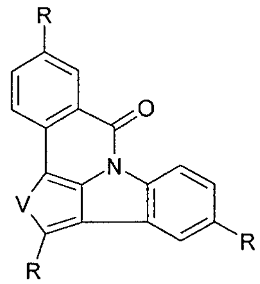
Formel (22b)

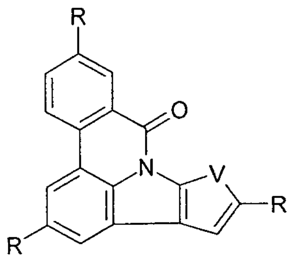
Formel (23b)

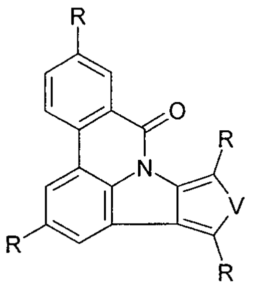
Formel (24b)

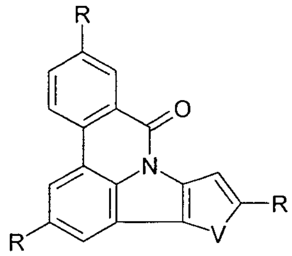
Formel (25b)

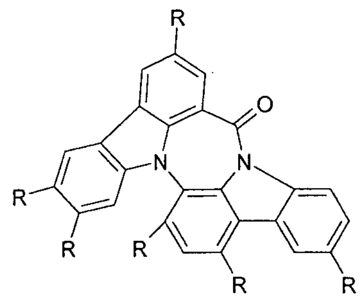
Formel (26b)

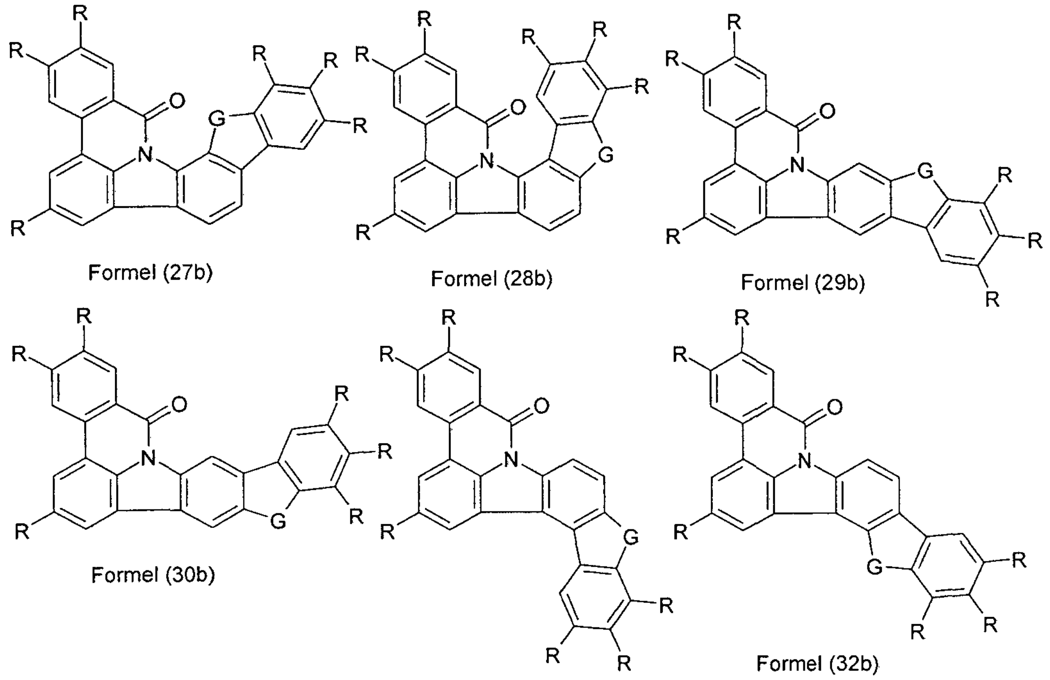

Formel (27b) Formel (28b) Formel (29b)

Formel (30b) Formel (31b) Formel (32b)

wobei die verwendeten Symbole die in Anspruch 1 und 4 genannten Bedeutungen aufweisen.

**8.** Organische Elektrolumineszenzvorrichtung nach einem oder mehreren der Ansprüche 1 bis 7, **dadurch gekennzeichnet, dass** die elektronentransportierende Verbindung mit einem LUMO ≤ -2.4 eV ein LUMO von ≤ -2.5 eV aufweist, bevorzugt ≤ -2.55 eV.

**9.** Organische Elektrolumineszenzvorrichtung nach einem oder mehreren der Ansprüche 1 bis 8, **dadurch gekennzeichnet, dass** die elektronentransportierende Verbindung mit einem LUMO ≤ -2.4 eV mindestens eine Lactamgruppe, mindestens eine Triazingruppe der Formel (T-1) oder mindestens eine Pyrimidingruppe der Formel (P-1), (P-2) oder (P-3) enthält,

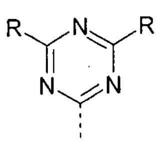
Formel (T-1)

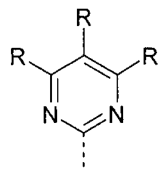
Formel (P-1)

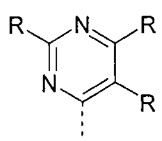
Formel (P-2)

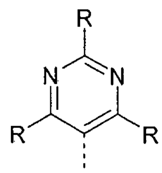
Formel (P-3)

wobei R die in Anspruch 1 genannten Bedeutungen aufweist und die gestrichelte Bindung die Verknüpfung dieser Gruppe darstellt.

**10.** Organische Elektrolumineszenzvorrichtung nach Anspruch 9, **dadurch gekennzeichnet, dass** die elektronentransportierende Verbindung mit einem LUMO ≤ -2.4 eV eine Triazingruppe der Formel (T-1) oder eine Pyrimidingruppe der Formel (P-1), (P-2) oder (P-3) enthält, die direkt oder über eine verbrückende Gruppe an eine Indenocarbazolgruppe, eine Indolocarbazolgruppe oder eine Carbazolgruppe gebunden ist, wobei sowohl die Triazin- bzw. Pyrimidingruppe wie auch die Indenocarbazol- bzw. Indolocarbazol- bzw. Carbazolgruppe durch einen oder mehrere Reste R substituiert sein können und R wie in Anspruch 1 definiert ist.

**11.** Organische Elektrolumineszenzvorrichtung nach Anspruch 10, **dadurch gekennzeichnet, dass** die Indenocarbazolgruppe, die Indolocarbazolgruppe bzw. die Carbazolgruppe ausgewählt sind aus den Strukturen der folgenden Formeln (Indeno-1), (Indeno-2), (Indolo-1), (Carb-1) und (Spiro-1),

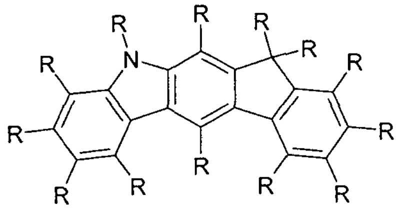

Formel (Indeno-1)

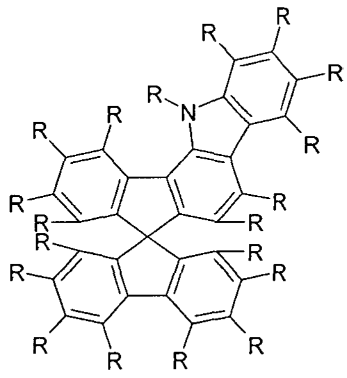

Formel (Indeno-2)

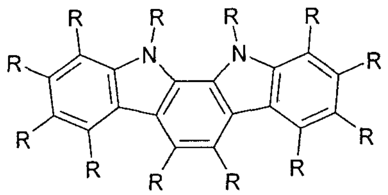

Formel (Indolo-1)

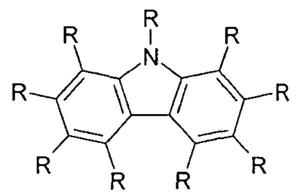

Formel (Carb-1)

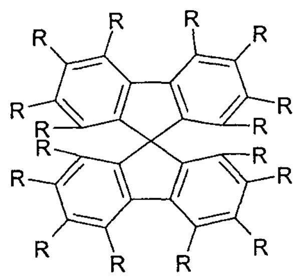

Formel (Spiro-1)

wobei R die in Anspruch 1 genannten Bedeutungen aufweist und diese Gruppen statt einem der Reste R eine Bindung zu der Pyrimidin- bzw. Triazingruppe bzw. zu der verbrückenden Gruppe, die wiederum an die Pyrimidin- bzw. Triazingruppe gebunden ist aufweist.

**12.** Organische Elektrolumineszenzvorrichtung nach einem oder mehreren der Ansprüche 1 bis 11, **dadurch gekennzeichnet, dass** die elektronentransportierende Verbindung mit einem LUMO ≤ -2.4 eV und die Verbindung der Formel (1) bzw. (1a) in einer emittierenden Schicht zusammen mit einer phosphoreszierenden Verbindung eingesetzt werden und dass es sich bei der phosphoreszierenden Verbindung um eine Verbindung handelt, die Iridium, Platin oder Kupfer enthält.

**13.** Verfahren zur Herstellung einer organischen Elektrolumineszenzvorrichtung nach einem oder mehreren der Ansprüche 1 bis 12, **dadurch gekennzeichnet, dass** mindestens eine Schicht mit einem Sublimationsverfahren aufgebracht wird und/oder dass mindestens eine Schicht mit einem OVPD (Organic Vapour Phase Deposition) Verfahren oder mit Hilfe einer Trägergassublimation aufgebracht wird und/oder dass mindestens eine Schicht aus Lösung, durch Spincoating oder mit einem Druckverfahren aufgebracht wird.

**14.** Mischung enthaltend

a) mindestens eine elektronentransportierende Verbindung, die ein LUMO ≤ -2.4 eV aufweist, das durch quantenchemische Rechnungen bestimmt wird; und
b) mindestens eine Verbindung gemäß Formel (1) oder Formel (1a) gemäß Anspruch 1.

**15.** Formulierung enthaltend eine Mischung gemäß Anspruch 14 und mindestens ein Lösemittel.

## Claims

1. Organic electroluminescent device comprising cathode, anode and at least one layer which comprises the following compounds:

a) at least one electron-transporting compound which has an LUMO ≤ -2.4 eV, determined by quantum-chemical calculations; and
b) at least one compound of the following formula (1) or (1a),

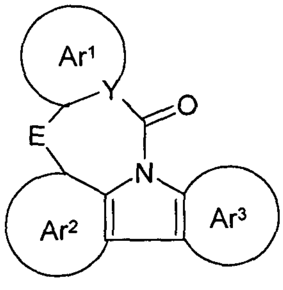
formula (1)

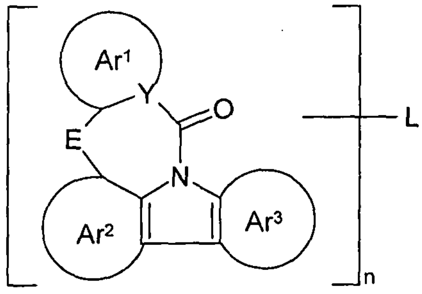
formula (1a)

where the following applies to the symbols and indices used:

E is a single bond or $NAr^4$;
Y is C if $Ar^1$ represents a 6-membered aryl ring group or 6-membered heteroaryl ring group, or is C or N if $Ar^1$ represents a 5-membered heteroaryl ring group;
$Ar^1$, together with the group Y and the carbon atom explicitly depicted, is an aromatic or heteroaromatic ring system having 5 to 30 aromatic ring atoms, which may be substituted by one or more radicals R;
$Ar^2$, $Ar^3$, identically or differently on each occurrence, together with the carbon atoms explicitly depicted, are an aromatic or heteroaromatic ring system having 5 to 30 aromatic ring atoms, which may be substituted by one or more radicals R;
$Ar^4$ is an aromatic or heteroaromatic ring system having 5 to 30 aromatic ring atoms, which may be substituted by one or more radicals R; $Ar^4$ here may also be linked to $Ar^2$ or $Ar^1$ by a single bond;
L is, for n = 2, a single bond or a divalent group, or, for n = 3, a trivalent group or, for n = 4, a tetravalent group, each of which is bonded to $Ar^1$, $Ar^2$, $Ar^3$ or $Ar^4$ at any desired position;
R is selected on each occurrence, identically or differently, from the group consisting of H, D, F, Cl, Br, I, CN, $NO_2$, $N(Ar^5)_2$, $N(R^1)_2$, $C(=O)Ar^5$, $C(=O)R^1$, $P(=O)(Ar^5)_2$, a straight-chain alkyl, alkoxy or thioalkyl group having 1 to 40 C atoms or a branched or cyclic alkyl, alkoxy or thioalkyl group having 3 to 40 C atoms or an alkenyl or alkynyl group having 2 to 40 C atoms, each of which may be substituted by one or more radicals $R^1$, where one or more non-adjacent $CH_2$ groups may be replaced by $R^1C=CR^1$, C≡C, $Si(R^1)_2$, $Ge(R^1)_2$, $Sn(R^1)_2$, C=O, C=S, C=Se, $C=NR^1$, $P(=O)(R^1)$, SO, $SO_2$, $NR^1$, O, S or $CONR^1$ and where one or more H atoms may be replaced by D, F, Cl, Br, I, CN or $NO_2$, an aromatic or heteroaromatic ring system having 5 to 80, preferably 5 to 60, aromatic ring atoms, which may in each case be substituted by one or more radicals $R^1$, an aryloxy or heteroaryloxy group having 5 to 60 aromatic ring atoms, which may be substituted by one or more radicals $R^1$, or a combination of these systems, where two or more adjacent substituents R may optionally form a monocyclic or polycyclic, aliphatic, aromatic or heteroaromatic ring system, which may be substituted by one or more radicals $R^1$;
$R^1$ is selected on each occurrence, identically or differently, from the group consisting of H, D, F, Cl, Br, I, CN, $NO_2$, $N(Ar^5)_2$, $N(R^2)_2$, $C(=O)Ar^5$, $C(=O)R^2$, $P(=O)(Ar^5)_2$, a straight-chain alkyl, alkoxy or thioalkyl group having 1 to 40 C atoms or a branched or cyclic alkyl, alkoxy or thioalkyl group having 3 to 40 C atoms or an alkenyl or alkynyl group having 2 to 40 C atoms, each of which may be substituted by one or more radicals $R^2$, where one or more non-adjacent $CH_2$ groups may be replaced by $R^2C=CR^2$, C=C, $Si(R^2)_2$, $Ge(R^2)_2$, $Sn(R^2)_2$, C=O, C=S, C=Se, $C=NR^2$, $P(=O)(R^2)$, SO, $SO_2$, $NR^2$, O, S or $CONR^2$ and where one or more H atoms may be replaced by D, F, Cl, Br, I, CN or $NO_2$, an aromatic or heteroaromatic ring system having 5 to 60 aromatic ring atoms, which may in each case be substituted by one or more radicals $R^2$, an aryloxy or heteroaryloxy group having 5 to 60 aromatic ring atoms, which may be substituted by one or more radicals $R^2$, or a combination of these systems, where two or more adjacent substituents R may optionally form a monocyclic or polycyclic, aliphatic, aromatic or heteroaromatic ring system, which may

be substituted by one or more radicals $R^2$;

$Ar^5$ is on each occurrence, identically or differently, an aromatic or heteroaromatic ring system having 5-30 aromatic ring atoms, which may be substituted by one or more non-aromatic radicals $R^2$; two radicals $Ar^5$ here which are bonded to the same N atom or P atom may also be bridged to one another by a single bond or a bridge selected from $N(R^2)$, $C(R^2)_2$ or O;

$R^2$ is selected from the group consisting of H, D, F, CN, an aliphatic hydrocarbon radical having 1 to 20 C atoms, an aromatic or heteroaromatic ring system having 5 to 30 aromatic ring atoms, in which one or more H atoms may be replaced by D, F, Cl, Br, I or CN, where two or more adjacent substituents $R^2$ may form a mono- or polycyclic, aliphatic, aromatic or heteroaromatic ring system with one another;

n is 2, 3 or 4.

**2.** Organic electroluminescent device according to Claim 1, **characterised in that** the layer which comprises the electron-transporting compound having an LUMO $\leq$ -2.4 eV and the compound of the formula (1) or (1 a) is an emitting layer, an electron-transport or electron-injection layer or a hole-blocking layer.

**3.** Organic electroluminescent device according to Claim 1 or 2, **characterised in that** the ratio of the electron-transporting compound having an LUMO $\leq$ -2.4 eV to the compound of the formula (1) or (1a) is between 10:90 and 90:10, preferably between 20:80 and 80:20, particularly preferably between 30:70 and 70:30 and very particularly preferably between 40:60 and 60:40.

**4.** Organic electroluminescent device according to one or more of Claims 1 to 3, **characterised in that** the group $Ar^1$ in compounds of the formula

(1) or (1a) stands for a group of the formula (2), (3), (4), (5) or (6),

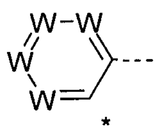
formula (2)

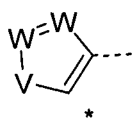
formula (3)

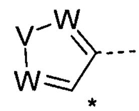
formula (4)

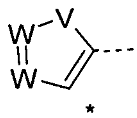
formula (5)

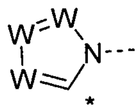
formula (6)

where the dashed bond indicates the link to the carbonyl group, * indicates the position of the link to E, and furthermore:

W, identically or differently on each occurrence, is CR or N; or two adjacent groups W stand for a group of the following formula (7) or (8),

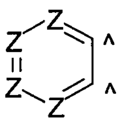
formula (7)

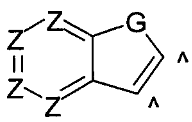
formula (8)

where G stands for $CR_2$, NR, O or S, Z stands, identically or differently on each occurrence, for CR or N, and ^ indicates the corresponding adjacent groups W in the formulae (2) to (6);

V is NR, O or S;

and **in that** the group $Ar^2$ stands for a group of one of the formulae (9), (10) or (11),

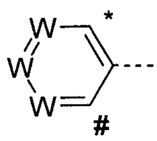

formula (9)

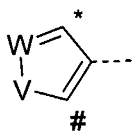

formula (10)

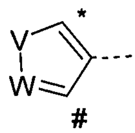

formula (11)

where the dashed bond indicates the link to N, # indicates the position of the link to $Ar^3$, * indicates the link to E, and W and V have the meanings given above;
and **in that** the group $Ar^3$ stands for a group of one of the formulae (12), (13), (14) or (15),

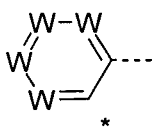

formula (12)

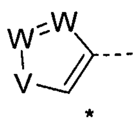

formula (13)

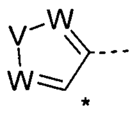

formula (14)

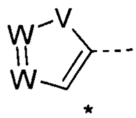

formula (15)

where the dashed bond indicates the link to N, * indicates the link to $Ar^2$, and W and V have the meanings given above.

**5.** Organic electroluminescent device according to one or more of Claims 1 to 4, **characterised in that** the compound of the formula (1) is selected from the compounds of the formulae (16) to (32),

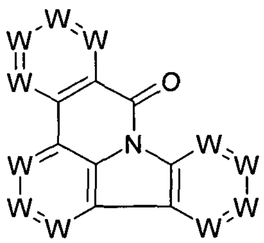

formula (16)

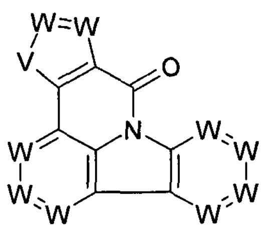

formula (17)

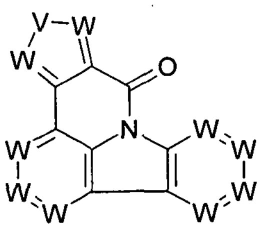

formula (18)

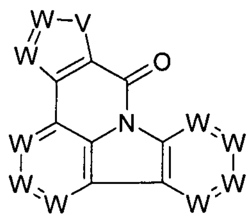

formula (19)

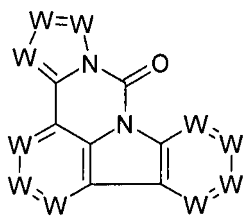

formula (20)

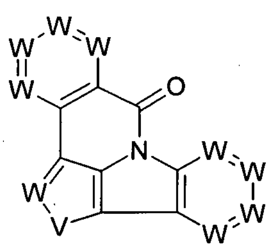

formula (21)

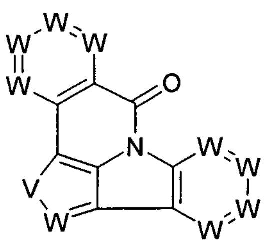

formula (22)

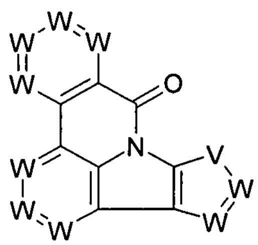

formula (23)

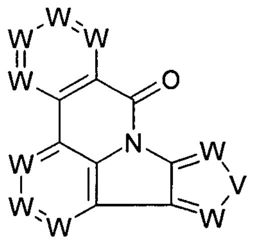

formula (24)

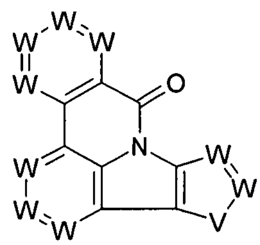

formula (25)

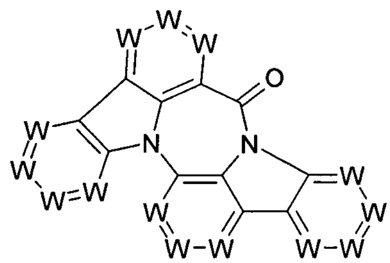

formula (26)

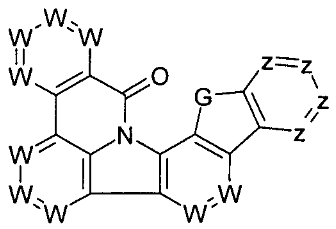

formula (27)

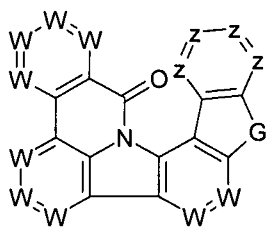

formula (28)

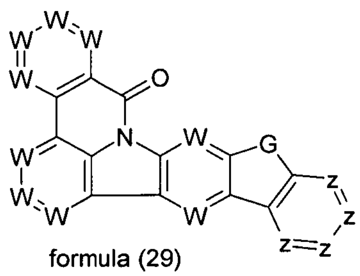

formula (29)

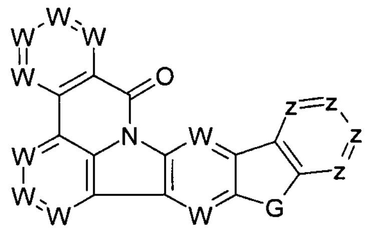

formula (30)

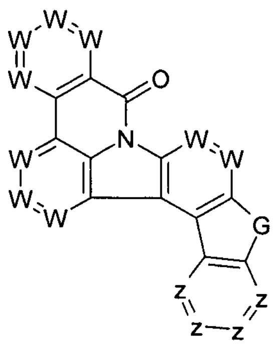

formula (31)

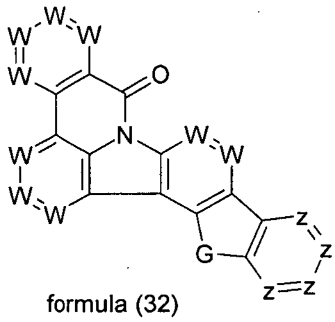

formula (32)

where the symbols used have the meanings given in Claims 1 and 4.

**6.** Organic electroluminescent device according to one or more of Claims 1 to 5, **characterised in that** the compound of the formula (1) is selected from the compounds of the formulae (16a) to (32a),

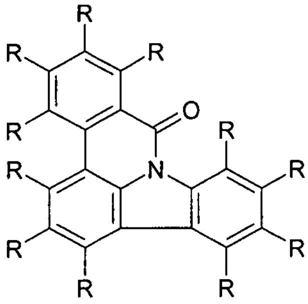
formula (16a)

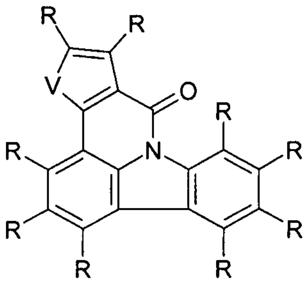
formula (17a)

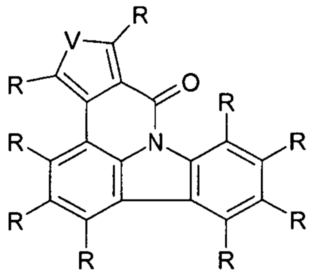
formula (18a)

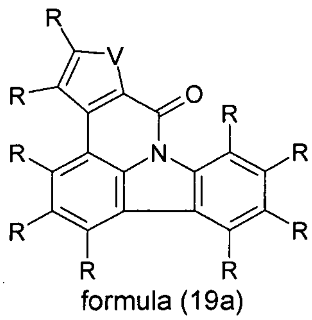
formula (19a)

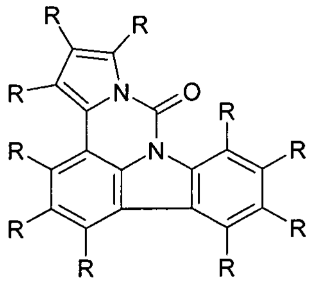
formula (20a)

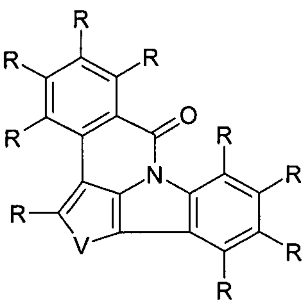
formula (21a)

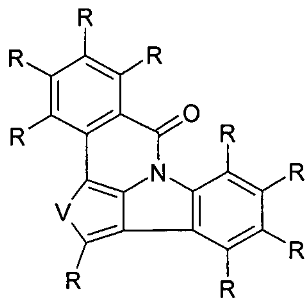
formula (22a)

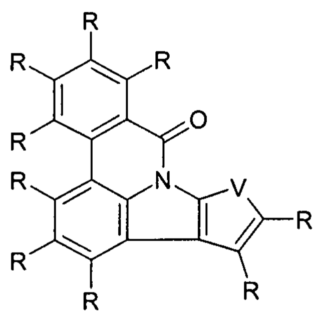
formula (23a)

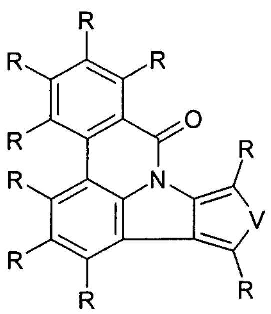
formula (24a)

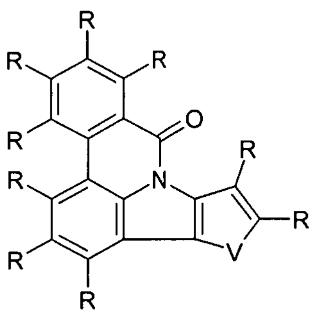
formula (25a)

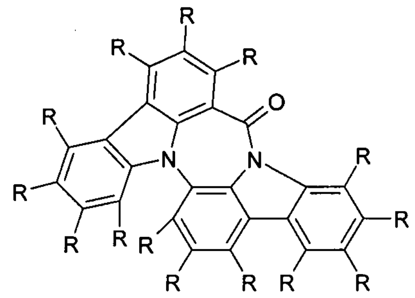

formula (26a)

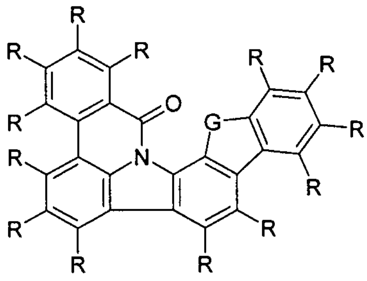

formula (27a)

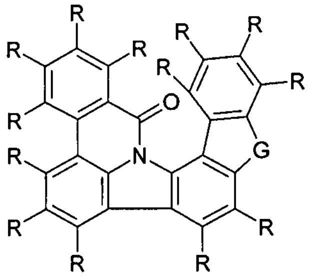

formula (28a)

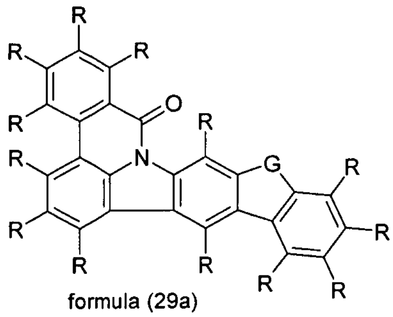

formula (29a)

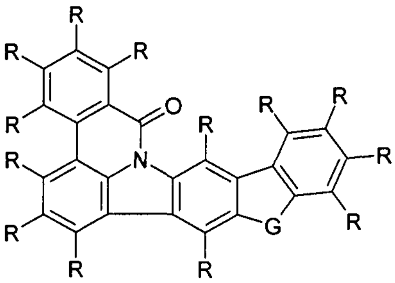

formula (30a)

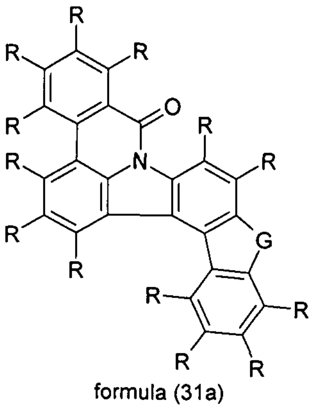

formula (31a)

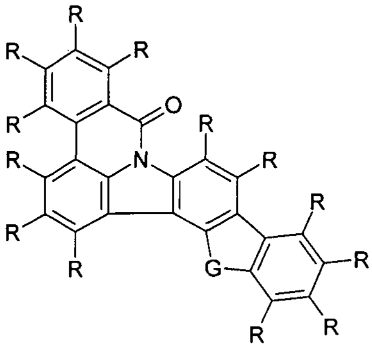

formula (32a)

where the symbols used have the meanings given in Claims 1 and 4.

**7.** Organic electroluminescent device according to one or more of Claims 1 to 6, **characterised in that** the compound of the formula (1) is selected from the compounds of the formulae (16b) to (32b),

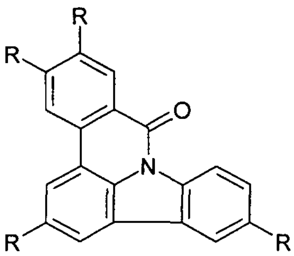

formula (16b)

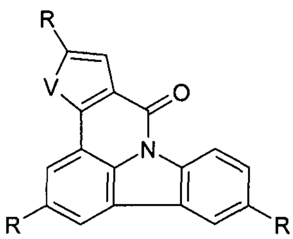

formula (17b)

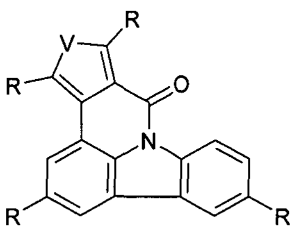

formula (18b)

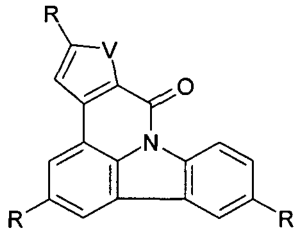
formula (19b)

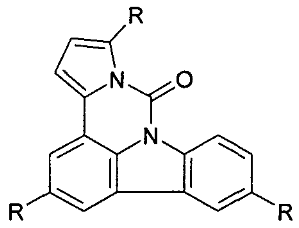
formula (20b)

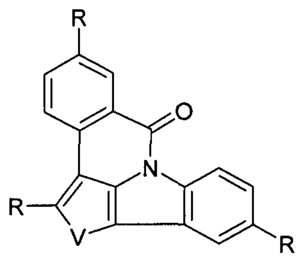
formula (21b)

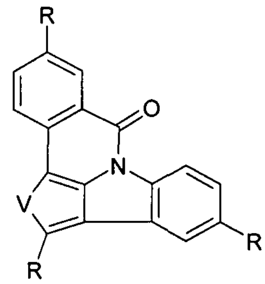
formula (22b)

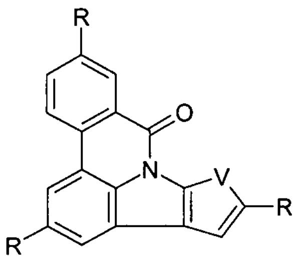
formula (23b)

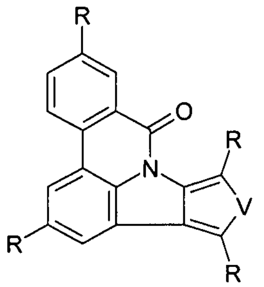
formula (24b)

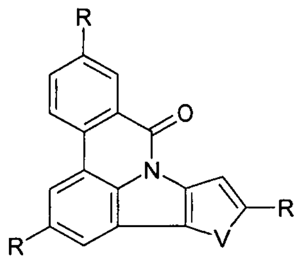
formula (25b)

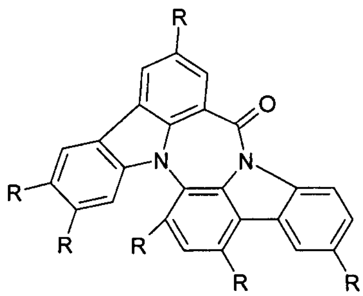
formula (26b)

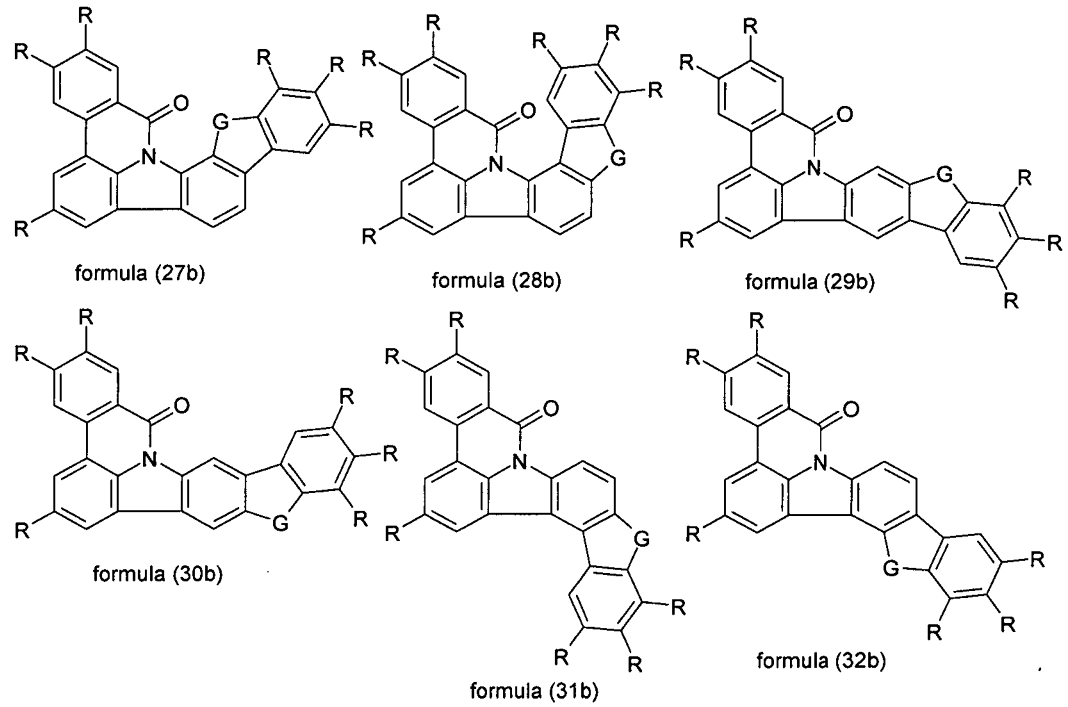

formula (27b) formula (28b) formula (29b)

formula (30b) formula (31b) formula (32b)

where the symbols used have the meanings given in Claims 1 and 4.

8. Organic electroluminescent device according to one or more of Claims 1 to 7, **characterised in that** the electron-transporting compound having an LUMO ≤-2.4 eV has an LUMO of ≤ -2.5 eV, preferably ≤ -2.55 eV.

9. Organic electroluminescent device according to one or more of Claims 1 to 8, **characterised in that** the electron-transporting compound having an LUMO≤ -2.4 eV contains at least one lactam group, at least one triazine group of the formula (T-1) or at least one pyrimidine group of the formula (P-1), (P-2) or (P-3),

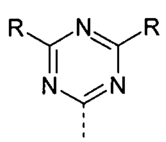
formula (T-1)

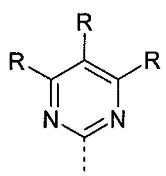
formula (P-1)

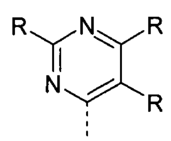
formula (P-2)

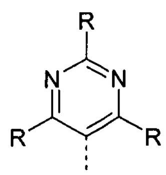
formula (P-3)

where R has the meanings given in Claim 1 and the dashed bond represents the linking of this group.

10. Organic electroluminescent device according to Claim 9, **characterised in that** the electron-transporting compound having an LUMO ≤ -2.4 eV contains a triazine group of the formula (T-1) or a pyrimidine group of the formula (P-1), (P-2) or (P-3) which is bonded directly or via a bridging group to an indenocarbazole group, an indolocarbazole group or a carbazole group, where both the triazine or pyrimidine group and also the indenocarbazole or indolocarbazole or carbazole group may be substituted by one or more radicals R, and R is as defined in Claim 1.

11. Organic electroluminescent device according to Claim 10, **characterised in that** the indenocarbazole group, the indolocarbazole group or the carbazole group is selected from the structures of the following formulae (indeno-1), (indeno-2), (indolo-1), (carb-1) and (spiro-1),

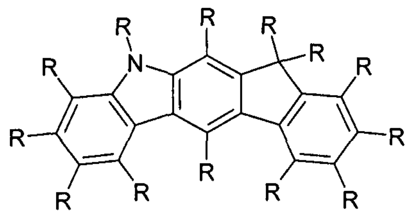

formula (indeno-1)

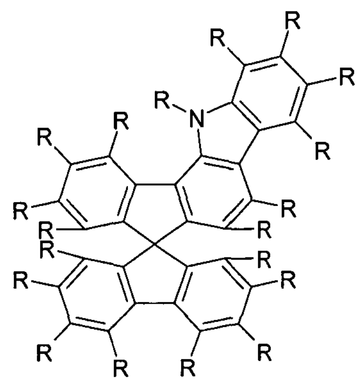

formula (indeno-2)

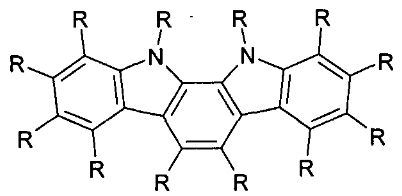

formula (indolo-1)

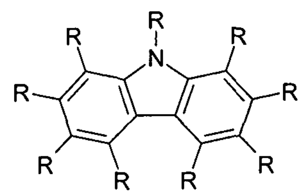

formula (carb-1)

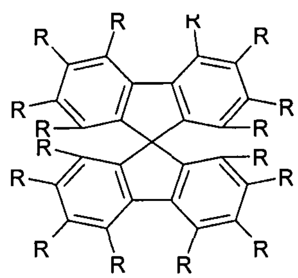

formula (spiro-1)

where R has the meanings given in Claim 1, and, instead of one of the radicals R, these groups have a bond to the pyrimidine or triazine group or to the bridging group, which is in turn bonded to the pyrimidine or triazine group.

**12.** Organic electroluminescent device according to one or more of Claims 1 to 11, **characterised in that** the electron-transporting compound having an LUMO ≤ -2.4 eV and the compound of the formula (1) or (1 a) are employed in an emitting layer together with a phosphorescent compound, and **in that** the phosphorescent compound is a compound which contains iridium, platinum or copper.

**13.** Process for the production of an organic electroluminescent device according to one or more of Claims 1 to 12, **characterised in that** at least one layer is applied by means of a sublimation process and/or **in that** at least one layer is applied by means of an OVPD (organic vapour phase deposition) process or with the aid of carrier-gas sublimation and/or **in that** at least one layer is applied from solution, by spin coating or by means of a printing process.

**14.** Mixture comprising

a) at least one electron-transporting compound which has an LUMO ≤ -2.4 eV, determined by quantum-chemical calculations; and
b) at least one compound of the formula (1) or formula (1a) according to Claim 1.

**15.** Formulation comprising a mixture according to Claim 14 and at least one solvent.

## Revendications

**1.** Dispositif électroluminescent organique comprenant une cathode, une anode et au moins une couche qui comprend les composés qui suivent :

a) au moins un composé de transport d'électrons qui présente une plus basse orbitale moléculaire inoccupée LUMO $\leqq$ -2,4 eV, déterminée au moyen de calculs de la chimie quantique ; et
b) au moins un composé de la formule (1) ou de la formule (1a) qui suit :

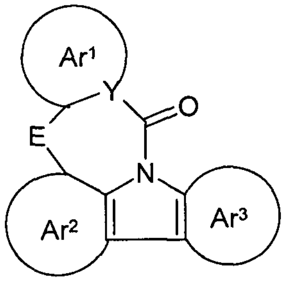
formule (1)

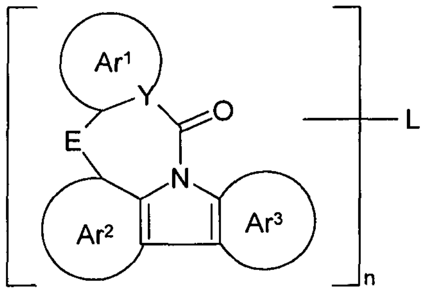
formule (1a)

dans lesquelles ce qui suit s'applique aux symboles et indices utilisés :

E est une liaison simple ou $NAr^4$;
Y est C si $Ar^1$ représente un groupe cyclique aryle à 6 éléments ou un groupe cyclique hétéroaryle à 6 éléments, ou est C ou N si $Ar^1$ représente un groupe cyclique hétéroaryle à 5 éléments ;
$Ar^1$, en association avec le groupe Y et l'atome de carbone représentés de façon explicite, est un système de cycle aromatique ou hétéroaromatique comportant 5 à 30 atomes de cycle aromatique, lequel peut être substitué par un radical ou plusieurs radicaux R ;
$Ar^2$, $Ar^3$ sont, de manière identique ou différente pour chaque occurrence, en association avec les atomes de carbone représentés de façon explicite, un système de cycle aromatique ou hétéroaromatique comportant 5 à 30 atomes de cycle aromatique, lequel peut être substitué par un radical ou plusieurs radicaux R ;
$Ar^4$ est un système de cycle aromatique ou hétéroaromatique comportant 5 à 30 atomes de cycle aromatique, lequel peut être substitué par un radical ou plusieurs radicaux R ; $Ar^4$ peut ici également être lié à $Ar^2$ ou $Ar^1$ par une liaison simple ;
L est, pour n = 2, une liaison simple ou un groupe divalent, ou, pour n = 3, un groupe trivalent ou, pour n = 4, un groupe tétravalent, dont chacun est lié à $Ar^1$, $Ar^2$, $Ar^3$ ou $Ar^4$ au niveau de n'importe quelle position souhaitée ;
R est choisi pour chaque occurrence, de manière identique ou différente, parmi le groupe constitué par H, D, F, Cl, Br, I, CN, $NO_2$ $N(Ar^5)2$, $N(R^1)_2$, $C(=O)A_r{}^5$, $C(=O)R^1$, $P(=O)(Ar^5)_2$, un groupe alkyle, alcoxy ou thioalkyle en chaîne droite comportant 1 à 40 atome(s) de C ou un groupe alkyle, alcoxy ou thioalkyle ramifié ou cyclique comportant 3 à 40 atomes de C ou un groupe alkényle ou alkynyle comportant 2 à 40 atomes de C, dont chacun peut être substitué par un radical ou plusieurs radicaux $R^1$, où un ou plusieurs groupe(s) $CH_2$ non adjacents peut/peuvent être remplacé(s) par $R^1C=CR^1$, C=C, $Si(R^1)_2$, $Ge(R^1)_2$, $Sn(R^1)_2$, C=O, C=S, C=Se, $C=NR^1$, $P(=O)(R^1)$, SO, $SO_2$, $NR^1$, O, S ou $CONR^1$ et où un ou plusieurs atome(s) de H peut/peuvent être remplacé(s) par D, F, Cl, Br, I, CN ou $NO_2$, un système de cycle aromatique ou hétéroaromatique comportant 5 à 80, de façon préférable 5 à 60, atomes de cycle aromatique, lequel peut dans chaque cas être substitué par un radical ou plusieurs radicaux $R^1$, un groupe aryloxy ou hétéroaryloxy comportant 5 à 60 atomes de cycle aromatique, lequel peut être substitué par un radical ou plusieurs radicaux $R^1$, ou une combinaison de ces systèmes, où deux substituants R adjacents ou plus peuvent en option former un système de cycle aliphatique, aromatique ou hétéroaromatique monocyclique ou polycyclique, lequel peut être substitué par un radical ou plusieurs radicaux $R^1$ ;
$R^1$ est choisi pour chaque occurrence, de manière identique ou différente, parmi le groupe constitué par H, D, F, Cl, Br, I, CN, $NO_2$ $N(Ar^5)_2$, $N(R^2)2$, $C(=O)Ar^5$, $C(=O)R^2$, $P(=O)(Ar^5)_2$, un groupe alkyle, alcoxy ou thioalkyle en chaîne droite comportant 1 à 40 atome(s) de C ou un groupe alkyle, alcoxy ou thioalkyle ramifié ou cyclique comportant 3 à 40 atomes de C ou un groupe alkényle ou alkynyle comportant 2 à 40 atomes de C, dont chacun peut être substitué par un radical ou plusieurs radicaux $R^2$, où un ou plusieurs groupe(s) $CH_2$ non adjacents peut/peuvent être remplacé(s) par $R^2C=CR^2$, C=C, $Si(R^2)_2$, $Ge(R^2)_2$, $Sn(R^2)_2$,

C=O, C=S, C=Se, C=NR$^2$, P(=O)(R$^2$), SO, SO$_2$, NR$^2$, O, S ou CONR$^2$ et où un ou plusieurs atome(s) de H peut/peuvent être remplacé(s) par D, F, Cl, Br, I, CN ou NO$_2$ un système de cycle aromatique ou hétéroaromatique comportant 5 à 60 atomes de cycle aromatique, lequel peut dans chaque cas être substitué par un radical ou plusieurs radicaux R$^2$, un groupe aryloxy ou hétéroaryloxy comportant 5 à 60 atomes de cycle aromatique, lequel peut être substitué par un radical ou plusieurs radicaux R$^2$, ou une combinaison de ces systèmes, où deux substituants R adjacents ou plus peuvent en option former un système de cycle aliphatique, aromatique ou hétéroaromatique monocyclique ou polycyclique, lequel peut être substitué par un radical ou plusieurs radicaux R$^2$ ;

Ar$^5$ est pour chaque occurrence, de manière identique ou différente, un système de cycle aromatique ou hétéroaromatique comportant 5-30 atomes de cycle aromatique, lequel peut être substitué par un radical ou plusieurs radicaux R$^2$ non aromatique(s) ; deux radicaux Ar$^5$ ici qui sont liés au même atome de N ou au même atome de P peuvent également être pontés l'un à l'autre par une liaison simple ou un pont choisi parmi N(R$^2$), C(R$^2$)$_2$ ou O ;

R$^2$ est choisi parmi le groupe constitué par H, D, F, CN, un radical hydrocarbone aliphatique comportant 1 à 20 atome(s) de C, un système de cycle aromatique ou hétéroaromatique comportant 5 à 30 atomes de cycle aromatique, où un ou plusieurs atome(s) de H peut/peuvent être remplacé(s) par D, F, Cl, Br, I ou CN, où deux substituants R$^2$ adjacents ou plus peuvent former un système de cycle aliphatique, aromatique ou hétéroaromatique monocyclique ou polycyclique l'un avec l'autre ou les uns avec les autres ;

n est 2, 3 ou 4.

2. Dispositif électroluminescent organique selon la revendication 1, **caractérisé en ce que** la couche qui comprend le composé de transport d'électrons présentant une LUMO ≤ -2,4 eV et le composé de la formule (1) ou de la formule (1a) est une couche d'émission, une couche de transport d'électrons ou une couche d'injection d'électrons ou une couche de blocage de trous.

3. Dispositif électroluminescent organique selon la revendication 1 ou 2, **caractérisé en ce que** le rapport du composé de transport d'électrons présentant une LUMO≤ -2,4 eV sur le composé de la formule (1) ou de la formule (1a) est entre 10:90 et 90:10, de façon préférable entre 20:80 et 80:20, de façon particulièrement préférable entre 30:70 et 70:30 et de façon très particulièrement préférable entre 40:60 et 60:40.

4. Dispositif électroluminescent organique selon une ou plusieurs des revendications 1 à 3, **caractérisé en ce que** le groupe Ar$^1$ dans les composés de la formule (1) ou de la formule (1a) représente un groupe de la formule (2), de la formule (3), de la formule (4), de la formule (5) ou de la formule (6) :

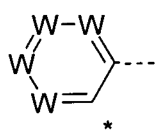
formule (2)

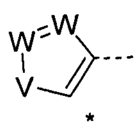
formule (3)

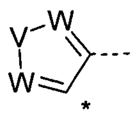
formule (4)

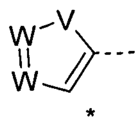
formule (5)

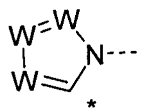
formule (6)

dans lesquelles la liaison en pointillés indique le lien sur le groupe carbonyle, * indique la position du lien sur E, et en outre :

W est, de manière identique ou différente pour chaque occurrence, CR ou N ; ou deux groupes W adjacents représentent un groupe de la formule (7) ou de la formule (8) qui suit :

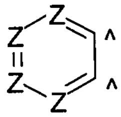
formule (7)

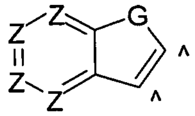
formule (8)

où G représente CR$_2$, NR, O ou S, Z représente, de manière identique ou différente pour chaque occurrence, CR ou N, et ^ indique les groupes adjacents correspondants W dans les formules (2) à (6) ;

V est NR,O ou S;

et **en ce que** le groupe $Ar^2$ représente un groupe de l'une des formules (9), (10) ou (11):

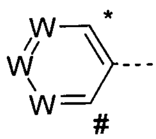
formule (9)

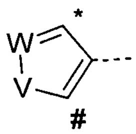
formule (10)

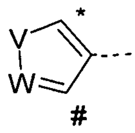
formule (11)

dans lesquelles la liaison en pointillés indique le lien sur N, # indique la position du lien sur $Ar^3$, * indique le lien sur E, et W et V présentent les significations données ci avant ;
et **en ce que** le groupe $Ar^3$ représente un groupe de l'une des formules (12), (13), (14) ou (15) :

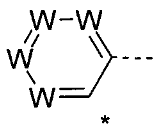
formule (12)

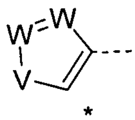
formule (13)

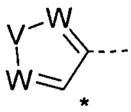
formule (14)

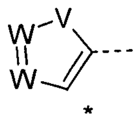
formule (15)

dans lesquelles la liaison en pointillés indique le lien sur N, * indique le lien sur $Ar^2$, et W et V présentent les significations données ci avant.

5. Dispositif électroluminescent organique selon une ou plusieurs des revendications 1 à 4, **caractérisé en ce que** le composé de la formule (1) est choisi parmi les composés des formules (16) à (32) :

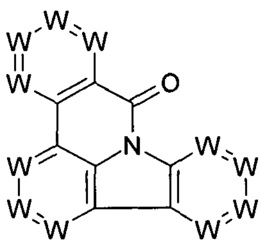
formule (16)

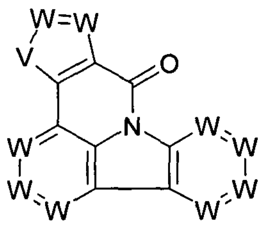
formule (17)

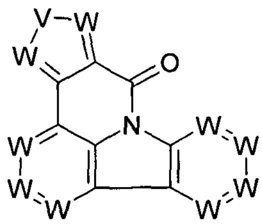
formule (18)

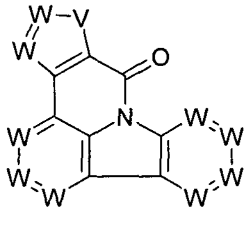
formule (19)

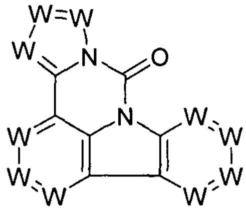
formule (20)

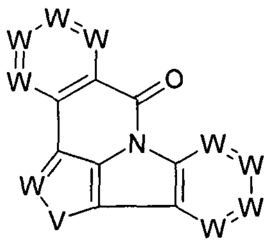

formule (21)

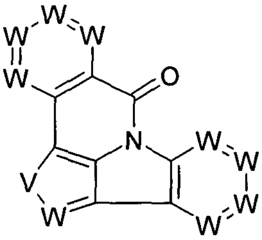

formule (22)

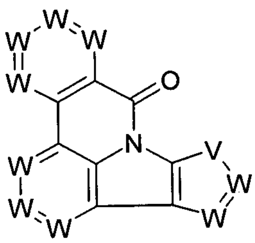

formule (23)

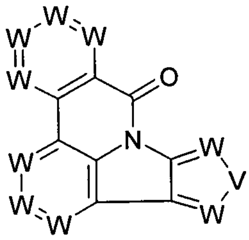

formule (24)

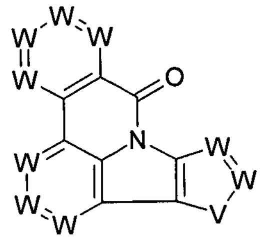

formule (25)

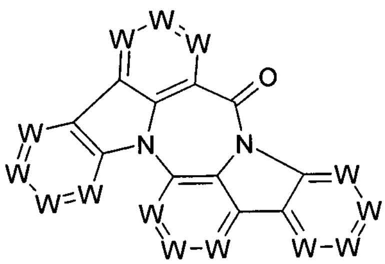

formule (26)

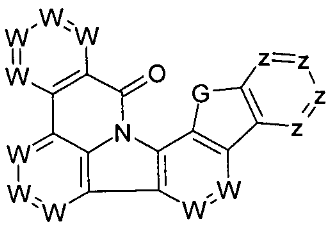

formule (27)

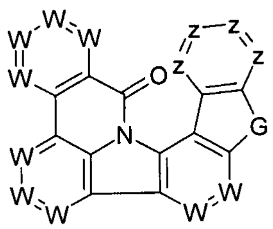

formule (28)

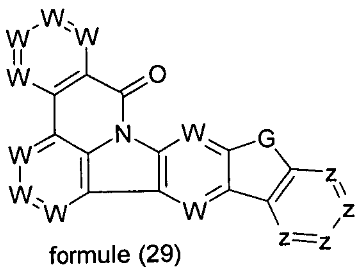

formule (29)

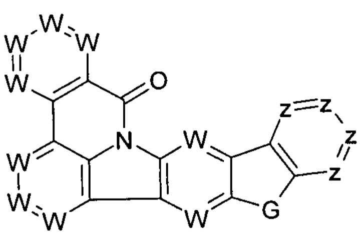

formule (30)

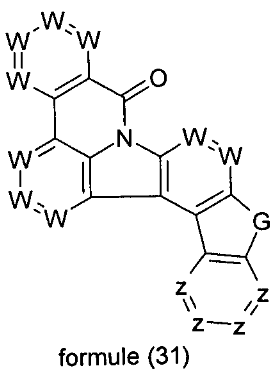

formule (31)

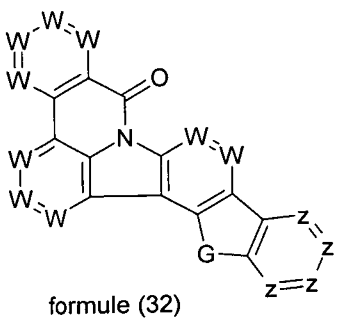

formule (32)

dans lesquelles les symboles utilisés présentent les significations données selon les revendications 1 et 4.

6. Dispositif électroluminescent organique selon une ou plusieurs des revendications 1 à 5, **caractérisé en ce que** le composé de la formule (1) est choisi parmi les composés des formules (16a) à (32a) :

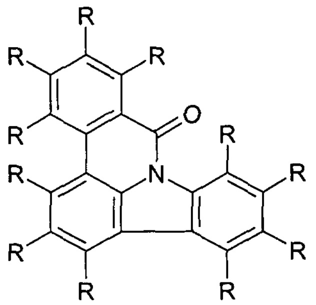
formule (16a)

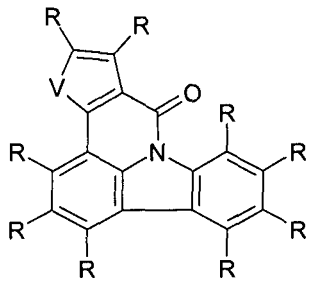
formule (17a)

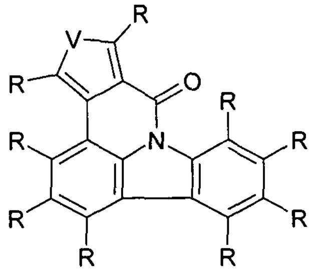
formule (18a)

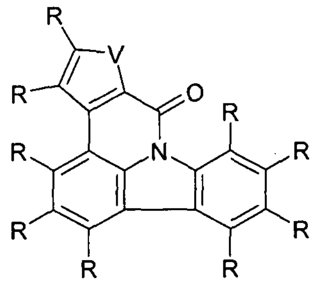
formule (19a)

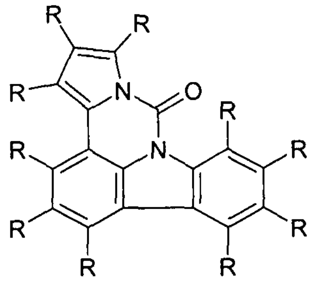
formule (20a)

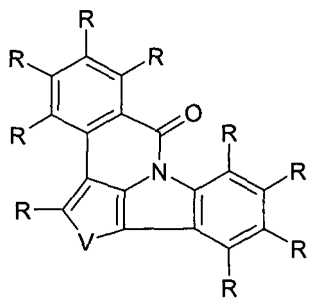
formule (21a)

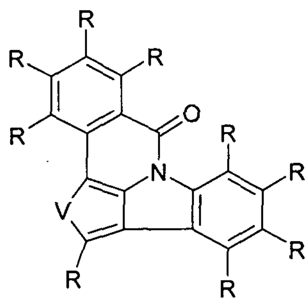
formule (22a)

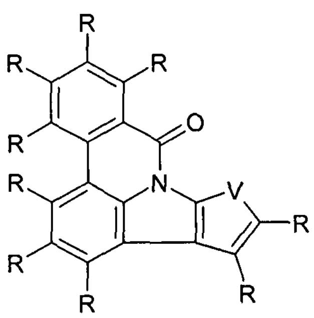
formule (23a)

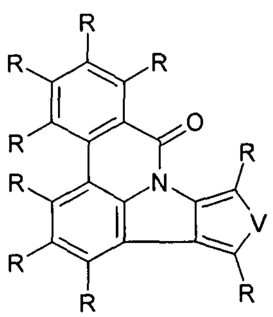
formule (24a)

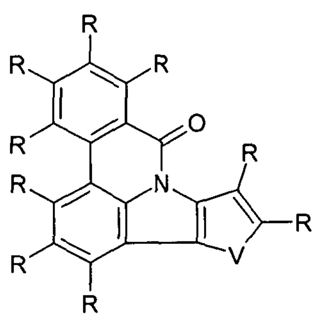
formule (25a)

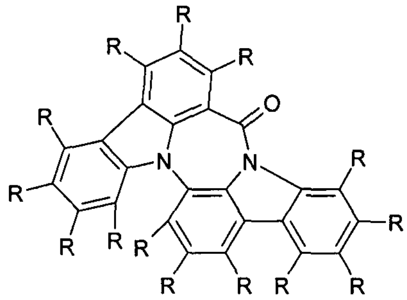

formule (26a)

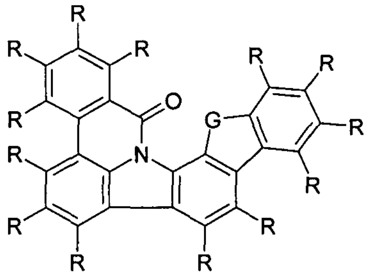

formule (27a)

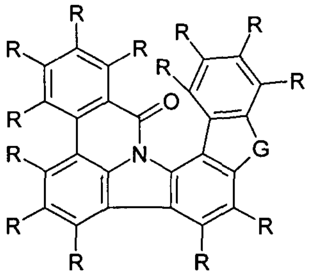

formule (28a)

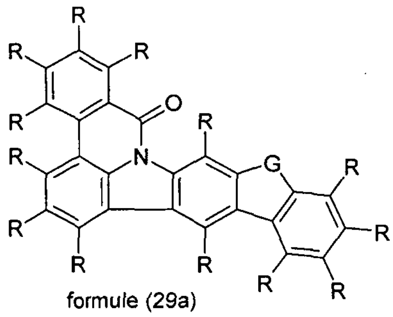

formule (29a)

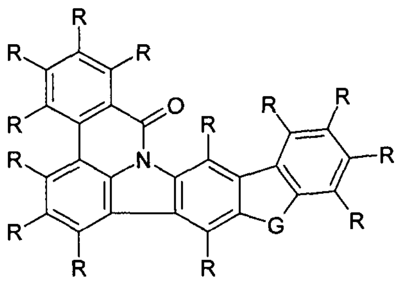

formule (30a)

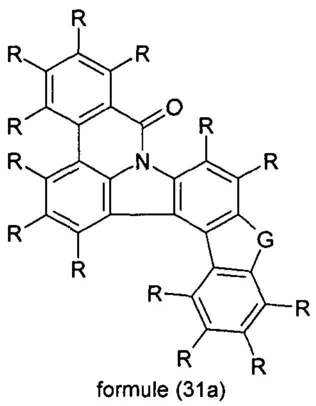

formule (31a)

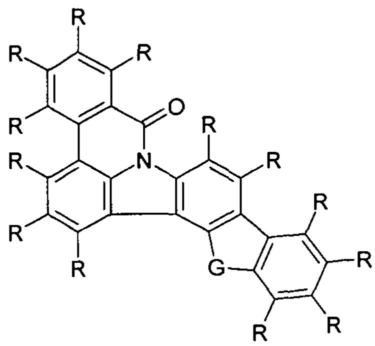

formule (32a)

dans lesquelles les symboles utilisés présentent les significations données selon les revendications 1 et 4.

7. Dispositif électroluminescent organique selon une ou plusieurs des revendications 1 à 6, **caractérisé en ce que** le composé de la formule (1) est choisi parmi les composés des formules (16b) à (32b) :

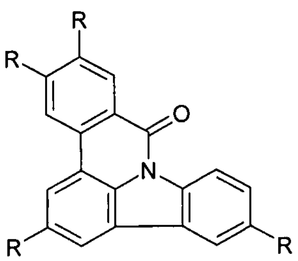

formule (16b)

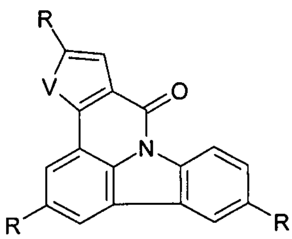

formule (17b)

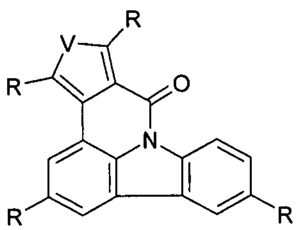

formule (18b)

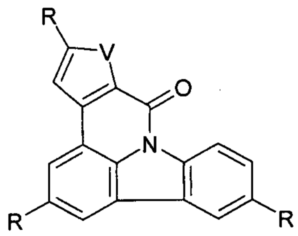

formule (19b)

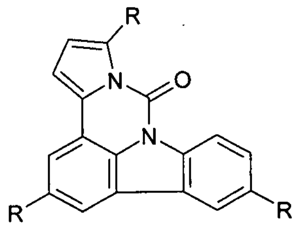

formule (20b)

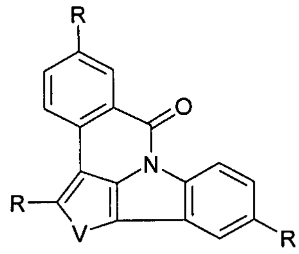

formule (21b)

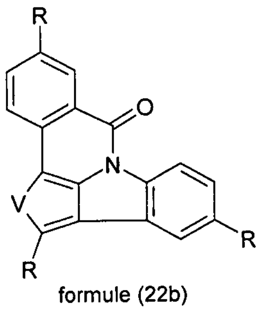

formule (22b)

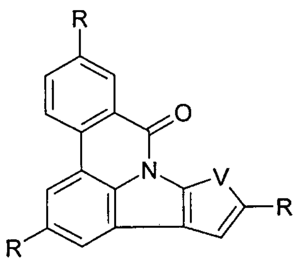

formule (23b)

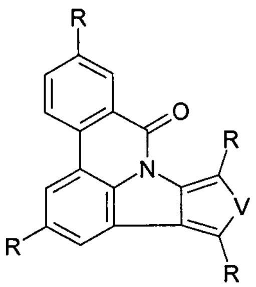

formule (24b)

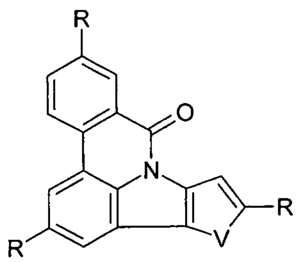

formule (25b)

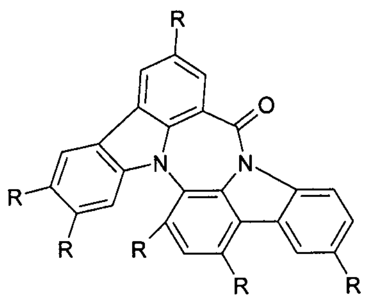

formule (26b)

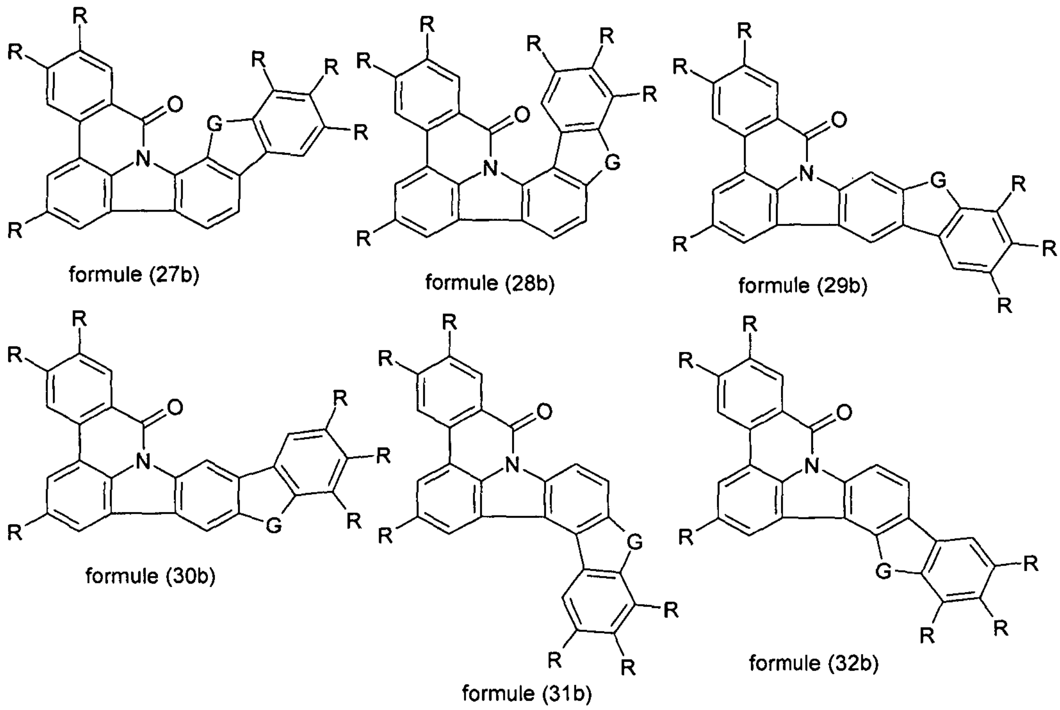

formule (27b) formule (28b) formule (29b)

formule (30b) formule (31b) formule (32b)

dans lesquelles les symboles utilisés présentent les significations données selon les revendications 1 et 4.

**8.** Dispositif électroluminescent organique selon une ou plusieurs des revendications 1 à 7, **caractérisé en ce que** le composé de transport d'électrons présentant une LUMO ≤ -2,4 eV présente une LUMO ≤ -2,5 eV, de façon préférable ≤ -2,55 eV.

**9.** Dispositif électroluminescent organique selon une ou plusieurs des revendications 1 à 8, **caractérisé en ce que** le composé de transport d'électrons présentant une LUMO ≤ -2,4 eV V contient au moins un groupe lactame, au moins un groupe triazine de la formule (T-1) ou au moins un groupe pyrimidine de la formule (P-1), de la formule (P-2) ou de la formule (P-3) :

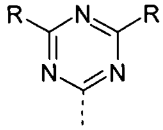
formule (T-1)

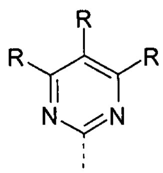
formule (P-1)

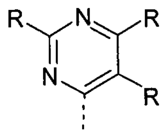
formule (P-2)

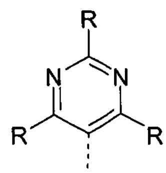
formule (P-3)

dans lesquelles R présente les significations données selon la revendication 1 et la liaison en pointillés représente le lien de ce groupe.

**10.** Dispositif électroluminescent organique selon la revendication 9, **caractérisé en ce que** le composé de transport d'électrons présentant une LUMO ≤ -2,4 eV contient un groupe triazine de la formule (T-1) ou un groupe pyrimidine de la formule (P-1), de la formule (P-2) ou de la formule (P-3), lequel groupe est lié directement ou via un groupe de pontage à un groupe indénocarbazole, un groupe indolocarbazole ou un groupe carbazole, où à la fois le groupe triazine ou le groupe pyrimidine et également le groupe indénocarbazole ou le groupe indolocarbazole ou le groupe carbazole peuvent être substitués par un radical ou plusieurs radicaux R, et R est comme défini selon la revendication 1.

**11.** Dispositif électroluminescent organique selon la revendication 10, **caractérisé en ce que** le groupe indénocarbazole, le groupe indolocarbazole ou le groupe carbazole est choisi parmi les structures des formules (indeno-1), (indeno-2), (indolo-1), (carb-1) et (spiro-1) qui suivent :

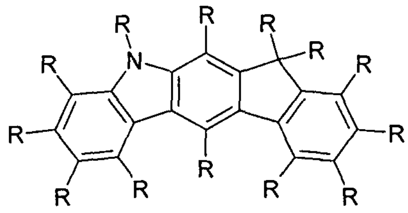

formule (indeno-1)

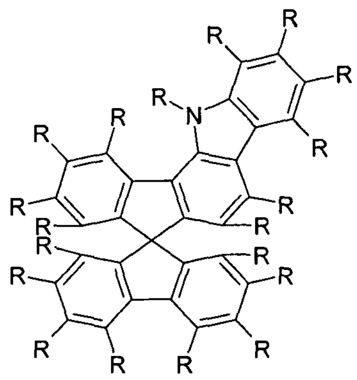

formule (indeno-2)

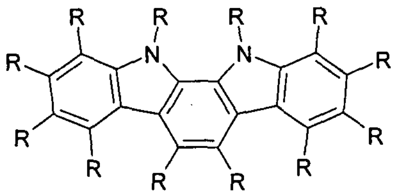

formule (indolo-1)

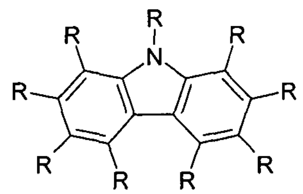

formule (carb-1)

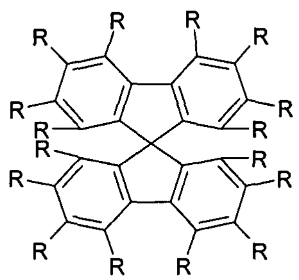

formule (spiro-1)

dans lesquelles R présente les significations données selon la revendication 1, et, en lieu et place de l'un des radicaux R, ces groupes comportent une liaison sur le groupe pyrimidine ou sur le groupe triazine ou sur le groupe de pontage, lequel groupe de pontage est à son tour lié au groupe pyrimidine ou au groupe triazine.

**12.** Dispositif électroluminescent organique selon une ou plusieurs des revendications 1 à 11, **caractérisé en ce que** le composé de transport d'électrons présentant une LUMO ≤ -2,4 eV et le composé de la formule (1) ou de la formule (1a) sont utilisés dans une couche d'émission en association avec un composé phosphorescent, et **en ce que** le composé phosphorescent est un composé qui contient de l'iridium, du platine ou du cuivre.

**13.** Procédé pour la production d'un dispositif électroluminescent organique selon une ou plusieurs des revendications 1 à 12, **caractérisé en ce qu'**au moins une couche est appliquée au moyen d'un processus de sublimation et/ou **en ce qu'**au moins une couche est appliquée au moyen d'un procédé OVPD (dépôt organique en phase vapeur) ou à l'aide d'une sublimation par gaz porteur et/ou **en ce qu'**au moins une couche est appliquée à partir d'une solution, au moyen d'un dépôt à la tournette/par centrifugation ou au moyen d'un processus d'impression.

**14.** Mélange comprenant :

a) au moins un composé de transport d'électrons qui présente une LUMO ≤ -2,4 eV, déterminée au moyen de calculs de la chimie quantique ; et
b) au moins un composé de la formule (1) ou de la formule (1a) selon la revendication 1.

**15.** Formulation comprenant un mélange selon la revendication 14 et au moins un solvant.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 4539507 A
- US 5151629 A
- EP 0676461 A
- WO 9827136 A
- WO 2002047457 A
- WO 2010108579 A
- WO 2011116865 A
- WO 2011137951 A
- WO 0070655 A
- WO 200141512 A
- WO 200202714 A
- WO 200215645 A
- EP 1191613 A
- EP 1191612 A
- EP 1191614 A
- WO 2005033244 A
- WO 2005019373 A
- US 20050258742 A
- WO 2010086089 A
- WO 2011157339 A
- WO 2012007086 A
- WO 2012163471 A
- WO 2013000531 A
- WO 2013020631 A
- WO 2005011013 A
- WO 2005053051 A


### In der Beschreibung aufgeführte Nicht-Patentliteratur


- **M. A. BALDO et al.** *Appl. Phys. Lett.,* 1999, vol. 75, 4-6
- **M. S. ARNOLD et al.** *Appl. Phys. Lett.,* 2008, vol. 92, 053301